# EUROPEAN PATENT SPECIFICATION

(11) **EP 1 975 708 B1**
(45) Date of publication and mention of the grant of the patent: **22.04.2015**
(21) Application number: 08006349.8
(22) Date of filing: 31.03.2008
(51) Int. Cl.: G03F 7/027

(54) **Lithographic printing plate precursor**
Lithografiedruckplattenvorläufer
Précurseur de plaque d'impression lithographique

(30) Priority: 30.03.2007 JP 2007095221
(43) Date of publication of application: 01.10.2008
(73) Proprietor: FUJIFILM Corporation, Minato-ku Tokyo (JP)
(72) Inventor: Kamosaki, Tetsu, Haibara-gun Shizuoka (JP); Mori, Takanori, Haibara-gun Shizuoka (JP)
(74) Representative: Hoffmann Eitle

(56) References cited:
- EP-A- 1 235 107
- EP-A- 1 710 627
- WO-A-03/038527
- JP-A- 2004 219 667
- JP-A- 2006 078 749

## Description

### FIELD OF THE INVENTION

The present invention relates to a negative-working lithographic printing plate precursor utilizing photopolymerization capable of undergoing direct drawing with laser light.

### BACKGROUND OF THE INVENTION

A lithographic printing plate precursor (photosensitive lithographic printing plate) ordinarily has a photosensitive layer (image-recording layer) formed by coating a photosensitive composition on a support, for example, an aluminum plate subjected to surface roughening treatment. Of the lithographic printing plate precursors, in a negative-working lithographic printing plate precursor, image formation is carried out according to a process of exposing a desired image, polymerizing or crosslinking the exposed area of the image-recording layer to insolubilize it in a developer and dissolving out the unexposed area of the image-recording layer with the developer. As the photosensitive composition used for such a purpose, a photopolymerizable composition has hitherto been well known and some photopolymerizable compositions are already put into practical use. Also, as for a high-sensitive photopolymer which adopts a recent photo-initiation system technology that is highly sensitive to visible light, the sensitivity increases to a region employable for direct plate-making by visible laser, and a so-called CTP plate using such a high-sensitive photopolymer becomes widespread.

In order to respond to the improvement in drawing speed for pursuing high productivity, not only further increase in the sensitivity is necessary but also provision of a printing plate having high printing durability abrasion of which is prevented even when printing of a large number of sheets is performed is required.

For the purpose of increasing the printing durability, it is known to use a polymer binder containing a crosslinkable group. However, it is difficult for hitherto known techniques to achieve a good balance between the printing durability with the sensitivity sufficient for conducting high-speed drawing.

EP 1 235 107 discloses a photopolymerizable composition that is cured with visible light or an infrared laser and is used as a recording layer in a negative planographic printing plate precursor. The photopolymerizable composition is cured by exposure and includes (A) a polymerizable compound that is solid at 25°C and has at least one radical-polymerizable ethylenically unsaturated double bond in a molecule, (B) a radical polymerization initiator, (C) a binder polymer and, as required, (D) a compound generating heat by infrared exposure.

JP-A-2004-219667 relates to a photosensitive lithographic printing plate formed by laminating a photopolymerizable photosensitive layer and an oxygen cut-off layer on an aluminum supporting body, and which contains a high molecular compound (A) which has a carbon-carbon double bond at least in the side chain, an acid value of 0.7-2.0, a glass transition temperature of < 120°C and solubility in an alkaline aqueous solution; a photopolymerization initiator (B) and an ethylenically unsaturated polymerizable compound (C).

JP-A-2006-078749 describes a polymerizable photosensitive composition suitable for a planographic printing plate material capable of being directly plate-made by means of digital data, which photosensitive composition contains a specified cyclohexyl group-containing compound of the formula (*Z*)*₁-*(*HEX*)*-*[(CH₂)*ₙ*-X-O-C(=O)-C(=CH₂)R]*ₘ*, wherein *m* is an integer of *2-6, 1* is an integer of 0-6, X is a divalent connecting group, *n* each independently is an integer of > 0, R is H or methyl, *Z* each independently is a monovalent substituent, and HEX is a cyclohexylene ring, and when *m* or *1* is an integer of > 2, the respective X, N, R and Z may be identical or different; and a binder polymer having an amide bond or a urethane bond.

### SUMMARY OF THE INVENTION

An object of the present invention is to provide a lithographic printing plate precursor having high sensitivity and providing a lithographic printing plate exhibiting high printing durability capable of performing printing of a large number of sheets.

This object is achieved by providing a lithographic printing plate precursor comprising:
(i) a support; and
(ii) an image-recording layer comprising a photopolymerizable composition, which comprises
   (a) an addition-polymerizable compound, which has at least one ethylenically unsaturated double bond in the molecule, and has a melting point of ≥ 60°C,
   (b) an alkaline water-soluble or alkaline water-swellable binder, which is a polyurethane resin comprising a crosslinkable group and having a glass transition point of ≥ 45°C,
   (c) a sensitizing dye, and
   (d) a photo-initiator.

Preferred embodiments are as defined in the following detailed description and/or in the appended dependent claims.

According to the present invention, a lithographic printing plate precursor having high sensitivity and providing a lithographic printing plate exhibiting high printing durability capable of performing printing of a large number of sheets can be provided.

### DETAILED DESCRIPTION OF THE INVENTION

The lithographic printing plate precursor according to the invention comprises a support and an image-recording layer containing a photopolymerizable composition containing (1) an addition-polymerizable compound having at least one ethylenically unsaturated double bond in its molecule, (2) an alkaline water-soluble or alkaline water-swellable binder, (3) a sensitizing dye and (4) a photo-initiator, wherein (A) a melting point of the addition-polymerizable compound having at least one ethylenically unsaturated double bond in its molecule is 60 °C or more and a glass transition point of the alkaline water-soluble or alkaline water-swellable binder is 45°C or more.

The constituting elements and components of the lithographic printing plate precursor according to the invention will be described in more detail below.

### [Image-recording layer]

### <Addition-polymerizable compound having at least one ethylenically unsaturated double bond in its molecule and a melting point of 60°C or more>

The image-recording layer according to the invention contains an addition-polymerizable compound having at least one ethylenically unsaturated double bond in its molecule (hereinafter, also appropriately referred to as a "monomer", sometimes) and the monomer has a melting point of 60°C or more.

The monomer having a melting point of 60°C or more is not particularly restricted and a compound represented by formula (I) shown below is particularly preferably used.

**L₁-OOCNH-R₁-X-R₂-NHCOO-L₂** (I)

In formula (I), X represents a substituted or unsubstituted 5-membered or 6-membered ring structure, and the ring may be a hydrocarbon ring or a hetero ring. Among them, an unsubstituted 6-membered ring structure is particularly preferable. As the 5-membered or 6-membered ring, a hydrocarbon ring is preferable and a saturated hydrocarbon ring is more preferable.

R₁ and R₂, each represents a straight-chain alkylene group having from 1 to 5 carbon atoms or a branched alkylene group having from 1 to 5 carbon atoms. A straight-chain or branched alkylene group having from 1 to 3 carbon atoms is more preferable and a straight-chain alkylene group having from 1 to 3 carbon atoms is particularly preferable. R₁ and R₂ may have the same structure or different structures.

L₁ and L₂ each represents an organic group, provided that at least one of L₁ and L₂ includes an ethylenically unsaturated double bond. It is more preferable to include an ethylenically unsaturated double bond in both of L₁ and L₂. The organic group including an ethylenically unsaturated double bond is not particularly restricted and an organic group represented by formula (II) or (III) shown below is preferably used.

**-A-NHCOO-B-Y** (II)

**-D-Y** (III)

In formula (II), A and B each independently represents a single bond or a straight-chain or branched alkylene group having from 1 to 5 carbon atoms. The total number of carbon atoms included in A and B is preferably from 1 to 10, more preferably from 1 to 7, particularly preferably from 2 to 4. In formula (III), D represents a straight-chain or branched alkylene group having from 1 to 5 carbon atoms and is particularly preferably a straight-chain alkylene group having from 2 to 4 carbon atoms.

Y in formula (II) or (III) represents an acryloyloxy group, a methacryloyloxy group, a styryloxy group or an allyloxy group. Among them, an acryloyloxy group or a methacryloyloxy group is particularly preferable.

The melting point of the monomer is more preferably 75°C or more.

Specific examples of the monomer according to the invention are set forth below, but the invention should not be construed as being limited thereto.

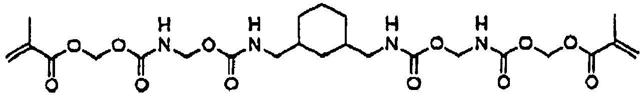

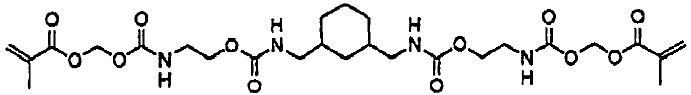

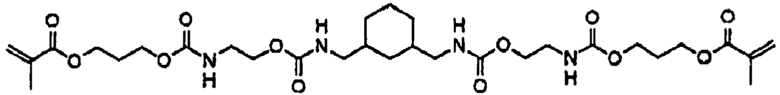

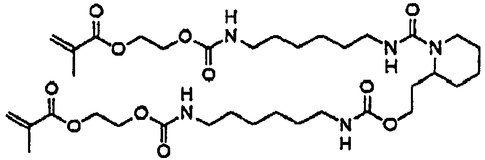

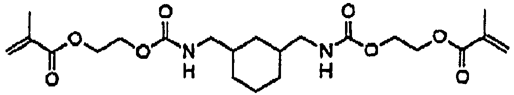

In the photopolymerizable composition according to the invention, known other monomer may be used in combination with the monomer having a melting point of 60°C or more according to the invention in the range in which the effects of the invention are exerted.

The weight ratio of the monomer according to the invention to other monomer is preferably from 100 : 0 to 1 : 1, particularly preferably from 100 : 0 to 10 : 1.

### <Alkaline water-soluble or alkaline water-swellable binder>

In the lithographic printing plate precursor undergoing alkali development according to the invention, an alkaline water-soluble or alkaline water-swellable organic polymer is used as a binder in order to improve the film property of the image-recording layer and the developing property. Examples of such an organic polymer include addition polymers having a carboxylic acid group in its side chain, for example, polymers described in JP-A-59-44615 (the term "JP-A" as used herein means an "unexamined published Japanese patent application"), JP-B-54-34327 (the term "JP-B" as used herein means an "examined Japanese patent publication"), JP-B-58-12577, JP-B-54-25957, JP-A-54-92723, JP-A-59-53836 and JP-A-59-71048, more specifically, methacrylic acid copolymers, acrylic acid copolymers, itaconic acid copolymers, crotonic acid copolymers, maleic acid copolymers and partially esterified maleic acid copolymers.

Also, acidic cellulose derivatives having a carboxylic acid group in its side chain and polymers obtained by adding a cyclic acid anhydride to an addition polymer having a hydroxy group are known.

Further, polyurethane resins described in JP-B-7-120040, JP-B-7-120041, JP-B-7-120042, JP-B-8-12424, JP-A-63-287944, JP-A-63-287947, JP-A-1-271741 and JP-A-11-352691 are also useful as the alkaline water-soluble or alkaline water-swellable binder.

The alkaline water-soluble or alkaline water-swellable binder for use in the invention has a glass transition point (T_{g}) of 45°C or more. The Tg of the alkaline water-soluble or alkaline water-swellable binder is more preferably 50°C or more, still more preferably 80°C or more, most preferably 100°C or more. When the alkaline water-soluble or alkaline water-swellable binder having a glass transition point of 100°C or more is used, good sensitivity and printing durability are achieved irrespective of the melting point of the monomer used together.

As the alkaline water-soluble or alkaline water-swellable binder having a glass transition point of 45°C or more according to the invention, a polyurethane resin is used.

The molecular weight of the specific binder polymer according to the invention is appropriately determined in view of the image-forming property and printing durability. It is preferably in a range from 2,000 to 1,000,000, more preferably from 5, 000 to 500, 000, still more preferably from 10,000 to 200,000. The acid value (meq/g) of the binder polymer is preferably in a range from 2.00 to 3.60.

As the urethane resin used in the invention, a urethane resin containing a crosslinkable group is preferable. In particular, a combination of the monomer having a melting point of 60°C or more represented by formula (I) described above with a urethane resin having a Tg of 45°C or more and containing a crosslinkable group is used.

The term "crosslinkable group" as used herein means a group capable of crosslinking the polymer binder in the process of a radical polymerization reaction which is caused in the image-recording layer, when the lithographic printing plate precursor is exposed to light. The crosslinkable group is not particularly restricted as long as it has such a function and includes, for example, an ethylenically unsaturated bonding group, an amino group or an epoxy group as a functional group capable of undergoing an addition polymerization reaction. Also, a functional group capable of forming a radical upon irradiation with light may be used and such a crosslinkable group includes, for example, a thiol group, a halogen atom and an onium salt structure. Among them, the ethylenically unsaturated bonding group is preferable, and functional groups represented by formulae (1) to (3) shown below are particularly preferable.

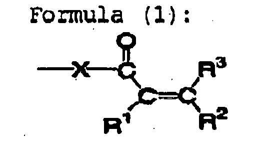

In formula (1), R¹ to R³ each independently represents a hydrogen atom or a monovalent organic group. R¹ preferably includes, for example, a hydrogen atom or an alkyl group which may have a substituent. Among them, a hydrogen atom or a methyl group is preferable because of high radical reactivity. R² and R³ each independently preferably includes, for example, a hydrogen atom, a halogen atom, an amino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable because of high radical reactivity.

X represents an oxygen atom, a sulfur atom or -N(R¹²)-, and R¹² represents a hydrogen atom or a monovalent organic group. The monovalent organic group represented by R¹² includes, for example, an alkyl group which may have a substituent. Among them, R¹² is preferably a hydrogen atom, a methyl group, an ethyl group or an isopropyl group because of high radical reactivity.

Examples of the substituent which can be introduced include an alkyl group, an alkenyl group, an alkynyl group, an aryl group, an alkoxy group, an aryloxy group, a halogen atom, an amino group, an alkylamino group, an arylamino group, a carboxyl group, an alkoxycarbonyl group, a sulfo group, a nitro group, a cyano group, an amido group, an alkylsulfonyl group and an arylsulfonyl group.

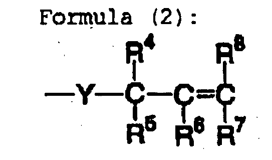

In formula (2), R⁴ to R⁸ each independently represents a hydrogen atom or a monovalent organic group. R⁴ to R⁸ each independently preferably includes, for example, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable.

Examples of the substituent which can be introduced include those described in Formula (1). Y represents an oxygen atom, a sulfur atom or -N(R¹²)-, and R¹² has the same meaning as R¹² defined in Formula (1). Preferable examples for R¹² are also same as those described in Formula (1).

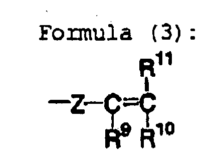

In formula (3), R⁹ represents a hydrogen atom or a monovalent organic group and is preferably a hydrogen atom or an alkyl group which may have a substituent. Among them, a hydrogen atom or a methyl group is preferable because of high radical reactivity. R¹⁰ and R¹¹ each independently represents, for example, a hydrogen atom, a halogen atom, an amino group, a dialkylamino group, a carboxyl group, an alkoxycarbonyl group, a sulfo group, a nitro group, a cyano group, an alkyl group which may have a substituent, an aryl group which may have a substituent, an alkoxy group which may have a substituent, an aryloxy group which may have a substituent, an alkylamino group which may have a substituent, an arylamino group which may have a substituent, an alkylsulfonyl group which may have a substituent and an arylsulfonyl group which may have a substituent. Among them, a hydrogen atom, a carboxyl group, an alkoxycarbonyl group, an alkyl group which may have a substituent or an aryl group which may have a substituent is preferable because of high radical reactivity.

Examples of the substituent introduced include those described in Formula (i). Z represents an oxygen atom, a sulfur atom, -N(R¹³)- or a phenylene group which may have a substituent. R¹³ includes an alkyl group which may have a substituent or the like. Among them, a methyl group, an ethyl group or an isopropyl group is preferable because of high radical reactivity.

The polyurethane resin having a crosslinkable group in its side chain according to the invention not only functions as a film-forming agent of the image-recording layer but also it is required to be soluble or swellable in alkaline water since it is needed to be dissolved in an alkali developer. Therefore, the polyurethane resin has an alkaline water-soluble group, for example, a carboxyl group, in the side chain in addition to the crosslinkable group. The polyurethane resin is preferable in view of satisfying both good stain resistance and high printing durability because the development damage in the exposed area can be prevented without accompanying with deterioration of the developing property in the unexposed area, even when the acid value of the image-recording layer is low.

The polyurethane resin having a crosslinkable group in the side chain thereof is described in more detail below.

The polyurethane resin having a crosslinkable group in the side chain thereof particularly preferably used in the invention can be obtained by a polyaddition reaction of (i) a diisocyanate compound, (ii) a diol compound having a carboxyl group, (iii) a diisocyanate compound having a crosslinkable group and if desired, (iv) a diol compound containing no carboxyl group.

The diisocyanate compound and diol compound which are starting materials of the polyurethane resin will be described in more detail below. (i) Diisocyanate compound

Examples of the diisocyanate compound include diisocyanate compounds represented by the following formula (4):

OCN-L-NCO (4)

In formula (4), L represents a single bond or a divalent aliphatic or aromatic hydrocarbon group which may have a substituent. If desired, L may contain other functional group which does not react with the isocyanate group, for example, a carbonyl group, an ester group, a urethane group, an amido group or a ureido group. More specifically, L represents a single bond or a divalent aliphatic or aromatic hydrocarbon group which may have a substituent (preferably, for example, an alkyl group, an aralkyl group, an aryl group, an alkoxy group or a halogen atom), preferably an alkylene group having from 1 to 20 carbon atoms or an arylene group having from 6 to 15 carbon atoms, more preferably an alkylene group having from 1 to 8 carbon atoms. Also, if desired, L may contain other functional group which does not react with the isocyanate group, for example, a carbonyl group, an ester group, a urethane group, an amido group, a ureido group or an ether group.

Specific examples of the diisocyanate compound represented by formula (4) include the following compounds. Specifically, an aromatic diisocyanate compound, for example, 2,4-tolylene diisocyanate, dimer of 2,4-tolylene diisocyanate, 2,6-tolylene diisocyanate, p-xylylene diisocyanate, m-xylylene diisocyanate, 4,4' -diphenylmethane diisocyanate, 1, 5-naphthalene diisocyanate or 3,3'-dimethylbiphenyl-4,4'-diisocyanate; an aliphatic diisocyanate compound, for example, hexamethylene diisocyanate, trimethylhexamethylene diisocyanate, lysine diisocyanate or dimeric acid diisocyanate; an alicyclic diisocyanate compound, for example, isophorone diisocyanate, 4,4'-methylenebis(cyclohexyl isocyanate), methylcyclohexane-2,4 (or 2,6)-diisocyanate or 1,3-(isocyanatomethyl)cyclohexane; and a diisocyanate compound obtained by a reaction of diol with diisocyanate, for example, an adduct of 1 mole of 1, 3-butylene glycol with 2 moles of tolylene diisocyanate are exemplified.

The diisocyanate compounds may be used individually or in combination of two or more thereof. In view of the balance between printing durability and stain resistance, it is preferred to use two or more of the diisocyanate compounds in combination, and it is particularly preferred to use at least one of the aromatic diisocyanate compounds (L represents an aromatic group) and at least one of the aliphatic diisocyanate compounds (L represents an aliphatic group).

With respect to the amount of the diisocyanate compound used, a molar ration of the diisocyanate compound to the diol compound is preferably from 0.8 to 1.2, more preferably from 0.9 to 1.1. In the case where an isocyanate group remains at a polymer terminal because of using an excess amount of the diisocyanate compound to the diol compound, it is preferred to treat the compound after the urethanization reaction with an alcohol or an amine to finally synthesize a compound having no residual isocyanate group at the terminal.

### (ii) Diol compound having at least one carboxyl group

The diol compound having at least one carboxyl group includes diol compounds represented by formulae (5), (6) and (7) shown below and/or a compound obtained by ring opening of a tetracarboxylic acid dianhydride with a diol compound. The diol compound used for the purpose of ring opening of the tetracarboxylic acid dianhydride can be used.

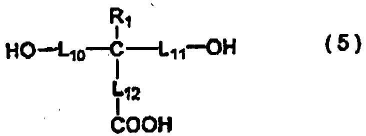

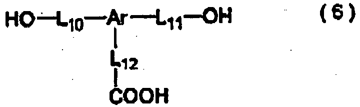

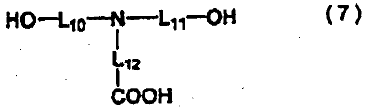

In formulae (5) to (7), R₁ represents a hydrogen atom, an alkyl group, an aralkyl group, an aryl group, an alkoxy group or an aryloxy group, each of which may have a substituent (for example, a cyano group, a nitro group, a halogen atom (e.g., -F, -Cl, -Br or -I), -CONH₂, -COOR₁₁₃, -OR₁₁₃, -NHCONHR₁₁₃, -NHCOOR₁₁₃, -NHCOR₁₁₃ or -OCONHR₁₁₃ (wherein R₁₁₃ represents an alkyl group having from 1 to 10 carbon atoms or an aralkyl group having from 7 to 15 carbon atoms)), preferably a hydrogen atom, an alkyl group having from 1 to 8 carbon atoms or an aryl group having from 6 to 15 carbon atoms. L₁₀, L₁₁ and L₁₂, which may be the same or different, each represents a single bond or a divalent aliphatic or aromatic hydrocarbon group which may have a substituent (preferably, for example, an alkyl group, an aralkyl group, an aryl group, an alkoxy group or a halogen atom), preferably an alkylene group having from 1 to 20 carbon atoms or an arylene group having from 6 to 15 carbon atoms, more preferably an alkylene group having from 1 to 8 carbon atoms. Also, if desired, L₁₀, L₁₁ and L₁₂ each may contain other functional group which does not react with the isocyanate group, for example, a carbonyl group, an ester group, a urethane group, an amido group, a ureido group or an ether group. Further, two or three of R₁, L₁₀, L₁₁ and L₁₂ may be taken together to form a ring. Ar represents a trivalent aromatic hydrocarbon group which may have substituent, preferably an aromatic group having from 6 to 15 carbon atoms.

Specific examples of the diol compound having a carboxyl group represented by formula (5), (6) or (7) include the following compounds.

Specifically, 3,5-dihydroxybenzoic acid, 2,2-bis(hydroxymethyl)propionic acid, 2,2-bis(2-hydroxyethyl)propionic acid, 2,2-bis(3-hydroxypropyl)propionic acid, bis(hydroxymethyl) acetic acid, bis(4-hydroxyphenyl)acetic acid, 2,2-bis(hydroxymethyl)butyric acid, 4,4-bis(4-hydroxyphenyl)pentanoic acid, tartaric acid, N,N-dihydroxyethylglycine and N,N-bis(2-hydroxyethyl)-3-carboxypropionamide are exemplified.

Preferable examples of the tetracarboxylic acid dihydrate, which is used in the preparation of the diol compound having at least one carboxy group, include compounds represented by formulae (8), (9) and (10) shown below.

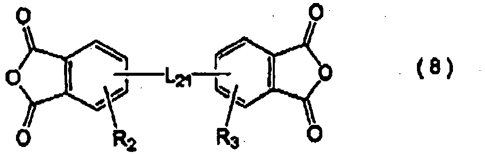

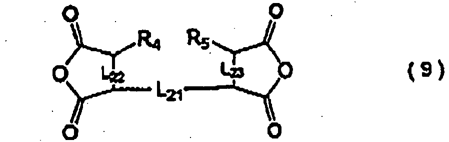

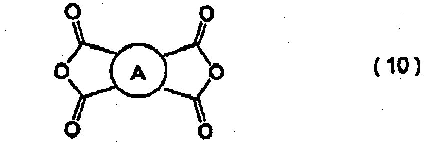

In formulae (8) to (10), L₂₁ represents a single bond, a divalent aliphatic or aromatic hydrocarbon group which may have a substituent (preferably, for example, an alkyl group, an aralkyl group, an aryl group, an alkoxy group, a halogen atom, an ester group or an amido group), -CO-, -SO-, -SO₂-, -O- or -s-, preferably a single bond, a divalent aliphatic hydrocarbon group having from 1 to 15 carbon atoms, -CO-, -SO₂-, -O- or -s-. R₂ and R₃, which may be the same or different, each represents a hydrogen atom, an alkyl group, an aralkyl group, an aryl group, an alkoxy group or a halogen atom, preferably a hydrogen atom, an alkyl group having from 1 to 8 carbon atoms, an aryl group having from 6 to 15 carbon atoms, an alkoxy group having from 1 to 8 carbon atoms or a halogen atom. Alternatively, two of L₂₁, R₂ and R₃ may be combined with each other to form a ring. R₄ and R₅, which may be the same or different, each represents a hydrogen atom, an alkyl group, an aralkyl group, an aryl group or a halogen atom, preferably a hydrogen atom, an alkyl group having from 1 to 8 carbon atoms or an aryl group having from 6 to 15 carbon atoms. Alternatively, two of L₂₁, R₄ and R₅ may be combined with each other to form a ring. L₂₂ and L₂₃, which may be the same or different, each represents a single bond, a double bond or a divalent aliphatic hydrocarbon group, preferably a single bond, a double bond or a methylene group. A represents a monocyclic or polycyclic aromatic ring, preferably an aromatic ring having from 6 to 18 carbon atoms.

Specific examples of the compound represented by formula (8), (9) or (10) include the following compounds.

Specifically, an aromatic tetracarboxylic acid dihydride, for example, pyromellitic acid dihydride, 3,3',4,4'-benzophenonetetracarboxylic acid dihydride, 3,3',4,4'-diphenyltetracarboxylic acid dihydride, 2,3,6,7-naphthalenetetracarboxylic acid dihydride, 1,4,5,8-naphthalenetetracarboxylic acid dihydride, 4,4'-sulfonyldiphthalic acid dihydride, 2,2-bis(3,4-dicarboxyphenyl)propane dihydride, bis(3,4-dicarboxyphenyl)ether dihydride, 4,4'-[3,3'-(alkylphosphoryldiphenylene)-bis(iminocarbonyl)]di phthalic acid dihydride, adduct of hydroquinonediacetate and trimellitic acid anhydride or adduct of diacetyldiamine and trimellitic acid anhydride; an alicyclic tetracarboxylic acid dihydride, for example, 5-(2,5-dioxotetrahydrofuryl)-3-methyl-3-cyclohexene-1,2-dicar boxylic acid dihydride (Epicron B-4400, produced by Dainippon Ink & Chemicals, Inc.), 1,2,3,4-cyclopentanetetracarboxylic acid dihydride, 1,2,4,5-cyclohexanetetracarboxylic acid dihydride or tetrahydrofurantetracarboxylic acid dihydride; and an aliphatic tetracarboxylic acid dihydride, for example, 1,2,3,4-butanetetracarboxylic acid dihydride or 1,2,4,5-pentanetetracarboxylic acid dihydride are exemplified.

By ring-opening of the tetracarboxylic acid dianhydride with a diol compound, (ii) the diol compound having at least one carboxyl group can be synthesized. It is also possible that a reaction between the diol compound and (i) the diisocyanate compound is initially conducted and the resulting reaction product is reacted with the tetracarboxylic acid dianhydride to synthesize the polyurethane resin according to the invention. This method is also included in the concept of the invention. Specifically, the method of introducing a structural unit resulting from the tetracarboxylic acid dianhydride and the diol compound into the polyurethane resin includes the following methods:
a) Method wherein an alcohol-terminated compound obtained by ring-opening of the tetracarboxylic acid dianhydride with a diol compound is reacted with the diisocyanate compound and
b) Method wherein an alcohol-terminated urethane compound obtained by reacting the diisocyanate compound under excess of the diol compound is reacted with the tetracarboxylic acid dianhydride.

Of the diol compounds having at least one carboxyl group, the compounds represented by formula (5) are more preferable because of high solvent solubility and ease of synthesis. The diol compound having at least one carboxyl group is introduced into the polyurethane resin binder in an amount so that the polyurethane resin binder contains ordinarily from 0.2 to 4.0 meq/g, preferably from 0.3 to 3.0 meq/g, more preferably from 0.4 to 2.0 meq/g, particularly preferably from 0.5 to 1.5 meq/g, most preferably from 0.6 to 1.2 meq/g, of the carboxyl group. Therefore, although the content of the structure derived from the diol compound having at least one carboxylic group in the polyurethane resin binder can be appropriately determined after considering a number of the carboxyl group in the diol compound, other diol compound used in combination, an acid value or a molecular weight of the resulting polyurethane resin binder, a composition or pH of developer it is, for example, ordinarily from 5 to 45% by mole, preferably from 10 to 40% by mole, more preferably from 15 to 35% by mole.

### (iii) Diisocyanate compound having crosslinkable group

The diisocyanate compound having a crosslinkable group includes, for example, a reaction product obtained by an addition reaction of a triisocyanate compound with one equivalent of a monofunctional alcohol or monofunctional amine compound having a crosslinkable group.

Examples of the triisocyanate compound are set forth below, but the invention should not be construed as being limited thereto.

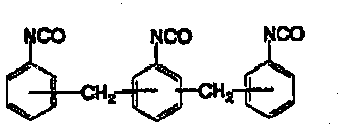

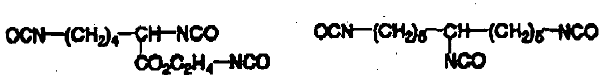

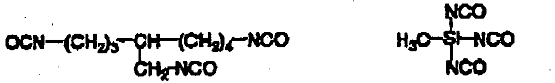

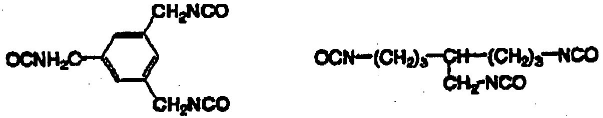

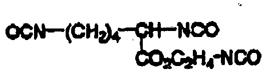

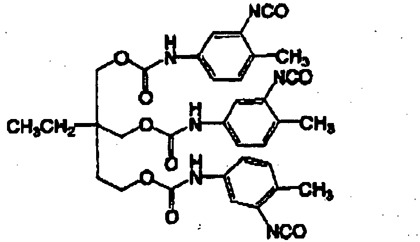

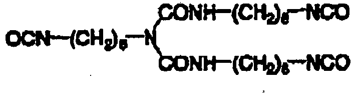

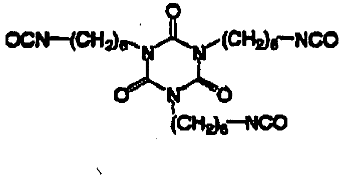

Examples of the monofunctional alcohol or monofunctional amine compound having a crosslinkable group are set forth below, but the invention should not be construed as being limited thereto.

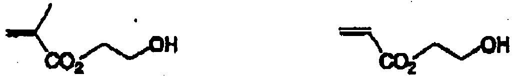

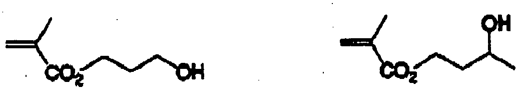

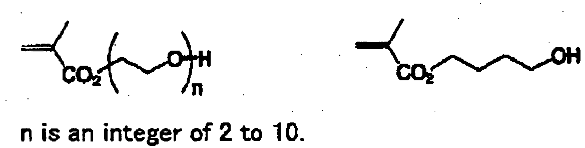

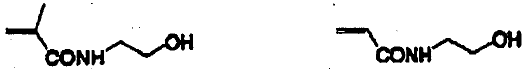

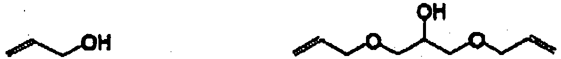

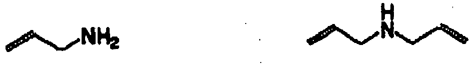

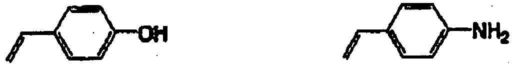

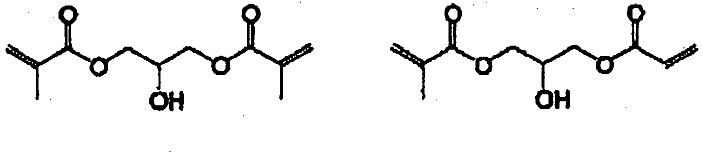

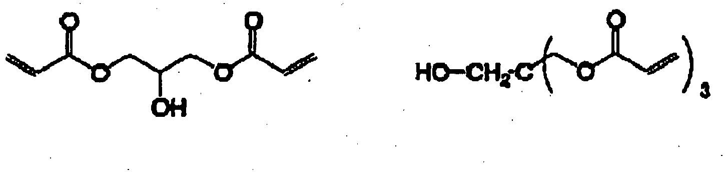

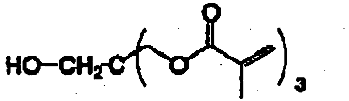

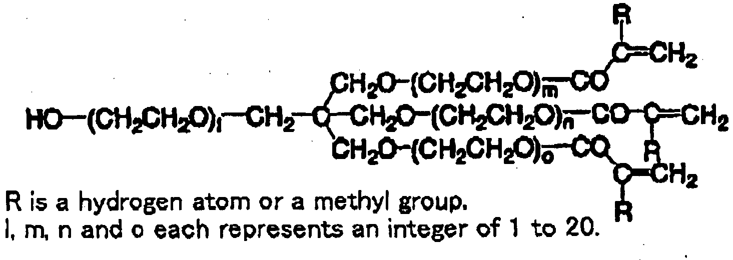

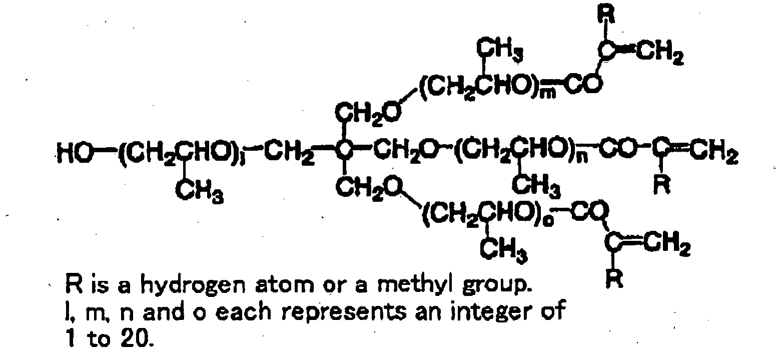

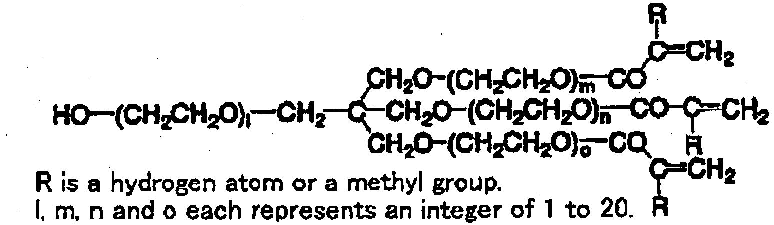

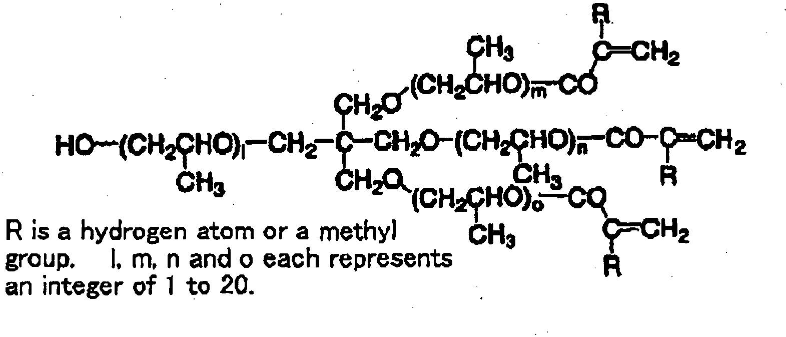

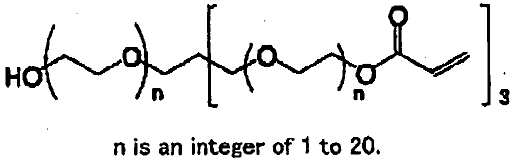

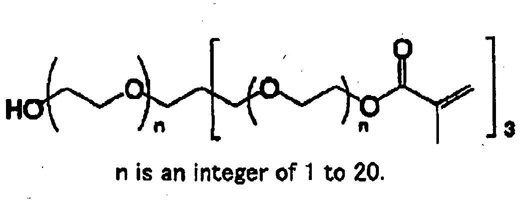

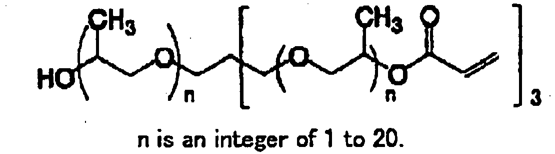

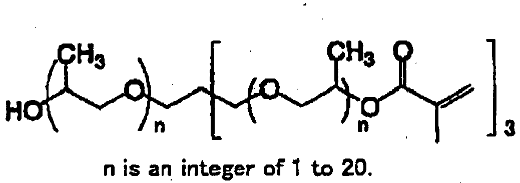

In order to introduce a crosslinkable group into the side chain of the polyurethane resin, a method of using as a raw material for the production of polyurethane resin, the diisocyanate compound having the crosslinkable group in its side chain is preferable. Specific examples of the diisocyanate compound having a crosslinkable group in its side chain obtained by an addition reaction of a triisocyanate compound with one equivalent of a monofunctional alcohol or monofunctional amine compound having the crosslinkable group are set forth below, but the invention should not be construed as being limited thereto.

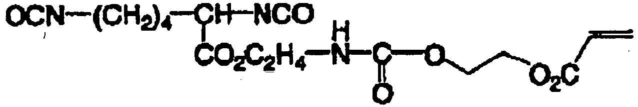

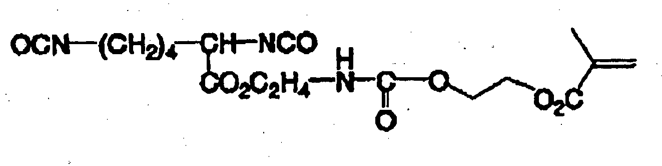

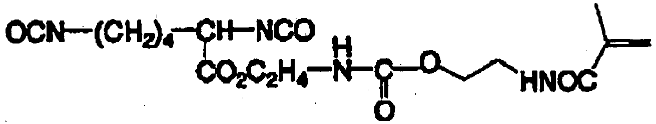

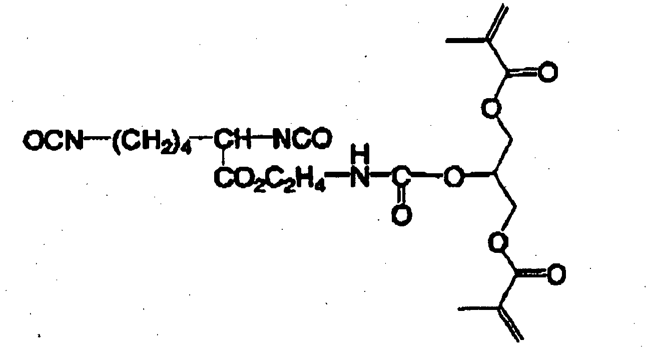

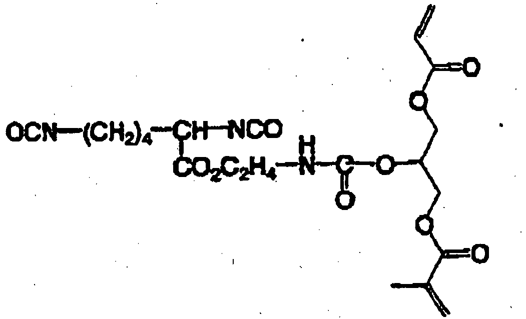

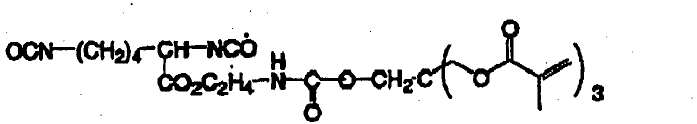

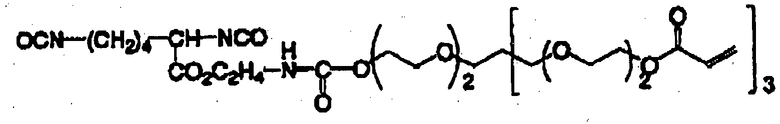

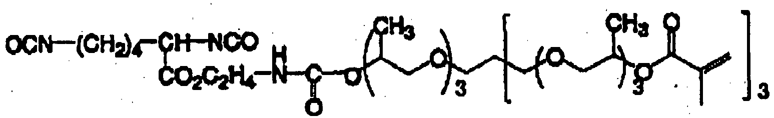

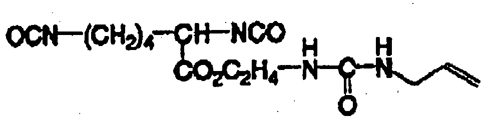

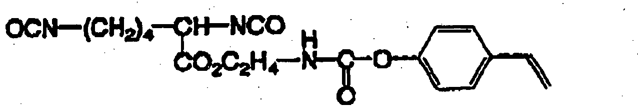

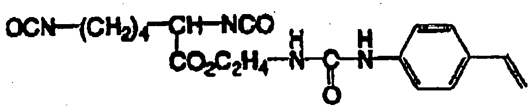

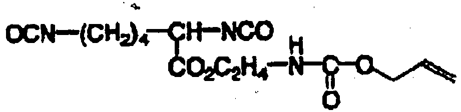

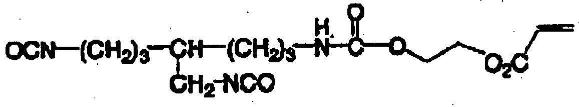

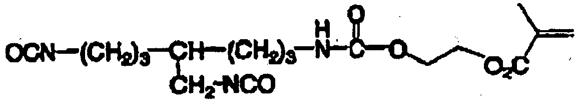

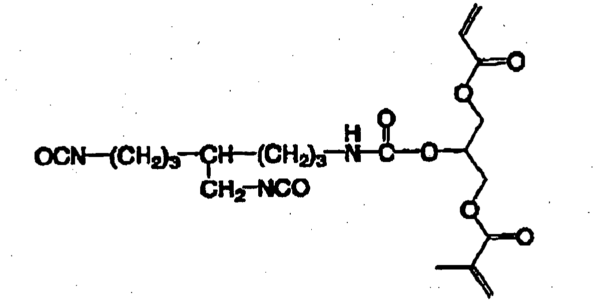

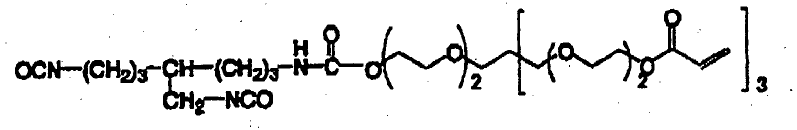

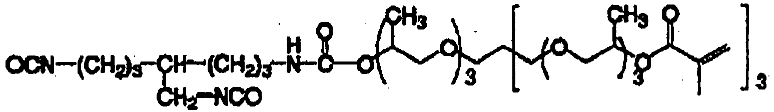

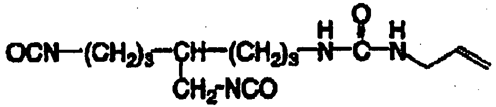

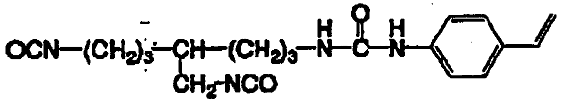

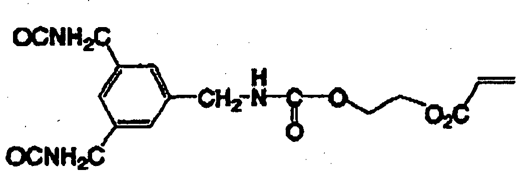

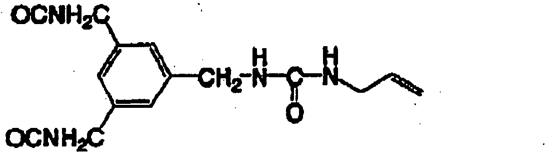

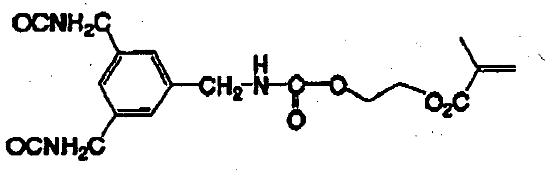

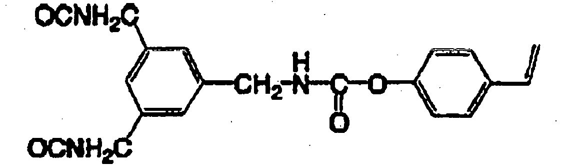

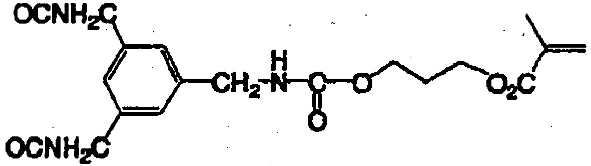

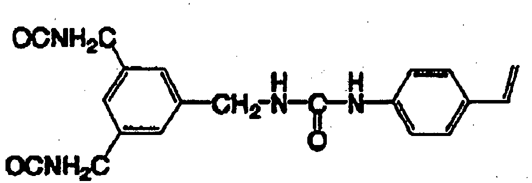

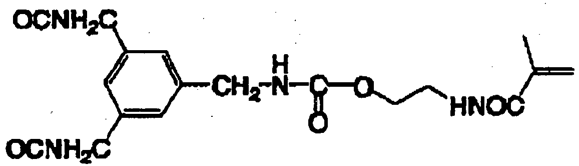

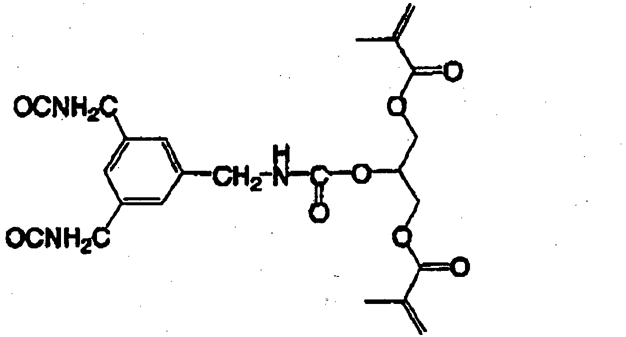

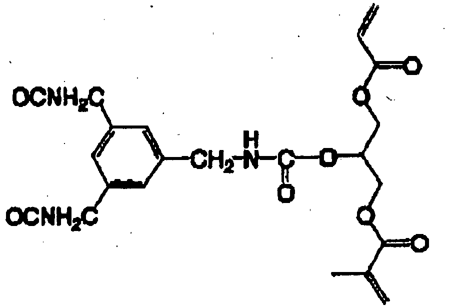

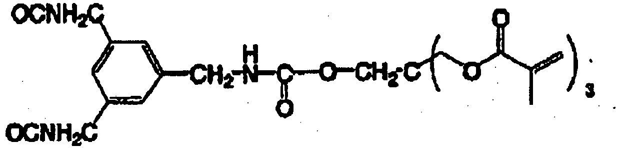

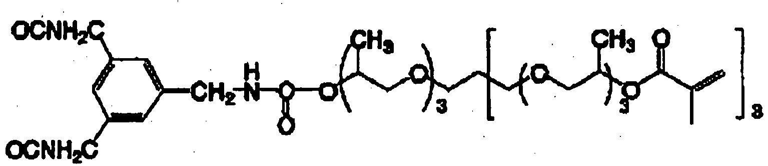

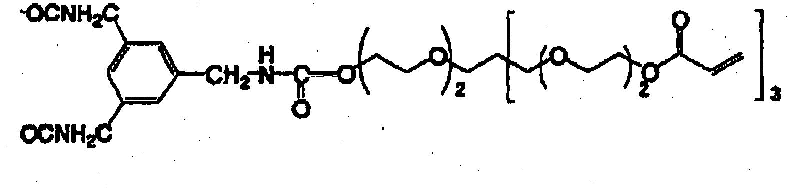

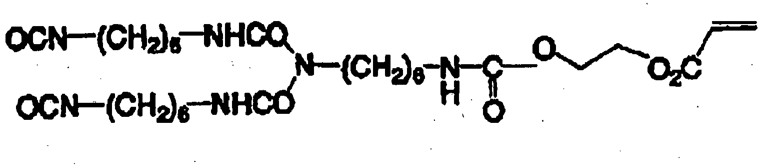

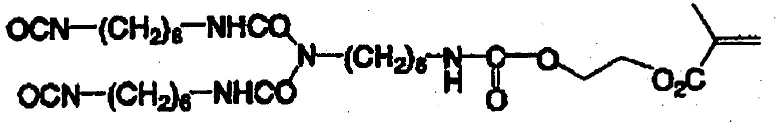

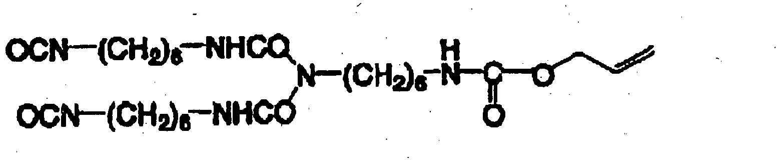

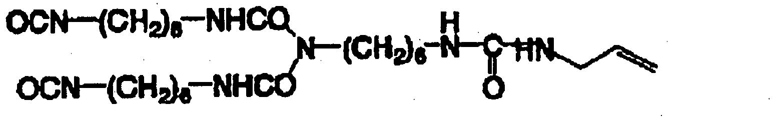

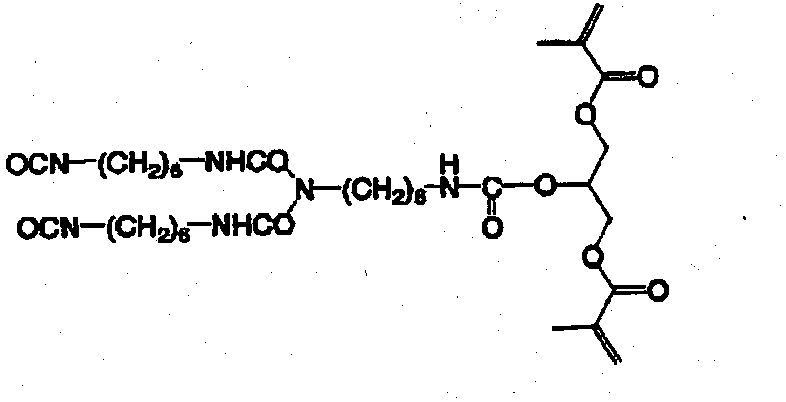

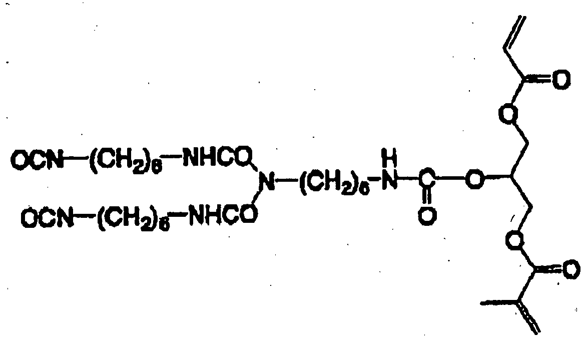

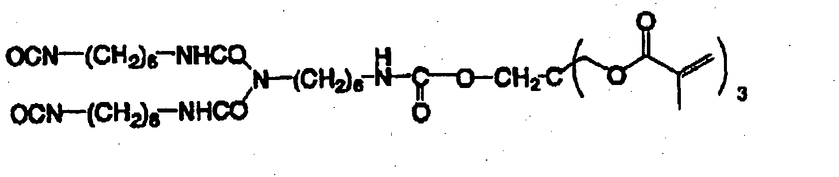

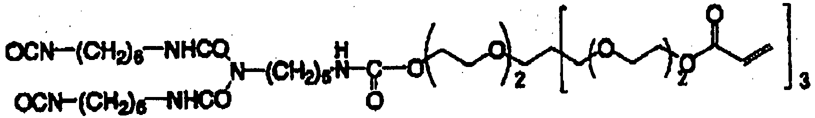

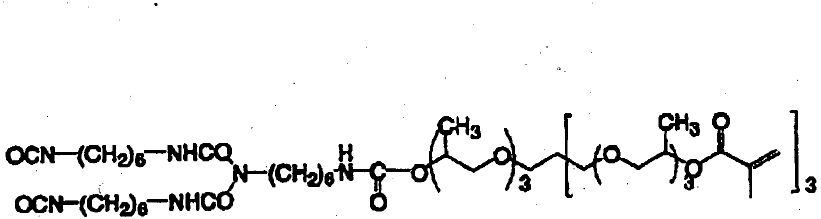

### (iv) Other diol compound

A method of using a diol compound having a crosslinkable group in its side chain as a raw material for the production of polyurethane resin is preferable as well as the method described above for the purpose of introducing the crosslinkable group into the side chain of the polyurethane resin. Such a diol compound may be a commercially available compound, for example, trimethylolpropane monoallyl ether or a compound easily produced by a reaction of a halogenated diol compound, a triol compound or an aminodiol compound with a carboxylic acid, acid chloride, isocyanate, alcohol, amine, thiol or halogenated alkyl compound having a crosslinkable group. Specific examples of the diol compound having a crosslinkable group are set forth below, but the invention should not be construed as being limited thereto.

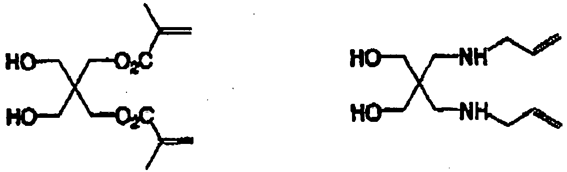

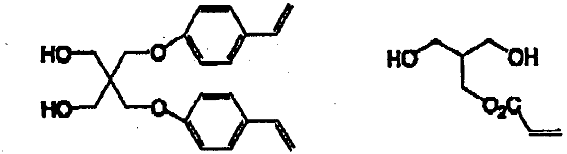

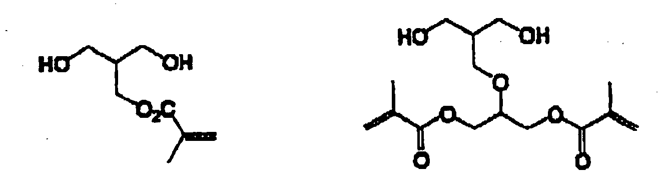

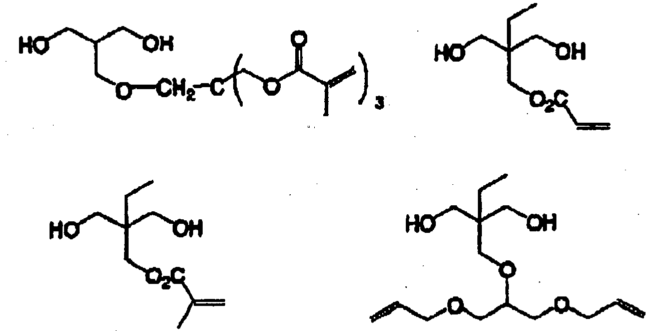

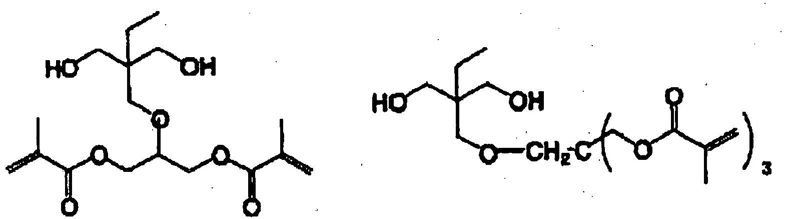

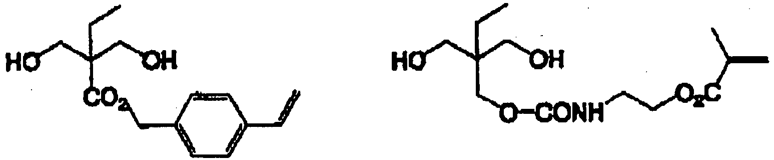

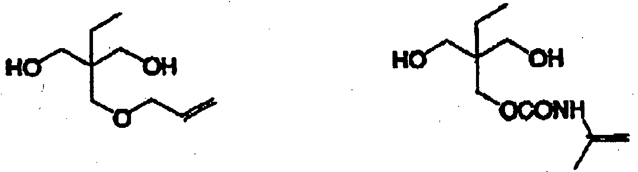

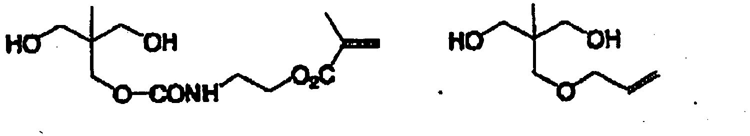

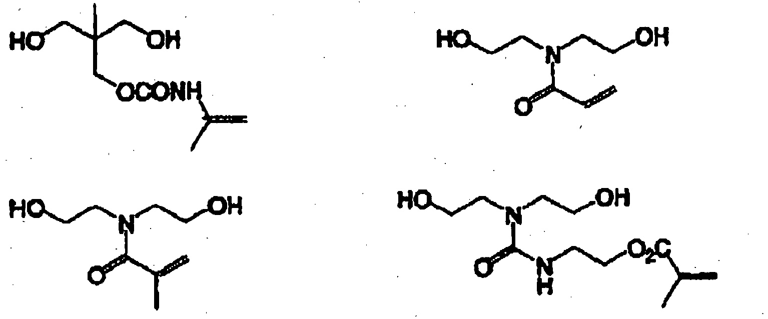

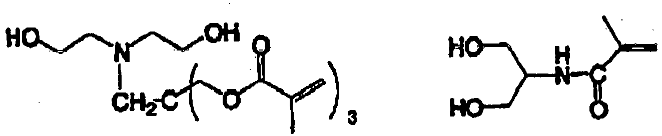

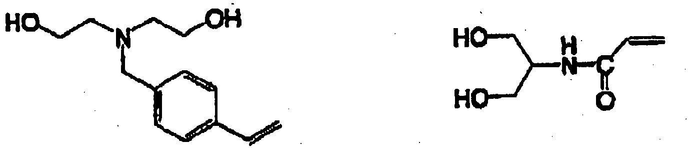

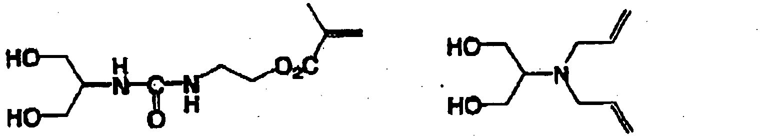

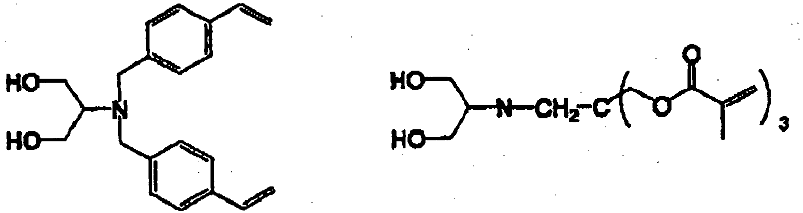

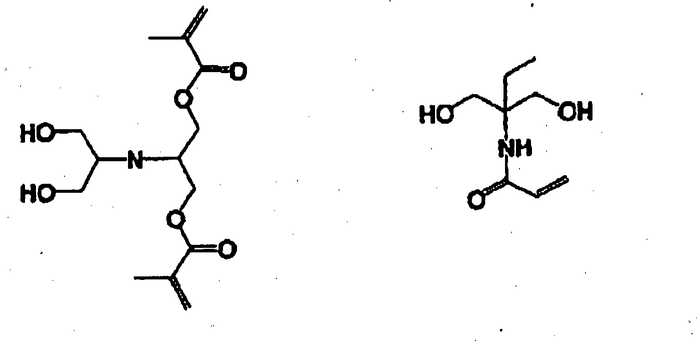

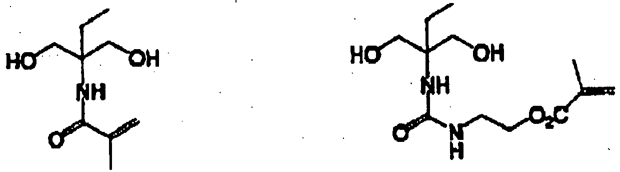

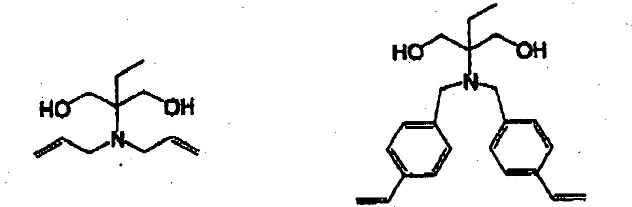

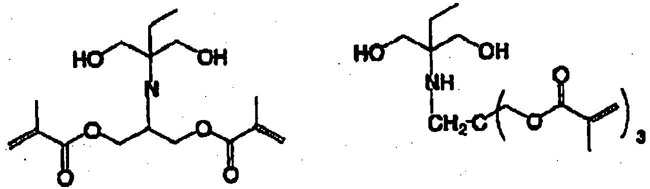

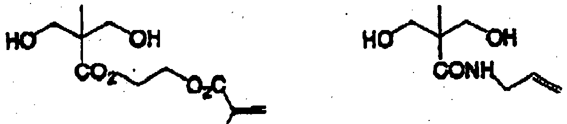

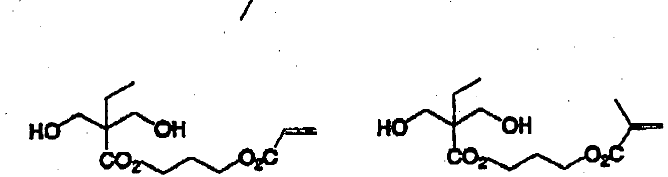

Other examples of the other diol compound include ethylene glycol compounds represented by the following formula (A'):

HO-(CH₂CH₂O)ₙ-H (A')

In formula (A'), n represents an integer of 1 or more.

Also, random copolymers and block copolymers between ethylene oxide and propylene oxide having hydroxy groups at the terminals are exemplified.

Further, an ethylene oxide adduct of bisphenol A (addition number of the ethylene oxide is from 27 to 100), an ethylene oxide adduct of bisphenol F (addition number of the ethylene oxide is from 22 to 100), an ethylene oxide adduct of hydrogenated bisphenol A (addition number of the ethylene oxide is from 23 to 100) and an ethylene oxide adduct of hydrogenated bisphenol F (addition number of the ethylene oxide is from 18 to 100) are also used. More specifically, the ethylene glycol compounds represented by formula (A') are preferable in view of the stain resistance. The ethylene glycol compounds represented by formula (A') wherein n is form 2 to 50 are more preferable, those wherein n is form 3 to 30 are still more preferable, and those wherein n is form 4 to 10 are particularly preferable.

Specific examples thereof include 1,2-propylene glycol, di-1,2-propylene glycol, tri-1,2-propylene glycol, tetra-1,2-propylene glycol, hexa-1,2-propylene glycol, 1,3-propylene glycol, di-1,3-propylene glycol, tri-1,3-propylene glycol, tetra-1,3-propylene glycol, 1,3-butylene glycol, di-1,3-butylene glycol, tri-1,3-butylene glycol, hexa-1,3-butylene glycol, polypropylene glycol having an average molecular weight of 400, polypropylene glycol having an average molecular weight of 700, polypropylene glycol having an average molecular weight of 1,000, polypropylene glycol having an average molecular weight of 2, 000, polypropylene glycol having an average molecular weight of 3, 000, polypropylene glycol having an average molecular weight of 4,000, neopentyl glycol, 2-butene-1,4-diol, 2,2,4-trimethyl-1,3-pentanediol, 1,4-bis-β-hydroxyethoxycyclohexane, 1,4-butanediol, 1,5-pentanediol, 1,6-hexanediol, 1,7-heptanediol, 1,8-octanediol, cyclohexanedimethanol, tricyclodecanedimethanol, hydrogenated bisphenol A, hydrogenated bisphenol F, an ethylene oxide adduct of bisphenol A (addition number of the ethylene oxide is 26 or less), an ethylene oxide adduct of bisphenol F (addition number of the ethylene oxide is 21 or less), an ethylene oxide adduct of hydrogenated bisphenol A (addition number of the ethylene oxide is 22 or less), an ethylene oxide adduct of hydrogenated bisphenol F (addition number of the ethylene oxide is 17 or less), a propylene oxide adduct of bisphenol A, a propylene oxide adduct of bisphenol F, a propylene oxide adduct of hydrogenated bisphenol A, a propylene oxide adduct of hydrogenated bisphenol F, hydroquinone dihydroxy ethyl ether, p-xylylene glycol, dihydroxyethylsulfone, bis(2-hydroxyethyl)-2,4-tolylenedicarbamate, 2,4-tolylene-bis(2-hydroxyethylcarbamide), bis(2-hydroxyethyl)-m-xylylenedicarbamate and bis(2-hydroxyethyl)isophthalate.

Further, polyether diol compounds of compounds represented by the following formulae (a), (b), (c), (d) and (e) are preferably used.

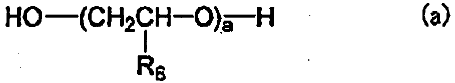

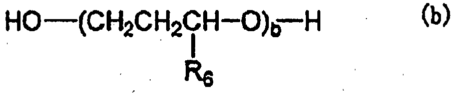

HO-(CH₂CH₂CH₂CH₂-O)_{c}-H (c)

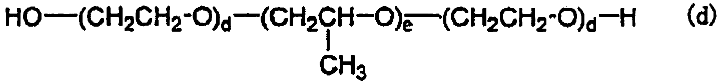

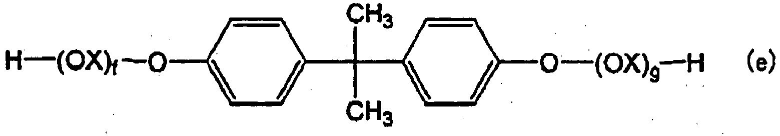

In formulae (a) to (e), R₆ represents a hydrogen atom or a methyl group, provided that R₆ in formula (a) represents a methyl group. X represents a group shown below.

-CH₂CH₂-

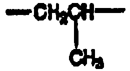

a, b, c, d, e, f and g each represents an integer of 2 or more, and preferably an integer of 2 to 100.

Polyester diol compounds represented by formulae (11) and (12) shown below are also enumerated as specific examples.

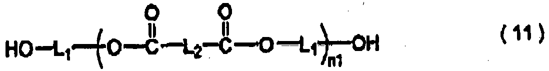

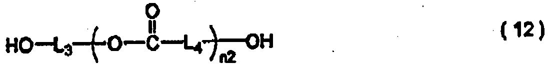

In formulae (11) and (12), L₁, L₂ and L₃, which may be the same or different, each represents a divalent aliphatic or aromatic hydrocarbon group, and L₄ represents a divalent aliphatic hydrocarbon group. Preferably, L₁, L₂ and L₃ each represents an alkylene group, an alkenylene group, an alkynylene group or an arylene group, and L₄ represents an alkylene group. Also, L₁, L₂, L₃ and L₄ each may have other functional group which does not react with the isocyanate group, for example, an ether group, a carbonyl group, an ester group, a cyano group, an olefin group, a urethane group, an amido group, a ureido group or a halogen atom. n1 and n2 each represents an integer of 2 or more, preferably an integer of 2 to 100.

Polycarbonate diol compounds represented by formula (13) shown below are also enumerated as specific examples.

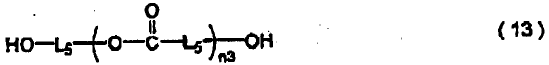

In the formula (13), L₅, which may be the same or different, each represents a divalent aliphatic or aromatic hydrocarbon group. Preferably, L₅ represents an alkylene group, an alkenylene group, an alkynylene group or an arylene group. Also, L₅ may have other functional group which does not react with the isocyanate group, for example, an ether group, a carbonyl group, an ester group, a cyano group, an olefin group, a urethane group, an amido group, a ureido group or a halogen atom. n3 represents an integer of 2 or more, preferably an integer of 2 to 100.

Specific examples of the diol compound represented by formula (11), (12) or (13) include those shown below. In the specific examples, n represents an integer of 2 or more.

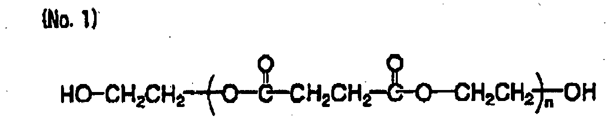

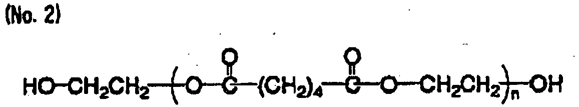

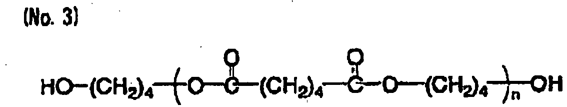

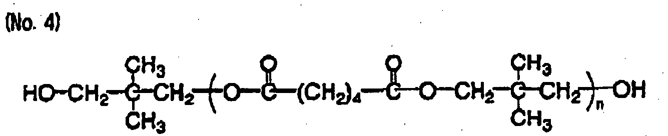

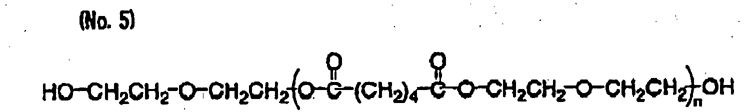

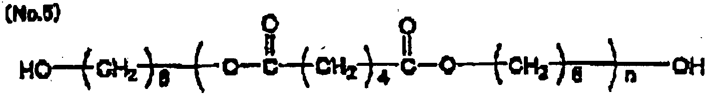

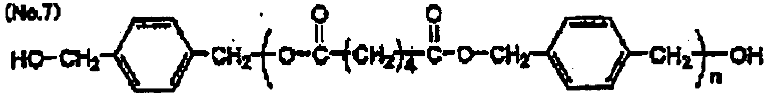

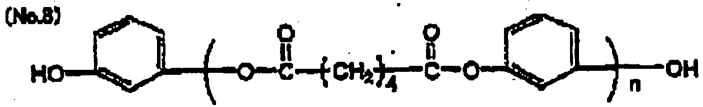

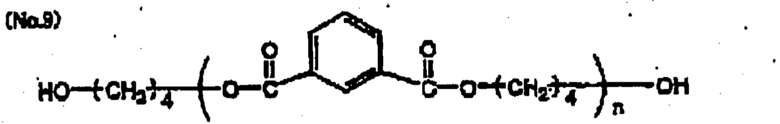

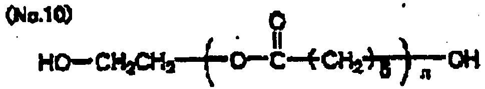

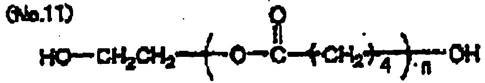

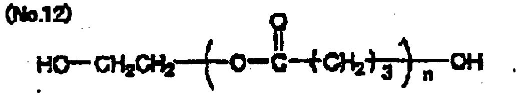

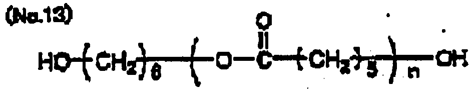

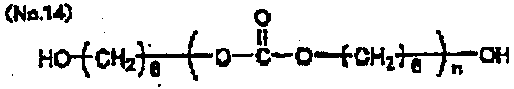

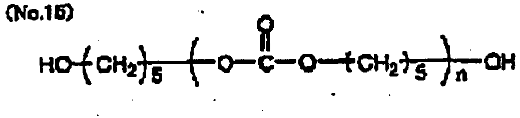

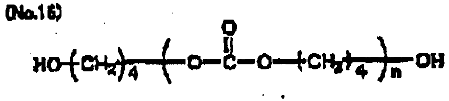

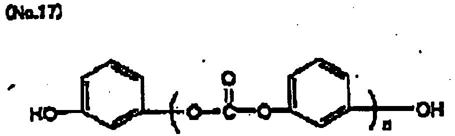

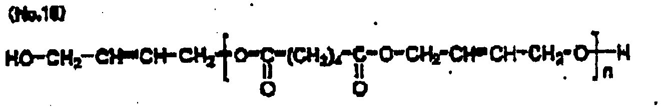

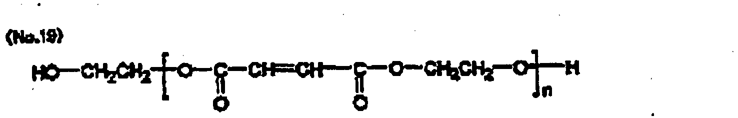

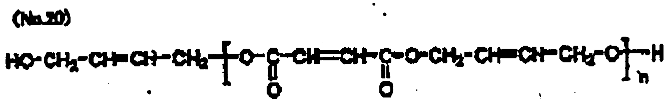

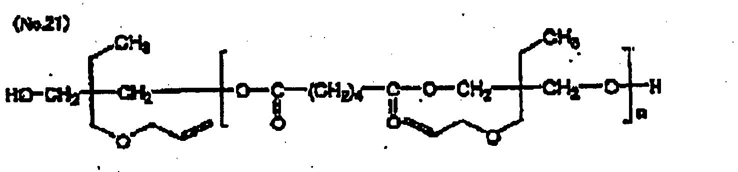

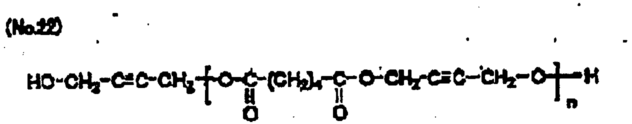

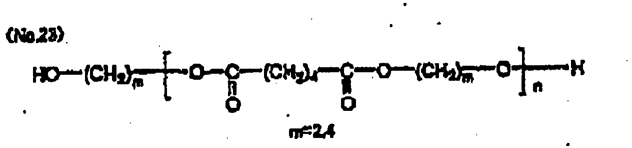

Moreover, a diol compound that does not have a carboxy group and that may have other functional group which does not react with the isocyanate group may be used.

Examples of such a diol compound include those represented by formulae (14) and (15) shown below.

HO-L₆-O-CO-L₇-CO-O-L₆-OH (14)

HO-L₇-CO-O-L₆-OH (15)

In formulae (14) and (15), L₆ and L₇, which may be the same or different, each represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group or a halogen atom (e.g., -F, -Cl, -Br or -I)). L₆ and L₇ each may have other functional group which does not react with the isocyanate group, for example, a carbonyl group, an ester group, a urethane group, an amido group or a ureido group, if desired. Alternatively, L₆ and L₇ may be combined with each other to form a ring.

Specific examples of the diol compound represented by formula (14) or (15) include those shown below.

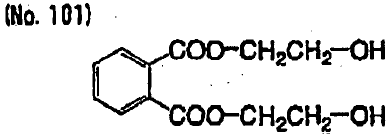

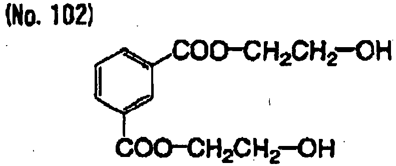

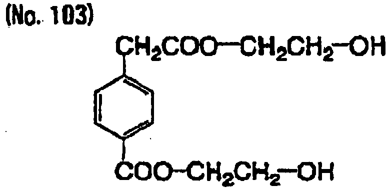

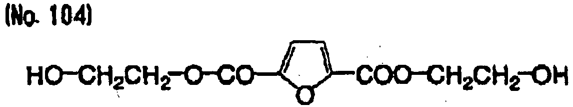

**(No. 105)** **HO-CH₂CH₂-O-CO-CH=CH-COO-CH₂CH₂-OH**

**(No. 106)** **HO-CH₂CH₂-O-COC₁₁H₂₂COO-CH₂CH₂-OH**

**(No. 107)** **HO-CH₂CH₂-O-COC₁₂H₂₄COO-OH₂CH₂-OH**

**(No. 108)** **HO-CH₂CH₂-O-COC₁₄H₂₈COO-CH₂CH₂-OH**

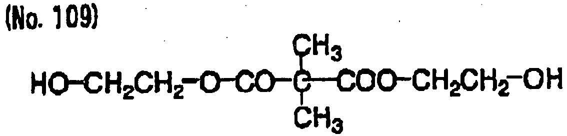

**(No. 110)** **HO-CH₂CH₂-O-CO-C=C-COO-CH₂CH₂-OH**

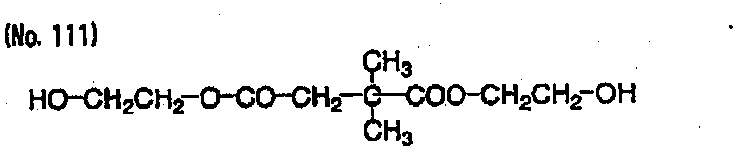

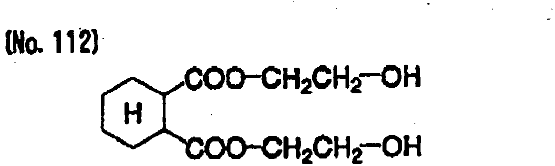

**(No. 113)** **HO-CH₂CH₂-O-CO-CH₂-O-CH₂COO-CH₂CH₂-OH**

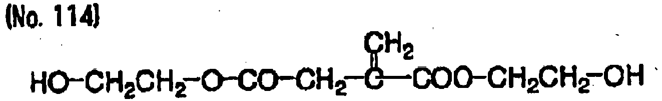

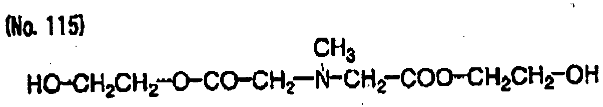

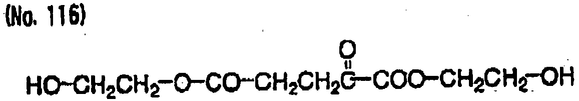

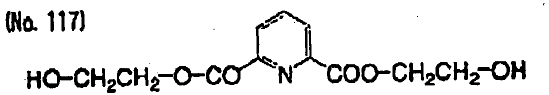

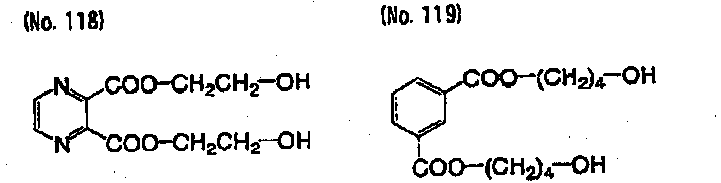

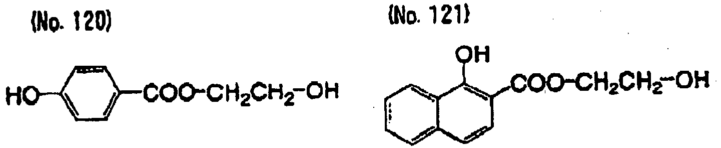

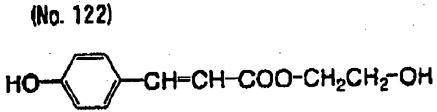

**(No. 123)** **HO-CH₂CH₂-COO-CH₂CH₂-OH**

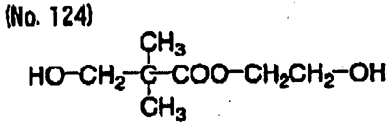

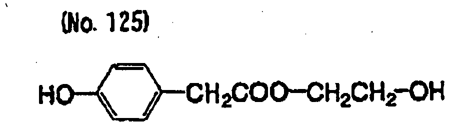

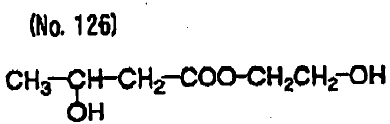

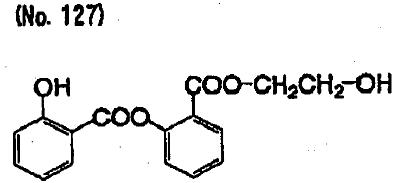

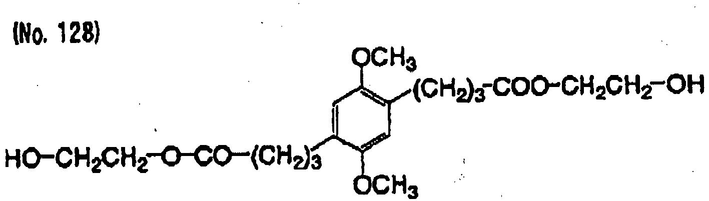

Moreover, diol compounds shown below are also preferably used.

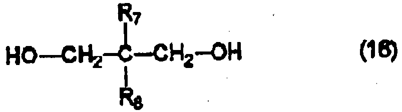

**HO-CH₂-C≡C-CH₂-OH** **(17)**

**HO-CH₂-CH=CH-CH₂-OH** **(18)**

In the formula (16), R₇ and R₈, which may be the same or different, each represents an alkyl group which may have a substituent, preferably an alkyl group having from 1 to 10 carbon atoms which may have a substituent (for example, a cyano group, a nitro group, a halogen atom (e.g., -F, -Cl, -Br or -I), -CONH₂, -COOR or -OR (wherein R, which may be the same or different, each represents an alkyl group having from 1 to 10 carbon atoms, an aryl group having from 7 to 15 carbon atoms or an aralkyl group)).

Specific examples of the diol compound represented by formula (16) include those shown below.

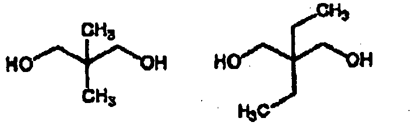

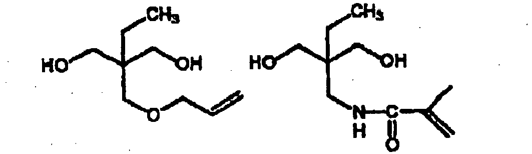

Example of the diol compound represented by formula (17) includes 2-butyne-1,4-diol. Examples of the diol compound represented by formula (18) include cis-2-butene-1,4-diol and trans-2-butene-1,4-diol.

Furthermore, diol compounds represented by formulae (19) and (20) shown below are also preferably used.

HO-L₈-NH-CO-L₉-CO-NH-L₈-OH (19)

HO-L₉-CO-NH-L₈-OH (20)

In formulae (19) and (20), L₈ and L₉, which may be the same or different, each represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group or a halogen atom (e.g., -F, -Cl, -Br or -I)). L₈ and L₉ each may have other functional group which does not react with the isocyanate group, for example, a carbonyl group, an ester group, a urethane group, an amido group or a ureido group, if desired. Alternatively, L₈ and L₉ may be combined with each other to form a ring.

Specific examples of the diol compound represented by formula (19) or (20) include those shown below.

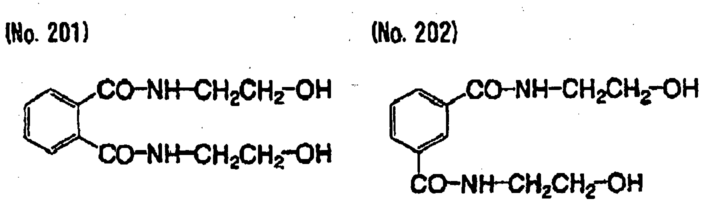

**(No. 203)** **HO-CH₂CH₂-NH-CO-CH=CH-CO-NH-CH₂CH₂-OH**

**(No. 204)** **NO-CH₂CH₂-NH-CO-C=C-CO-NH-CH₂CH₂-OH**

**(No. 205)** **HO-CH₂CH₂-NH-CO-(CH₂)₂-CO-NH-CH₂CH₂-OH**

**(No. 206)** **HO-CH₂CH₂-NH-CO-(CH₂)₃-CO-NH-CH₂CH₂-OH**

**(No. 207)** **HO-CH₂CH₂-NH-CO-(CH₂)₅-CO-NH-CH₂CH₂-OH**

**(No. 208)** **HO-CH₂CH₂-NH-CO-(CH₂)₈-CO-NH-CH₂CH₂-OH**

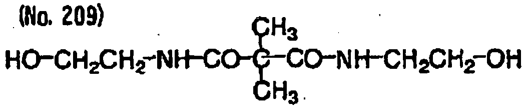

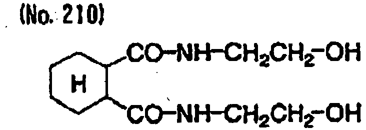

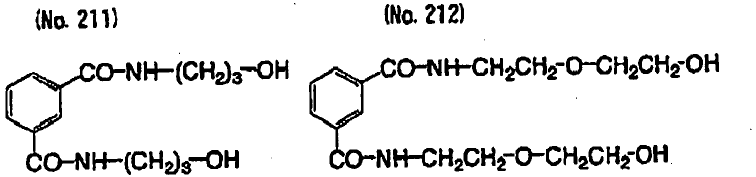

**(No. 213)** **HO-(CH₂)₃-NH-(CH₂)₃-NH-CO-(CH₂)₂-CO-NH-(CH₂)₃-OH**

**(No. 214)** **HO-CH₂CH₂-O-CH₂CH₂-NH-CO-(CH₂)₄-CO-NH-CH₂CH₂-O-CH₂CH₂-OH**

**(No. 215)** **HO-CH₂CH₂-NH-CO-CH₂-O-CH₂-CO-NH-CH₂CH₂-OH**

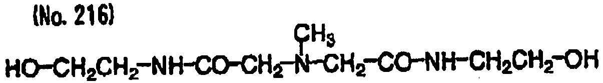

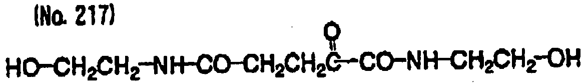

**(No. 218)** **HO-CH₂CH₂-NH-CO-CH₂-S-CH₂-CO-NH-CH₂CH₂-OH**

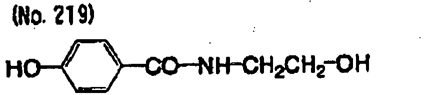

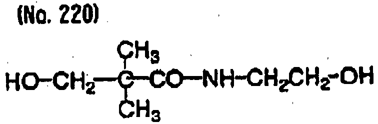

Furthermore, diol compounds represented by formulae (21) and (22) shown below are also preferably used.

**HO-Ar₂-(L₁₆-Arg)ₙ-OH** (21)

HO-Ar₂-L₁₆-OH (22)

In formulae (21) and (22), L₁₆ represents a divalent aliphatic hydrocarbon group which may have a substituent (for example, an alkyl group, an aralkyl group, an aryl group, an alkoxy group, an aryloxy group or a halogen atom). L₁₆ may have other functional group which does not react with the isocyanate group, for example, an ester group, a urethane group, an amido group or a ureido group, if desired.

Ar₂ and Ar₃, which may be the same or different, each represents a divalent aromatic hydrocarbon group which may have a substituent, preferably an aromatic group having from 6 to 15 carbon atoms. n represents an integer of 0 to 10.

Specific examples of the diol compound represented by formula (21) or (22) include those shown below.

Specifically, catechol, resorcine, hydroquinone, 4-methylcatechol, 4-tert-butylcatechol, 4-acetylcatechol, 3-methoxycatechol, 4-phenylcatechol, 4-methylresorcine, 4-ethylresorcine, 4-tert-butylresorcine, 4-hexylresorcine, 4-chlororesorcine, 4-benzylresorcine, 4-acetylresorcine, 4-carbomethoxyresorcine, 2-methylresorcine, 5-methylresorcine, tert-butylhydroquinone, 2,5-di-tert-butylhydroquinone, 2,5-di-tert-amylhydroquinone, tetramethylhydroquinone, tetrachlorohydroquinone, methylcarboaminohydroquinone, methylureidohydroquinone, methylthiohydroquinone, benzonorbornene-3,6-diol, bisphenol A, bisphenol S, 3,3'-dichlorobisphenol S, 4,4'-dihydroxybenzophenone, 4,4'-dihydroxybiphenyl, 4,4'-thiodiphenol, 2,2'-dihydroxydiphenylmethane, 3,4-bis(p-hydroxyphenyl)hexane, 1,4-bis(2-p-hydroxyphenyl)propyl)benzene, bis(4-hydroxyphenyl)methylamine, 1,3-dihydroxynaphthalene, 1,4-dihydroxynaphthalene, 1,5-dihydroxynaphthalene, 2,6-dihydroxynaphthalene, 1,5-dihydroxyanthraquinone, 2-hydroxybezyl alcohol, 4-hydroxybezyl alcohol, 2-hydroxy-3,5-di-tert-butylbezyl alcohol, 4-hydroxy-3,5-di-tert-butylbezyl alcohol, 4-hydroxyphenethyl alcohol, 2-hydroxyethyl-4-hydroxybenzoate, 2-hydroxyethyl-4-hydroxyphenylacetate and resorcine mono-2-hydroxyethyl ether are exemplified. Diol compounds shown below are also preferably used.

### (v) Other amino group-containing compound

In the polyurethane resin binder according to the invention, an amino group-containing compound represented by formula (31) or (32) shown below may be used together to react with the diisocyanate compound, thereby forming a urea structure to incorporate into the polyurethane resin.

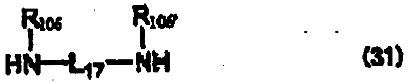

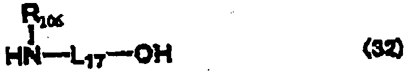

In formulae (31) and (32), R₁₀₆ and R₁₀₆', which may be the same or different, each represents a hydrogen atom, an alkyl group, an aralkyl group or an aryl group, each of which may have a substituent (for example, an alkoxy group, a halogen atom (e.g., -F, -Cl, -Br or -I), an ester group or a carboxyl group), preferably a hydrogen atom, an alkyl group having from 1 to 8 carbon atoms or an aryl group having from 6 to 15 carbon atoms, each of which may have a carboxyl group as a substituent. L₁₇ represents a divalent aliphatic hydrocarbon group, aromatic hydrocarbon group or heterocyclic group, each of which may have a substituent (for example, an alkyl group, an aralkyl group, an aryl group, an alkoxy group, an aryloxy group, a halogen atom (e.g., -F, -Cl, -Br or -I) or a carboxyl group). L₁₇ may have other functional group which does not react with the isocyanate group, for example, a carbonyl group, an ester group, a urethane group or an amido group, if desired. Alternatively, two of R₁₀₆, L₁₇ and R₁₀₆' may be combined with each other to form a ring.

Specific examples of the compound represented by formula (31) or (32) include the following compounds.

Specifically, aliphatic diamine compounds, for example, ethylenediamine, propylenediamine, tetramethylenediamine, pentamethylenediamine, hexamethylenediamine, heptamethylenediamine, octamethylenediamine, dodecamethylenediamine, propane-1,2-diamine, bis(3-aminopropyl)methylamine, 1,3-bis(3-aminopropyl)tetramethylsiloxane, piperazine, 2,5-dimethylpiperazine, N-(2-aminoethyl)piperazine, 4-amino-2,2,6,6-tetramethylpiperidine, N,N-dimethylethylenediamine, lysine, L-cystine or isophorondiamine; aromatic diamine compounds, for example, o-phenylenediamine, m-phenylenediamine, p-phenylenediamine, 2,4-tolylenediamine, benzidine, o-ditoluidine, o-dianisidine, 4-nitro-m-phenylenediamine, 2,5-dimethoxy-p-phenylenediamine, bis(4-aminophenyl)sulfone, 4-carboxy-o-phenylenediamine, 3-carboxy-m-phenylenediamine, 4,4'-diaminophenyl ether or 1,8-naphthalenediamine; heterocyclic amine compounds, for example, 2-aminoimidazole, 3-aminotriazole, 5-amino-1H-tetrazole, 4-aminopyrazole, 2-aminobenzimidazole, 2-amino-5-carboxytriazole, 2,4-diamono-6-methyl-S-triazine, 2,6-diaminopyridine, L-hystidine, DL-tryptophan or adenine; and aminoalcohol or aminophenol compounds, for example, ethanolamine, N-methylethanolamine, N-ethylethanolamine, 1-amino-2-propanol, 1-amino-3-propanol, 2-aminoethoxyethanol, 2-aminothioethoxyethanol, 2-amino-2-methyl-1-propanol, p-aminophenol, m-aminophenol, o-aminophenol, 4-methyl-2-aminophenol, 2-chloro-4-aminophenol, 4-methoxy-3-aminophenol, 4-hydroxybenzylamine, 4-amino-1-naphthol, 4-aminosalicylic acid, 4-hydroxy-N-phenylglycine, 2-aminobenzyl alcohol, 4-aminophenethyl alcohol, 2-carboxy-5-amino-1-naphthol or L-tyrosine are enumerated.

A polyurethane resin obtained by introducing a crosslinkable group into polyurethane having a carboxyl group by a polymer reaction as described in JP-A-2003-270775 may also be used as the binder polymer according to the invention as well as the above-described polyurethane resin obtained by introducing a crosslinkable group into a side chain at the synthesis of polyurethane.

According to the invention, a combination of the monomer having a melting point of 60°C or more represented by formula (I) described above with a urethane resin containing a crosslinkable group and having a Tg of 45°C or more, preferably, with a urethane resin containing a crosslinkable group and having a Tg of 50°C or more and is used. Specific example of the urethane resin is set forth below, but the invention should not be construed as being limited thereto.

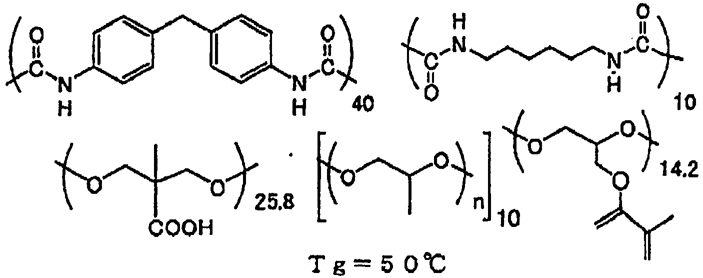

The molecular weight of the binder polymer according to the invention is appropriately determined in view of the image-forming property and printing durability. It is preferably in a range from 2,000 to 1,000,000, more preferably from 5,000 to 500,000, still more preferably from 10,000 to 200,000.

The polymer binders may be used individually or in combination of two or more thereof in the invention. The acrylic resin described above may be used together with the urethane resin. Further, other known binder may be used in combination as long as the effects of the invention are not damaged.

The total amount of the binder including a binder which may be used together in the image-recording layer can be appropriately determined. It is ordinarily in a range from 10 to 90% by weight, preferably from 20 to 80% by weight, more preferably from 30 to 70% by weight, based on the total weight of the nonvolatile components in the mage-recording layer. Further, a weight ratio of the monomer to the binder is preferably in a range from 1/9 to 9/1, more preferably from 2/8 to 8/2, still preferably from 3/7 to 7/3.

### <Sensitizing dye>

A sensitizing dye corresponding to a wavelength of an exposure light source may be incorporated into the image-recording layer according to the invention. Specifically, a sensitizing dye corresponding to an ultraviolet ray, visible light or infrared ray can be used. It is preferred to incorporate a sensitizing dye having an absorption maximum in a wavelength range of 250 to 450 nm in response to a light source of the ultraviolet region. Examples of the sensitizing dye include merocyanine dyes represented by formula (V) shown below, benzopyranes or coumarins represented by formula (VI) shown below, aromatic ketones represented by formula (VII) shown below and anthracenes represented by formula (VIII) shown below.

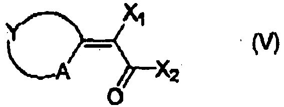

In formula (V), A represents a sulfur atom or NR₆, R₆ represents a monovalent non-metallic atomic group, Y represents a non-metallic atomic group necessary for forming a basic nucleus of the dye together with adjacent A and the adjacent carbon atom, and X₁ and X₂ each independently represents a monovalent non-metallic atomic group or X₁ and X₂ may be combined with each other to form an acidic nucleus of the dye.

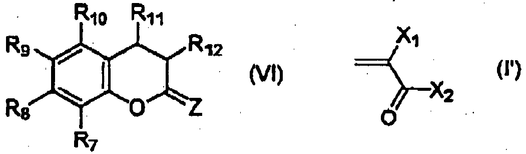

In formula (VI), **=Z** represents an oxo group, a thioxo group, an imino group or an alkylydene group represented by the partial structural formula (1') described above, X₁ and X₂ have the same meanings as defined in formula (V) respectively, and R₇ to R₁₂ each independently represents a monovalent non-metallic atomic group.

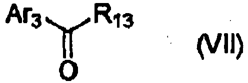

In formula (VII), Ar₃ represents an aromatic group which may have a substituent or a heteroaromatic group which may have a substituent, and R₁₃ represents a monovalent non-metallic atomic group. R₁₃ preferably represents an aromatic group or a heteroaromatic group. Ar₃ and R₁₃ may be combined with each other to form a ring.

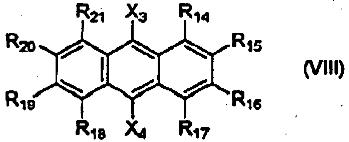

In formula (VIII), X₃, X₄ and R₁₄ to R₂₁ each independently represents a monovalent non-metallic atomic group. Preferably, X₃ and X₄ each independently represents an electron-donating group having a negative Hammett substituent constant.

In formulae (V) to (VIII), preferable examples of the monovalent non-metallic atomic group represented by any one of X₁ to X₄ and R₆ to R₂₁ include a hydrogen atom, an alkyl group (for example, a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group, a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl, group, a 2-butenyl group, a 2-methylallyl group, a 2-methylpropenylmethyl group, a 2-propynyl group, a 2-butynyl group or a 3-butynyl group), an aryl group (for example, a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a nitrophenyl group, a cyanophenyl group, a sulfophenyl group, a sulfonatophenyl group, a phosphonophenyl group or a phosphonatophenyl group), a heteroaryl group (for example, a group derived from a heteroaryl ring, for example, thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthylidine, quinazoline, cinnoline, pteridine, carbazole, carboline, phenanthrine, acridine, perimidine, phenanthroline, phthalazine, phenarsazine, phenoxazine, furazane or phenoxazine), an alkenyl group (for example, a vinyl group, a 1-propenyl group, a 1-butenyl group, a cinnamyl group or a 2-chloro-1-ethenyl group), an alkynyl group (for example, an ethynyl group, a 1-propynyl group, a 1-butynyl group or a trimethylsilylethynyl group), a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and its conjugated base group (hereinafter referred to as a "phosphonato group"), a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and its conjugated base group (hereinafter referred to as an "alkylphosphonato group"), a monoarylphosphono group (-PO₃H(aryl)) and its conjugated base group (hereinafter referred to as an "arylphosphonato group"), a phosphonooxy group (-OPO₃H₂) and its conjugated base group (hereinafter referred to as a "phosphonatooxy group"), a dialkylphosphonooxy group (-OPO₃(alkyl)₂), a diarylphosphonooxy group (-OPO₃(aryl)₂), an alkylarylphosphonooxy group (-OPO₃(alkyl)(aryl)), a monoalkylphosphonooxy group (-OPO₃H(alkyl)) and its conjugated base group (hereinafter referred to as an "alkylphosphonatooxy group"), a monoarylphosphonooxy group (-OPO₃H(aryl)) and its conjugated base group (hereinafter referred to as an "arylphosphonatooxy group"), a cyano group and a nitro group . Among the above-described groups, a hydrogen atom, an alkyl group, an aryl group, a halogen atom, an alkoxy group and an acyl group are particularly preferred.

The basic nucleus of the dye formed by Y together with the adjacent A and the adjacent carbon atom in formula (V) includes, for example, a 5-membered, 6-membered or 7-membered, nitrogen-containing or sulfur-containing heterocyclic ring, and is preferably a 5-membered or 6-membered heterocyclic ring.

As the nitrogen-containing heterocyclic ring, those which are known to constitute basic nuclei in merocyanine dyes described in L.G. Brooker et al, J. Am. Chem. Soc., Vol. 73, pp. 5326 to 5358 (1951) and references cited therein can be preferably used. Specific examples thereof include thiazoles (for example, thiazole, 4-methylthiazole, 4-phenylthiazole, 5-methylthiazole, 5-phenylthiazole, 4,5-dimethylthiazole, 4,5-diphenylthiazole, 4,5-di(p-methoxyphenyl)thiazole or 4-(2-thienyl)thiazole); benzothiazoles (for example, benzothiazole, 4-chlorobenzothiazole, 5-chlorobenzothiazole, 6-chlorobenzothiazole, 7-chlorobenzothiazole, 4-methylbenzothiazole, 5-methylbenzothiazole, 6-methylbenzothiazole, 5-bromobenzothiazole, 4-phenylbenzothiazole, 5-phenylbenzothiazole, 4-methoxybenzothiazole, 5-methoxybenzothiazole, 6-methoxybenzothiazole, 5-iodobenzothiazole, 6-iodobenzothiazole, 4-ethoxybenzothiazole, 5-ethoxybenzothiazole, tetrahydrobenzothiazole, 5,6-dimethoxybenzothiazole, 5,6-dioxymethylenebenzothiazole, 5-hydroxybenzothiazole, 6-hydroxybenzothiazole, 6-dimethylaminobenzothiazole or 5-ethoxycarbonylbenzothiazole); naphthothiazoles (for example, naphtho[1,2]thiazole, naphtho[2,1]thiazole, 5-methoxynaphtho[2,1]thiazole, 5-ethoxynaphtho[2,1]thiazole, 8-methoxynaphtho[1,2]thiazole or 7-methoxynaphtho[1,2]thiazole); thianaphtheno-7',6',4,5-thiazoles (for example, 4'-methoxythianaphtheno-7',6' ,4,5-thiazole); oxazoles (for example, 9-methyloxazole, 5-methyloxazole, 4-phenyloxazole, 4,5-diphenyloxazole, 4-ethyloxazole, 4,5-dimethyloxazole or 5-phenyloxazole); benzoxazoles (for example, benzoxazole, 5-chlorobenzoxazole, 5-methylbenzoxazole, 5-phenylbenzoxazole, 6-methylbenzoxazole, 5,6-dimethylbenzoxazole, 4,6-dimethylbenzoxazole, 6-methoxybenzoxazole, 5--methoxybenzvxazole, 4-ethoxybenzoxazole, 5-chlorobenzoxazole, 6-methoxybenzoxazole, 5-hydroxybenzoxazole or 6-hydroxybenzoxazole); naphthoxazoles (for example, naphth[1,2]oxazole or naphth[2,1]oxazole); selenazoles (for example, 4-methylselenazole or 4-phenylselenazole); benzoselenazoles (for example, benzoselenazole, 5-chlorobenzoselenazole, 5-methoxybenzoselenazole, 5-hydroxybenzoselenazole or tetrahydrobenzoselenazole); naphthoselenazoles (for example, naphtho[1,2]selenazole or naphtho[2,1]selenazole); thiazolines (for example, thiazoline or 4-methylthiazoline); 2-quinolines (for example, quinoline, 3-methylquinoline, 5-methylquinoline, 7-methylquinoline, 8-methylquinoline, 6-chloroquinoline, 8-chloroquinoline, 6-methoxyquinoline, 6-ethoxyquinoline, 6-hydroxyquinoline or 8-hydroxyquinoline); 4-quinolines (for example, quinoline, 6-methoxyquinoline, 7-methylquinoline or 8-methylquinoline); 1-isoquinolines (for example, isoquinoline or 3,4-dihydroisoquinoline); 3-isoquinolines (for example, isoquinoline); benzimidazoles (for example, 1,3-diethylbenzimidazole or 1-ethyl-3-phenylbenzimidazole); 3,3-dialkylindolenines (for example, 3,3-dimethylindolenine, 3,3,5-trimethylindolenine or 3,3,7-trimethylindolenine); and 2-pyridines (for example, pyridine or 5-methylpyridine); and 4-pyridines (for example, pyridine).

Examples of the sulfur-containing heterocyclic ring include dithiol partial structures in dyes described in JP-A-3-296759.

Specific examples thereof include benzodithiols (for example, benzodithiol, 5-tert-butylbenzodithiol or 5-methylbenzodithiol); naphthodithiols (for example, naphtho[1,2]dithiol or naphtho[2,1]dithiol); and dithiols (for example, 4,5-dimethyldithiol, 4-phenyldithiol, 4-methoxycarbonyldithiol, 4,5-dimethoxycarbonyldithiol, 4,5-ditrifluoromethyldithiol, 4,5-dicyanodithiol, 4-methoxycarbonylmethyldithiol or 4-carboxymethyldithiol).

In the description with respect to the heterocyclic ring above, for convenience and by convention, the names of heterocyclic mother skeletons are used. In the case of constituting the basic nucleus partial structure in the sensitizing dye, the heterocyclic ring is introduced in the form of a substituent of alkylydene type where a degree of unsaturation is decreased one step. For example, a benzothiazole skeleton is introduced as a 3-substituted-2(3H)-benzothiazolilydene group.

Of the sensitizing dyes having an absorption maximum in a wavelength range of 350 to 450 nm, dyes represented by formula (IX) shown below are more preferable in view of high sensitivity.

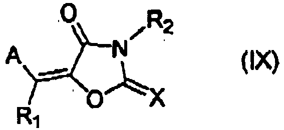

In formula (IX), A represents an aromatic cyclic group which may have a substituent or a heterocyclic group which may have a substituent, X represents an oxygen atom, a sulfur atom or =N (R₃), and R₁, R₂ and R₃ each independently represents a hydrogen atom or a monovalent non-metallic atomic group, or A and R₁ or R₂ and R₃ may be combined with each other to form an aliphatic or aromatic ring.

The formula (IX) will be described in more detail below. R₁, R₂ and R₃ each independently represents a hydrogen atom or a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxy group or a halogen atom.

Preferable examples of R₁, R₂ and R₃ will be specifically described below. Preferable examples of the alkyl group include a straight chain, branched or cyclic alkyl group having from 1 to 20 carbon atoms. Specific examples thereof include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, an eucosyl group, an isopropyl group, an isobutyl group, a sec-butyl group, a tert-butyl group, an isopentyl group, a neopentyl group, a 1-methylbutyl group, an isohexyl group, a 2-ethylhexyl group, a 2-methylhexyl group, a cyclohexyl group, a cyclopentyl group and a 2-norbornyl group. Among them, a straight chain alkyl group having from 1 to 12 carbon atoms, a branched alkyl group having from 3 to 12 carbon atoms and a cyclic alkyl group having from 5 to 10 carbon atoms are more preferable.

As the substituent for the substituted alkyl group, a monovalent non-metallic atomic group exclusive of a hydrogen atom is used. Preferable examples thereof include a halogen atom (for example, -F, -Br, -Cl or -I), a hydroxy group, an alkoxy group, an aryloxy group, a mercapto group, an alkylthio group, an arylthio group, an alkyldithio group, an aryldithio group, an amino group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an alkylsulfoxy group, an arylsulfoxy group, an acylthio group, an acylamino group, an N-alkylacylamino group, an N-arylacylamino group, a ureido group, an N'-alkylureido group, an N',N'-dialkylureido group, an N'-arylureido group, an N',N'-diarylureido group, an N'-alkyl-N'-arylureido group, an N-alkylureido group, an N-arylureido group, an N'-alkyl-N-alkylureido group, an N'-alkyl-N-arylureido group, an N',N'-dialkyl-N-alkylureido group, an N',N'-dialkyl-N-arylureido group, an N'-aryl-N-alkylureido group, an N'-aryl-N-arylureido group, an N',N'-diaryl-N-alkylureido group, an N',N'-diaryl-N-arylureido group, an N'-alkyl-N'-aryl-N-alkylureido group, an N'-alkyl-N'-aryl-N-arylureido group, an alkoxycarbonylamino group, an aryloxycarbonylamino group, an N-alkyl-N-alkoxycarbonylamino group, an N-alkyl-N-aryloxycarbonylamino group, an N-aryl-N-alkoxycarbonylamino group, an N-aryl-N-aryloxycarbonylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, an alkylsulfinyl group, an arylsulfinyl group, an alkylsulfonyl group, an arylsulfonyl group, a sulfo group (-SO₃H) and its conjugated base group (hereinafter referred to as a "sulfonato group"), an alkoxysulfonyl group, an aryloxysulfonyl group, a sulfinamoyl group, an N-alkylsulfinamoyl group, an N,N-dialkylsulfinamoyl group, an N-arylsulfinamoyl group, an N,N-diarylsulfinamoyl group, an N-alkyl-N-arylsulfinamoyl group, a sulfamoyl group, an N-alkylsulfamoyl group, an N,N-dialkylsulfamoyl group, an N-arylsulfamoyl group, an N,N-diarylsulfamoyl group, an N-alkyl-N-arylsulfamoyl group, a phosphono group (-PO₃H₂) and its conjugated base group (hereinafter referred to as a "phosphonato group"), a dialkylphosphono group (-PO₃(alkyl)₂), a diarylphosphono group (-PO₃(aryl)₂), an alkylarylphosphono group (-PO₃(alkyl)(aryl)), a monoalkylphosphono group (-PO₃H(alkyl)) and its conjugated base group (hereinafter referred to as an "alkylphosphonato group"), a monoarylphosphono group (-PO₃H(aryl)) and its conjugated base group (hereinafter referred to as an "arylphosphonato group"), a phosphonooxy group (-OPO₃H₂) and its conjugated base group (hereinafter referred to as a "phosphonatooxy group"), a dialkylphosphonooxy group (-OPO₃(alkyl)₂), a diarylphosphonooxy group (-OPO3(aryl)₂), an alkylarylphosphonooxy group (-OPO₃(alkyl)(aryl)), a monoalkylphosphonooxy group (-OPO₃H(alkyl)) and its conjugated base group (hereinafter referred to as an "alkylphosphonatooxy group"), a monoarylphosphonooxy group (-OPO₃H(aryl) ) and its conjugated base group (hereinafter referred to as an "arylphosphonatooxy group"), a cyano group, a nitro group, an aryl group, a heteroaryl group, an alkenyl group and an alkynyl group.

In the substituents, specific examples of the alkyl group include those described for the alkyl group above. Specific examples of the aryl group include a phenyl group, a biphenyl group, a naphthyl group, a tolyl group, a xylyl group, a mesityl group, a cumenyl group, a chlorophenyl group, a bromophenyl group, a chloromethylphenyl group, a hydroxyphenyl group, a methoxyphenyl group, an ethoxyphenyl group, a phenoxyphenyl group, an acetoxyphenyl group, a benzoyloxyphenyl group, a methylthiophenyl group, a phenylthiophenyl group, a methylaminophenyl group, a dimethylaminophenyl group, an acetylaminophenyl group, a carboxyphenyl group, a methoxycarbonylphenyl group, an ethoxycarbonylphenyl group, a phenoxycarbonylphenyl group, an N-phenylcarbamoylphenyl group, a nitrophenyl group, a cyanophenyl group, a sulfophenyl group, a sulfonatophenyl group, a phosphonophenyl group and a phosphonatophenyl group.

Examples of the heteroaryl group for any one of R₁, R₂ and R₃ preferably include a monocyclic or polycyclic aromatic cyclic group containing at least one of a nitrogen atom, an oxygen atom and a sulfur atom. Examples of especially preferable heteroaryl group include a group derived from a heteroaryl ring, for example, thiophene, thiathrene, furan, pyran, isobenzofuran, chromene, xanthene, phenoxazine, pyrrole, pyrazole, isothiazole, isoxazole, pyrazine, pyrimidine, pyridazine, indolizine, isoindolizine, indole, indazole, purine, quinolizine, isoquinoline, phthalazine, naphthylidine, quinazoline, cinnoline, pteridine, carbazole, carboline, phenanthrene, acridine, perimidine, phenanthroline, phthalazine, phenarsazine, phenoxazine, furazane or phenoxazine. These groups may be benzo-fused or may have a substituent.

Also, examples of the alkenyl group for any one of R₁, R₂ and R₃ preferably include a vinyl group, a 1-propenyl group, a 1-butenyl group, a cinnamyl group and a 2-chloro-1-ethenyl group. Examples of the alkynyl group include an ethynyl group, a 1-propynyl group, a 1-butynyl group and a trimethylsilylethynyl group. Examples of G₁ in the acyl group (G₁CO-) include a hydrogen atom and the above-described alkyl group and aryl group. Of the substituents, a halogen atom (for example, -F, -Br, -Cl or -I), an alkoxy group, an aryloxy group, an alkylthio group, an arylthio group, an N-alkylamino group, an N,N-dialkylamino group, an acyloxy group, an N-alkylcarbamoyloxy group, an N-arylcarbamoyloxy group, an acylamino group, a formyl group, an acyl group, a carboxyl group, an alkoxycarbonyl group, an aryloxycarbonyl group, a carbamoyl group, an N-alkylcarbamoyl group, an N,N-dialkylcarbamoyl group, an N-arylcarbamoyl group, an N-alkyl-N-arylcarbamoyl group, a sulfo group, a sulfonato group, a sulfamoyl group, an N-alkylsulfamoyl group, an N,N-dialkylsulfamoyl group, an N-arylsulfamoyl group, an N-alkyl-N-arylsulfamoyl group, a phosphono group, a phosphonato group, a dialkylphosphono group, a diarylphosphono group, a monoalkylphosphono group, an alkylphosphonato group, a monoarylphosphono group, an arylphosphonato group, a phosphonooxy group, a phosphonatooxy group, an aryl group and an alkenyl group are more preferable.

On the other hand, as an alkylene group in the substituted alkyl group, a divalent organic residue resulting from elimination of any one of hydrogen atoms on the above-described alkyl group having from 1 to 20 carbon atoms can be enumerated. Examples of preferable alkylene group include a straight chain alkylene group having from 1 to 12 carbon atoms, a branched alkylene group having from 3 to 12 carbon atoms and a cyclic alkylene group having from 5 to 10 carbon atoms.

Specific examples of the preferable substituted alkyl group represented by any one of R₁, R₂ and R₃, which is obtained by combining the above-described substituent with the alkylene group, include a chloromethyl group, a bromomethyl group, a 2-chloroethyl group, a trifluoromethyl group, a methoxymethyl group, a methoxyethoxyethyl group, an allyloxymethyl group, a phenoxymethyl group, a methylthiomethyl group, a tolylthiomethyl group, an ethylaminoethyl group, a diethylaminopropyl group, a morpholinopropyl group, an acetyloxymethyl group, a benzoyloxymethyl group, an N-cyclohexylcarbamoyloxyethyl group, an N-phenylcarbamoyloxyethyl group, an acetylaminoethyl group, an N-methylbenzoylaminopropyl group, a 2-oxoethyl group, a 2-oxopropyl group, a carboxypropyl group, a methoxycarbonylethyl group, an allyloxycarbonylbutyl group, a chlorophenoxycarbonylmethyl group, a carbamoylmethyl group, an N-methylcarbamoylethyl group, an N,N-dipropylcarbamoylmethyl group, an N-(methoxyphenyl)carbamoylethyl group, an N-methyl-N-(sulfophenyl)carbamoylmethyl group, a sulfobutyl group, a sulfonatobutyl group, a sulfamoylbutyl group, an N-ethylsulfamoylmethyl group, an N,N-dipropylsulfamoylpropyl group, an N-tolylsulfamoylpropyl group, an N-methyl-N-(phosphonophenyl)sulfamoyloctyl group, a phosphonobutyl group, a phosphonatohexyl group, a diethylphosphonobutyl group, a diphenylphosphonopropyl group, a methylphosphonobutyl group, a methylphosphonatobutyl group, a tolylphosphonohexyl group, a tolylphosphonatohexyl group, a phosphonooxypropyl group, a phosphonatooxybutyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group and a 3-butynyl group.

Preferable examples of the aryl group represented by any one of R₁, R₂ and R₃ include a fused ring formed from one to three benzene rings and a fused ring formed from a benzene ring and a 5-membered unsaturated ring. Specific examples thereof include a phenyl group, a naphthyl group, an anthryl group, a phenanthryl group, an indenyl group, an acenaphthenyl group and a fluorenyl group. Among them, a phenyl group and a naphthyl group are more preferable.

Specific examples of the preferable substituted aryl group represented by any one of R₁, R₂ and R₃ include aryl groups having a monovalent non-metallic atomic group exclusive of a hydrogen atom as a substituent on the ring-forming carbon atom of the above-described aryl group. Preferable examples of the substituent include the above-described alkyl groups and substituted alkyl groups, and the substituents described for the above-described substituted alkyl group. Specific examples of the preferable substituted aryl group include a biphenyl group, a tolyl group, a xylyl group, a mesityl group, a cumenyl group, a chlorophenyl group, a bromophenyl group, a fluorophenyl group, a chloromethylphenyl group, a trifluoromethylphenyl group, a hydroxyphenyl group, a methoxyphenyl group, a methoxyethoxyphenyl group, an allyloxyphenyl group, a phenoxyphenyl group, a methylthiophenyl group, a tolylthiophenyl group, an ethylaminophenyl group, a diethylaminophenyl group, a morpholinophenyl group, an acetyloxyphenyl group, a benzoyloxyphenyl group, an N-cyclohexylcarbamoyloxyphenyl group, an N-phenylcarbamoyloxyphenyl group, an acetylaminophenyl group, an N-methylbenzoylaminophenyl group, a carboxyphenyl group, a methoxycarbonylphenyl group, an allyloxycarbonylphenyl group, a chlorophenoxycarbonylphenyl group, a carbamoylphenyl group, an N-methylcarbamoylphenyl group, an N,N-dipropylcarbamoylphenyl group, an N-(methoxyphenyl)carbamoylphenyl group, an N-methyl-N-(sulfophenyl)carbamoylphenyl group, a sulfophenyl group, a sulfonatophenyl group, a sulfamoylphenyl group, an N-ethylsulfamoylphenyl group, an N,N-dipropylsulfamoylphenyl group, an N-tolylsulfamoylphenyl group, an N-methyl-N-(phosphonophenyl)sulfamoylphenyl group, a phosphonophenyl group, a phosphonatophenyl group, a diethylphosphonophenyl group, a diphenylphosphonophenyl group, a methylphosphonophenyl group, a methylphosphonatophenyl group, a tolylphosphonophenyl group, a tolylphosphonatophenyl group, an allylphenyl group, a 1-propenylmethylphenyl group, a 2-butenylphenyl group, a 2-methylallylphenyl group, a 2-methylpropenylphenyl group, a 2-propynylphenyl group, a 2-butynylphenyl group and a 3-butynylphenyl group.

Examples of the preferable substituted or unsubstituted alkenyl group and the preferable substituted or unsubstituted aromatic heterocyclic residue represented by any one of R₁, R₂ and R₃ include those described with respect to the alkenyl group and heteroaryl group above, respectively.

Next, A in formula (IX) will be described below. A represents an aromatic cyclic group which may have a substituent or heterocyclic group which may have a substituent. Specific examples of the aromatic cyclic group which may have a substituent and heterocyclic group which may have a substituent include those described for any one of R₁, R₂ and R₃ in formula (IX).

The sensitizing dye represented by formula (IX) is obtained by a condensation reaction of the above-described acidic nucleus or an active methyl group-containing acidic nucleus with a substituted or unsubstituted, aromatic ring or hetero ring and can be synthesized with reference to the description of JP-B-59-28329.

Preferable specific examples (D1) to (D76) of the compound represented by formula (IX) are set forth below. Further, when isomers with respect to a double bond connecting an acidic nucleus and a basic nucleus are present in each of the compounds, the invention should not be construed as being limited to any one of the isomers.

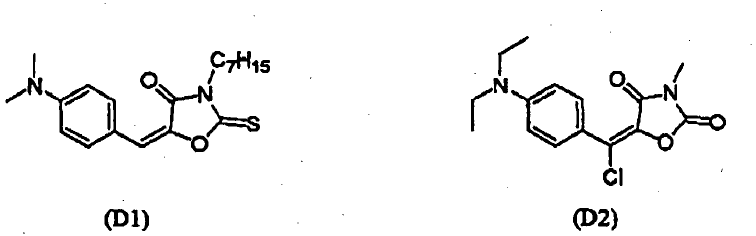

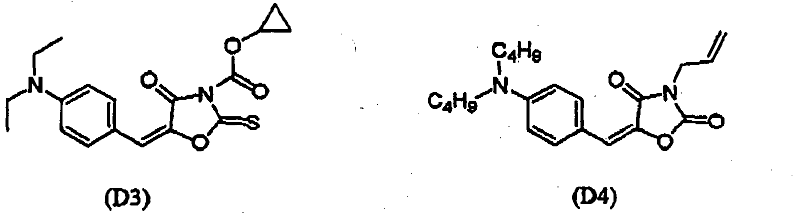

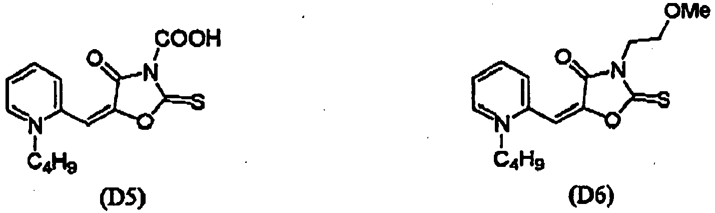

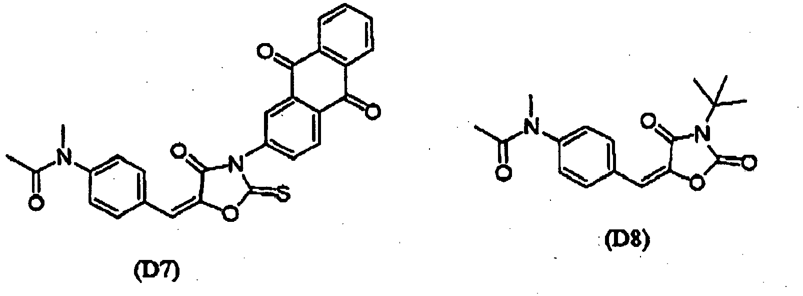

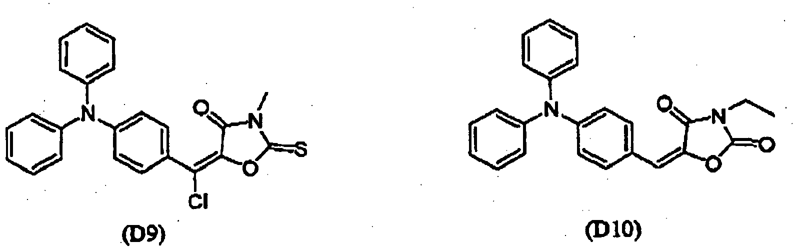

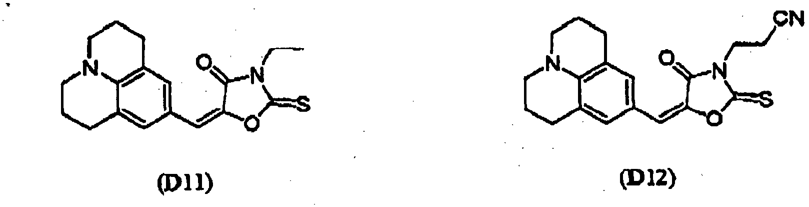

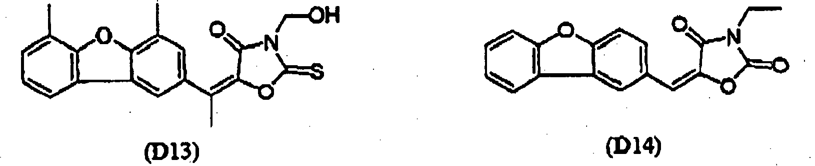

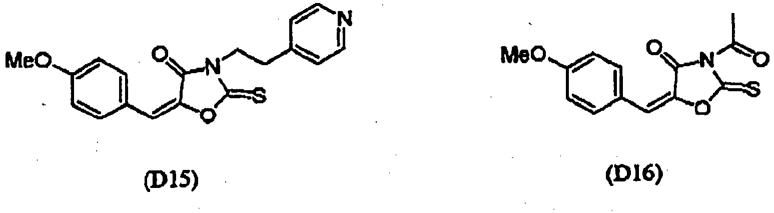

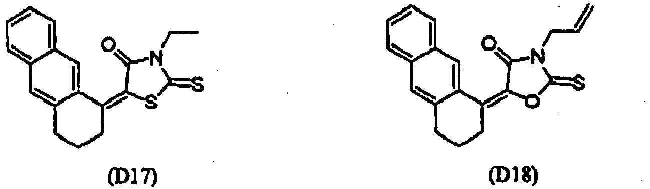

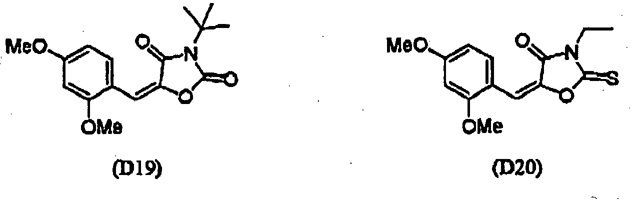

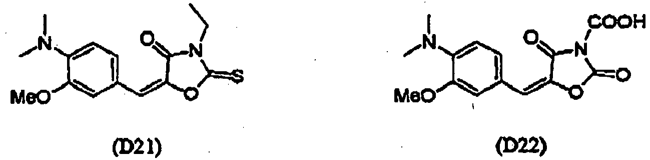

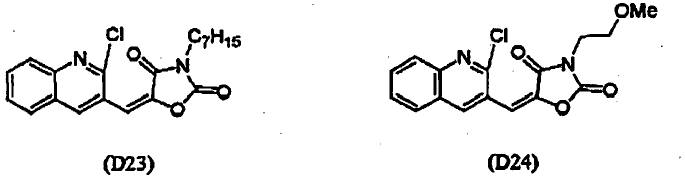

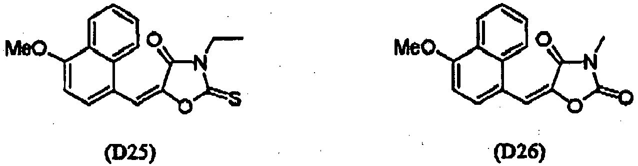

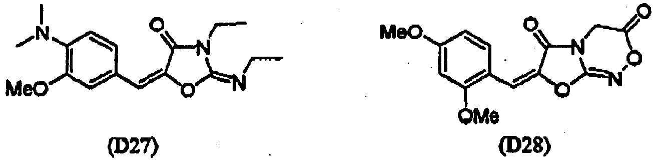

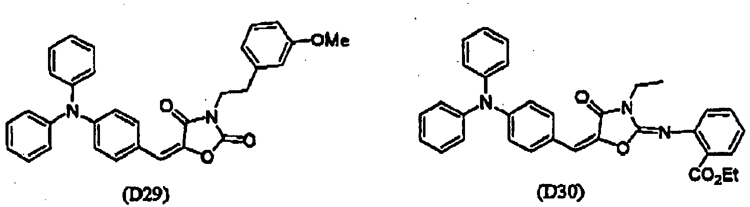

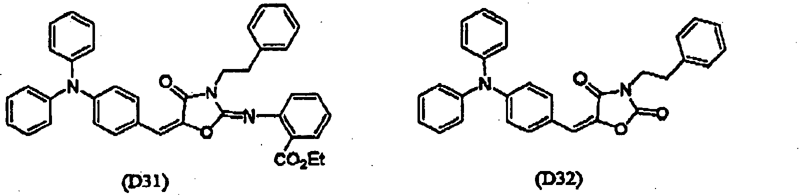

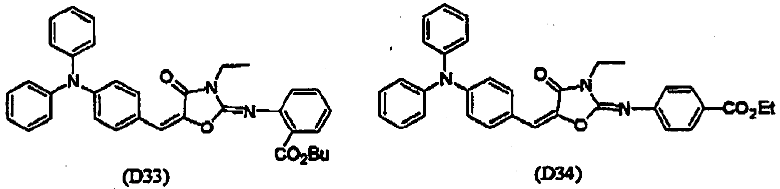

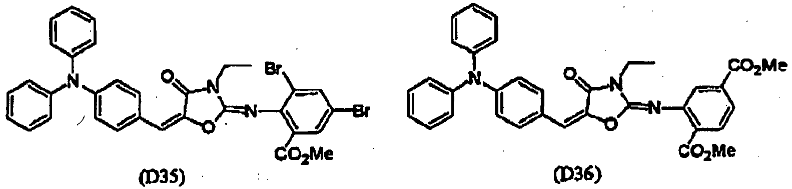

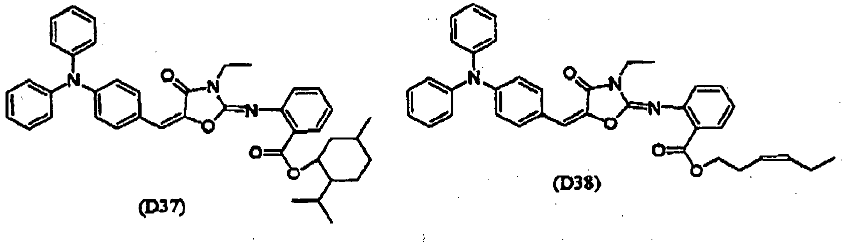

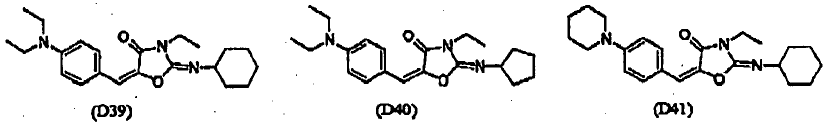

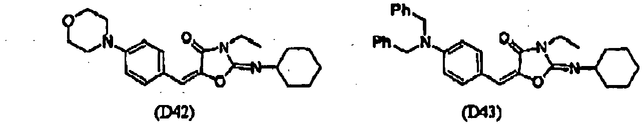

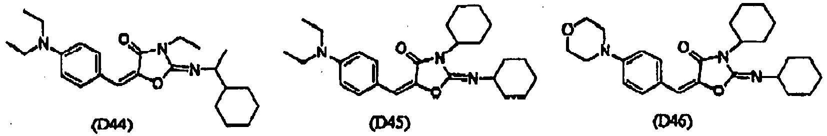

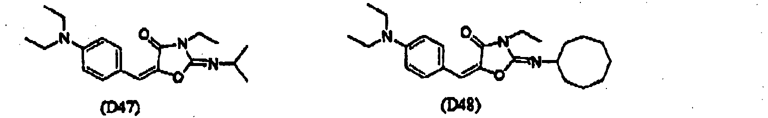

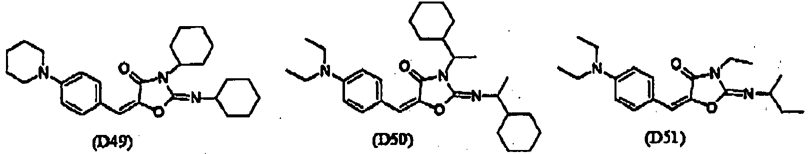

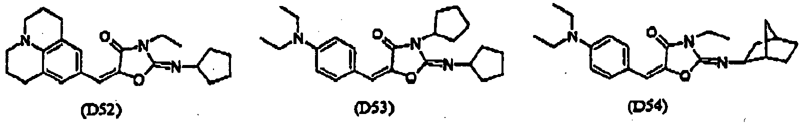

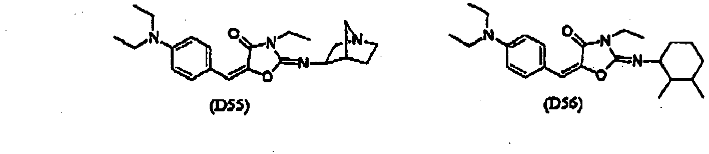

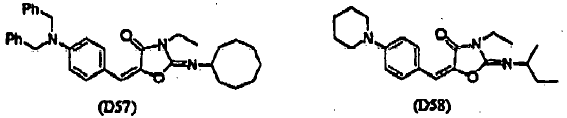

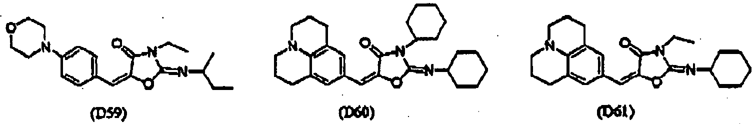

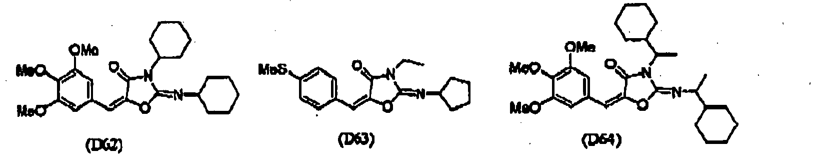

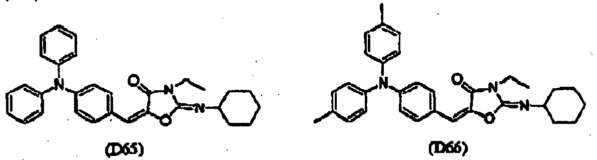

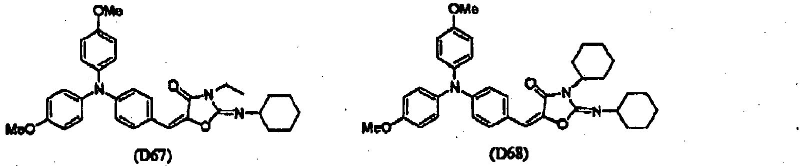

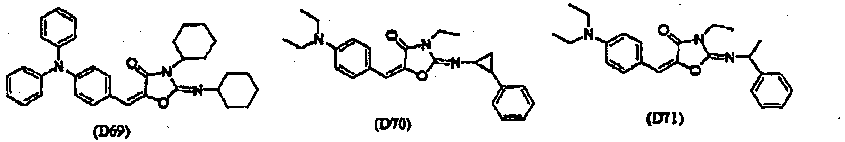

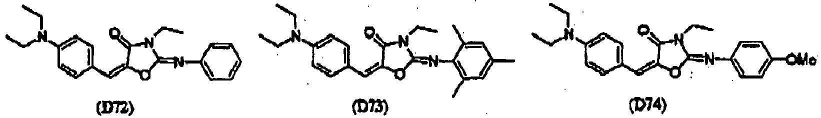

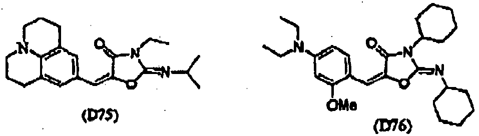

Details of the method of using the sensitizing dye, for example, selection of the structure, individual or combination use or an amount added, can be appropriately determined in accordance with the characteristic design of the final lithographic printing plate precursor.

For instance, when two or more sensitizing dyes are used in combination, the compatibility thereof in the image-recording layer can be increased. For the selection of sensitizing dye, the molar absorption coefficient thereof at the emission wavelength of the light source used is an important factor in addition to the photosensitivity. Use of the dye having a large molar absorption coefficient is profitable, because the amount of dye added can be made relatively small. Also, in case of using in the lithographic printing plate precursor, the use of such a dye is advantageous in view of physical properties of the image-recording layer. Since the photosensitivity and resolution of the image-recording layer and the physical properties of the exposed area of the image-recording layer are greatly influenced by the absorbance of sensitizing dye at the wavelength of light source, the amount of the sensitizing dye added is appropriately determined by taking account of these factors.

However, for the purpose of curing a layer having a large thickness, for example, of 5 µm or more, low absorbance is sometimes rather effective for increasing the curing degree. In the case of using in the lithographic printing plate precursor where the image-recording layer has a relatively small thickness, the amount of the sensitizing dye added is preferably selected such that the image-recording layer has an absorbance from 0.1 to 1.5, preferably from 0.25 to 1. Ordinarily, the amount of the sensitizing dye added is preferably from 0.05 to 30% by weight, more preferably from 0.1 to 20% by weight, most preferably from 0.2 to 10% by weight, based on the total solid content of the image-recording layer.

### <Photo-initiator>

The photo-initiator for use in the invention is a compound which generates a radical with light energy to initiate or accelerate polymerization of a compound having a polymerizable unsaturated group and it includes compounds referred to as photopolymerization initiators or simply polymerization initiators. Specifically, the photo-initiator includes trihalomethyl compounds, carbonyl compounds, organic peroxides, azo compounds, azido compounds, metallocene compounds, hexaarylbiimidazole compounds, organic boron compounds, disulfone compounds, oxime ester compounds and onium salt compounds. Among them, at least one compound selected from the group consisting of the hexaarylbiimidazole compounds, onium salt compounds, trihalomethyl compounds and metallocene compounds is preferable and the hexaarylbiimidazole compound is particularly referable.

The hexaarylbiimidazole polymerization initiator includes, for example, lophine dimers described in JP-B-45-37377 and JP-B-44-86516, specifically, 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biim idazole, 2,2'-bis(o,o'-dichlorophenyl)-4,4',5,5'-tetraphenylbiimidazol e, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluoromethylphenyl)-4,4',5,5'-tetraphenylbiimid azole.

The trihalomethyl compound preferably includes trihalomethyl-s-triazines, and specifically s-triazine derivatives having a trihalogen-substituted methyl group described in JP-A-58-29803, for example, 2,4,6-tris(trichloromethyl)-s-triazine, 2-methoxy-4,6-bis(trichloromethyl)-s-triazine, 2-amino-4,6-bis(trichloromethyl)-s-triazine and 2-(p-methoxystyryl)-4,6-bis(trichloromethyl)-s-triazine.

The onium salt compound includes, for example, onium salts represented by the following formula (III):

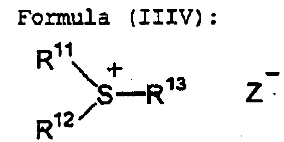

In formula (III), R¹¹, R¹² and R¹³, which may be the same or different, each represents a hydrocarbon group having 20 or less carbon atoms which may have a substituent. Preferable examples of the substituent include a halogen atom, a nitro group, an alkyl group having 12 or less carbon atoms, an alkoxy group having 12 or less carbon atoms and an aryloxy group having 12 or less carbon atoms. Z⁻ represents a counter ion selected from the group consisting of a halogen ion, a perchlorate ion, a tetrafluoroborate ion, a hexafluorophosphate ion, a carboxylate ion and a sulfonate ion, preferably a perchlorate ion, a hexafluorophosphate ion, a carboxylate ion or an arylsulfonate ion.

The metallocene compound can be used by appropriately selecting, for example, from known compounds as described in JP-A-59-152396 and JP-A-61-151197. Specific examples thereof include dicyclopentadienyl-Ti-dichloride, dicyclopentadienyl-Ti-bisphenyl, dicyclopentadienyl-Ti-bis-2,3,4,5,6-pentafluorophen-1-yl, dicyclopentadienyl-Ti-bis-2,3,5,6-tetrafluorophen-1-yl, dicyclopentadienyl-Ti-bis-2,4,6-trifluorophen-1-yl, dicyclopentadienyl-Ti-bis-2,6-difluorophen-7-yl, dicyclopentadienyl-Ti-bis-2,4-difluorophen-1-yl, dimethylcyclopentadienyl-Ti-bis-2,3,4,5,6-pentafluorophen-1-y l, dimethylcyclopentadienyl-Ti-bis-2,3,5,6-tetrafluorophen-1-yl, dimethylcyclopentadienyl-Ti-bis-2,4-difluorophen-1-yl and bis(cyclopentadienyl)-bis-(2,6-difluoro-3-(pyr-1-1yl)phenyl) titanium.

The carbonyl compound includes, for example, benzophenone derivatives, e.g., benzophenone, Michler's ketone, 2-methylbenzophenone, 3-methylbenzophenone, 4-methylbenzophenone, 2-chlorobenzophenone, 4-bromobenzophenone or 2-carboxybenzophenone, acetophenone derivatives, e.g., 2,2-dimethoxy-2-phenylacetophenone, 2,2-diethoxyacetophenone, 1-hydroxycyclohexylphenylketone, α-hydroxy-2-methylphenylpropane, 1-hydroxy-1-methylethyl-(p-isopropylphenyl)ketone, 1-hydroxy-1-(p-dodecylphenyl)ketone, 2-methyl-(4'-(methylthio)phenyl)-2-morpholino-1-propane or 1,1,1,--trichloromethyl-(p-butylphenyl)ketone, thioxantone derivatives, e.g., thioxantone, 2-ethylthioxantone, 2-isopropylthioxantone, 2-chlorothioxantone, 2,4-dimetylthioxantone, 2,4-dietylthioxantone or 2,4-diisopropylthioxantone, and benzoic acid ester derivatives, e.g., ethyl p-dimethylaminobenzoate or ethyl p-diethylaminobenzoate.

The oxime ester compound includes, for example, compounds described in J. C. S. Perkin II, 1653-1660 (1979), J. C. S. Perkin II, 156-162 (1979), Journal of Photopolymer Science and Technology, 202-232 (1995) and JP-A-2000-66385, and compounds described in JP-A-2000-80068.

The photo-initiators are preferably used individually or in combination of two or more thereof in the invention.

The amount of the photo-initiator used in the invention is preferably from 0.01 to 20% by weight, more preferably from 0.1 to 15% by weight, still more preferably from 1.0 to 10% by weight, based on the total solid content of the image-recording layer.

### <Other additive>

It is preferred to incorporate a mercapto compound having a mercapto group into the image-recording layer according to the invention. The mercapto compound functions as a chain transfer agent to have an effect on the increase in sensitivity.

According to the invention, it is preferred to use at least one compound selected from 2-mercaptobenzothiazoles, 2-mercaptobenzoxazoles, 2-mercaptobenzimidazoles and mercapto compounds represented by the following formula (X):

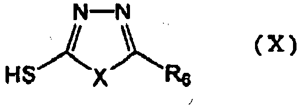

In formula (X), R₆ represents a hydrogen atom, a straight-chain or branched alkyl group having from 1 to 18 carbon atoms, an alkyl group containing an alicyclic structure having from 5 to 20 carbon atoms or a group containing an aromatic ring having from 6 to 20 carbon atoms, X represents an oxygen atom, a sulfur atom or -N(R₇)-, and R₇ represents a straight-chain or branched alkyl group having from 1 to 18 carbon atoms, an alkyl group containing an alicyclic structure having from 5 to 20 carbon atoms or a group containing an aromatic ring having from 6 to 20 carbon atoms.

As preferable examples of the compound represented by formula (X), the compounds shown below are exemplified.

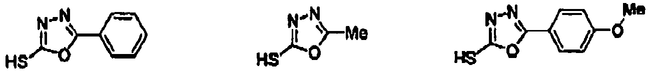

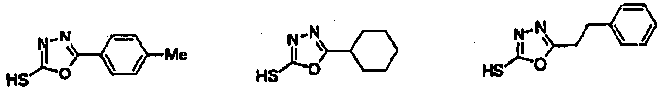

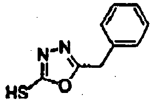

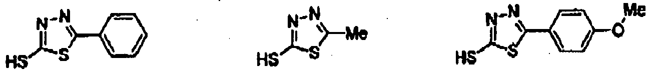

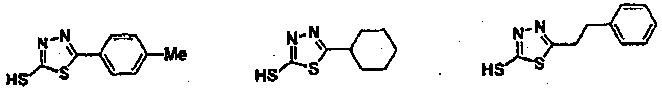

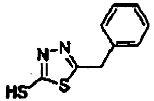

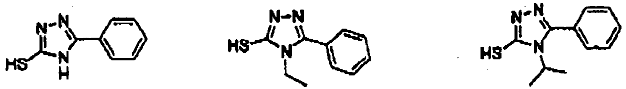

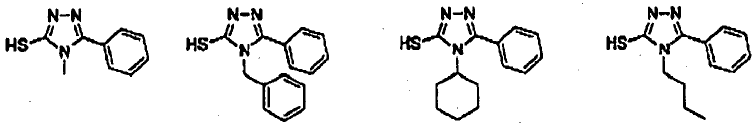

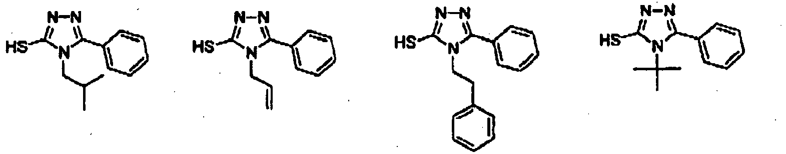

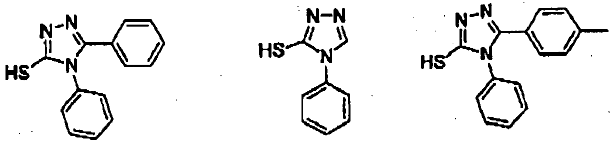

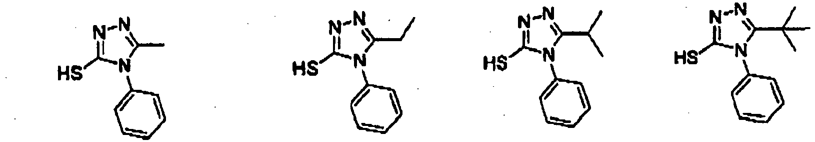

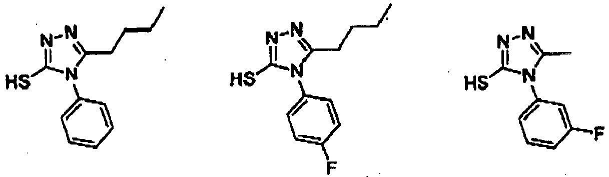

The mercapto compound represented by formula (X) can be synthesized according to known methods, for example, methods described in JP-A-5-124991. Also, commercially available compounds may be used.

The amount of the mercapto compound added is ordinarily from 0.5 to 20% by weight, preferably from 1 to 15% by weight, more preferably from 1 to 10% by weight, based on the total components constituting the image-recording layer.

It is desirable to add a small amount of a thermal polymerization inhibitor to the image-recording layer, in order to prevent undesirable thermal polymerization in the image-recording layer during the production or preservation of the lithographic printing plate precursor. Suitable examples of the thermal polymerization inhibitor include hydroquinone, p-methoxyphenol, di-tert-butyl-p-cresol, pyrogallol, tert-butylcatechol, benzoquinone, 4,4-thiobis(3-methyl-6-tert-butylphenol), 2,2'-methylenebis(4-methyl-6-tert-butylphenol), N-nitrosophenylhydroxyamine cerium(III) salt and N-nitrosophenylhydroxylamine aluminum salt.

The amount of the thermal polymerization inhibitor added is preferably from 0.01 to 5% by weight based on the total solid content of the image-recording layer.

In order to avoid polymerization inhibition due to oxygen, a higher fatty acid derivative, for example, behenic acid or behenic amide may be added to the image-recording layer according to the invention and allowed to localize on the image-recording layer surface during the drying step after the coating thereof, if desired. The amount of the higher fatty acid derivative added is preferably from 0.5 to 10% by weight based on the total solid content of the image-recording layer.

Further, for the purpose of coloring the image-recording layer, a coloring agent may be added thereto. Examples of the coloring agent include a pigment, for example, a phthalocyanine pigment (for example, C.I. Pigment Blue 15:3, C.I. Pigment Blue 15:4 or C.I. Pigment Blue 15:6), an azo pigment, carbon black or titanium oxide, Ethyl Violet, Crystal Violet, an azo dye, an anthraquinone dye and a cyanine dye. The amount of the coloring agent added is preferably from 0.5 to 20% by weight based on the total solid content of the image-recording layer. In addition, for the purpose of improving physical properties of the cured film, an additive, for example, an inorganic filler or a plasticizer (for example, dioctyl phthalate, dimethyl phthalate or tricresyl phosphate) may be added. The amount of the additive added is preferably 10% by weight or less based on the total solid content of the image-recording layer.

### <Formation of image-recording layer>

In the application of the image-recording layer, the components described above are dissolved in a solvent to prepare a coating solution. Examples of the solvent used include an organic solvent, for example, acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxypropanol, methoxymethoxyethanol, diethylene glycol monomethyl ether, diethylene glycol monoethyl ether, diethylene glycol dimethyl ether, diethylene glycol diethyl ether, propylene glycol monomethyl ether acetate, propyolene glycol monoethyl ether acetate, 3-methoxypropyl acetate, N,N-dimethylformamide, dimethylsulfoxide, γ-butyrolactone, methyl lactate or ethyl lactate. The solvents may be used individually or as a mixture thereof.

The concentration of solid content in the coating solution is ordinarily from 1 to 50% by weight.

Further, a surfactant may be added to the coating solution in order to improve surface quality of the coating.

The coverage of the image-recording layer is ordinarily from 0.1 to 10 g/m², preferably from 0.3 to 5 g/m², more preferably from 0.5 to 3 g/m², in terms of weight after drying.

### [Protective layer]

In the lithographic printing plate precursor according to the invention, a protective layer containing a water-soluble resin can be provided. The protective layer has a function as an oxygen-blocking layer preventing diffusion and penetration of oxygen which inhibits the polymerization reaction at the time of exposure. The protective layer for use in the invention preferably has oxygen permeability A at 25°C under one atmosphere of 1.0 ≤ A ≤ 20 (ml/m²·day). When the oxygen permeability A is extremely lower than 1.0 (ml/m²·day), problems may occur in that an undesirable polymerization reaction arises during the production or preservation before image exposure and in that undesirable fog or spread of image line occurs at the image exposure. On the contrary, when the oxygen permeability A greatly exceeds 20 (ml/m²·day), decrease in sensitivity may be incurred. The oxygen permeability A is more preferably in a range of 1.5 ≤ A ≤ 12 (ml/m²·day), still more preferably in a range of 2.0 ≤ A ≤ 8.0 (ml/m²·day). Besides the above described oxygen permeability, as for the characteristics required of the protective layer, it is desired that the protective layer does not substantially hinder the transmission of light for the exposure, is excellent in the adhesion property to the image-recording layer, and can be easily removed during a development step after the exposure. Contrivances on the protective layer have been heretofore made and described in detail in U.S. Patent 3,458,311 and JP-B-55-49729.

As the material of the protective layer, a water-soluble polymer compound relatively excellent in crystallizability is preferably used. Specifically, a water-soluble polymer, for example, polyvinyl alcohol, vinyl alcohol/vinyl phthalate copolymer, vinyl acetate/vinyl alcohol/vinyl phthalate copolymer, vinyl acetate/crotonic acid copolymer, polyvinyl pyrrolidone, acidic cellulose, gelatin, gum arabic, polyacrylic acid or polyacrylamide is enumerated. The water-soluble polymer compounds may be used individually or as a mixture. Of the compounds, when polyvinyl alcohol is used as a main component, the best results can be obtained in the fundamental characteristics, for example, oxygen-blocking property and removability of the protective layer by development.

Polyvinyl alcohol for use in the protective layer may be partially substituted with ester, ether or acetal as long as it contains unsubstituted vinyl alcohol units for achieving the necessary oxygen-blocking property and water solubility. Also, a part of polyvinyl alcohol may have other copolymer component.

As specific examples of the polyvinyl alcohol, those having a hydrolyzing rate of 71 to 100% and a polymerization repeating unit number of 300 to 2,400 are exemplified. Specific examples thereof include PVA-105, PVA-110, PVA-117, PVA-117H, PVA-120, PVA-124, PVA-124H, PVA-CS, PVA-CST, PVA-HC, PVA-203, PVA-204 PVA-205, PVA-210, PVA-217, PVA-220, PVA-224, PVA-217EE, PVA-217E, PVA-220E, PVA-224E, PVA-405, PVA-420, PVA-613 and L-8 (produced by Kuraray Co., Ltd.). They can be used individually or as a mixture. According to a preferred embodiment, the content of polyvinyl alcohol in the protective layer is from 20 to 95% by weight, more preferably from 30 to 90% by weight.

As a component used as a mixture with polyvinyl alcohol, polyvinyl pyrrolidone or a modified product thereof is preferable from the standpoint of the oxygen-blocking property and removability by development. The content thereof in the protective layer is ordinarily from 3.5 to 80% by weight, preferably from 10 to 60% by weight, more preferably from 15 to 30% by weight.

The components of the protective layer (selection of PVA and use of additives) and the coating amount are determined taking into consideration fogging property, adhesion property and scratch resistance besides the oxygen-blocking property and removability by development. In general, the higher the hydrolyzing rate of the PVA used (the higher the unsubstituted vinyl alcohol unit content in the protective layer) and the larger the layer thickness, the higher is the oxygen-blocking property, thus it is advantageous in the point of sensitivity. The molecular weight of the polymer compound, for example, polyvinyl alcohol (PVA) is ordinarily from 2,000 to 10,000,000, preferably from 20,000 to 3,000,000.

As other additive of the protective layer, glycerin, dipropylene glycol can be added in an amount corresponding to several % by weight of the polymer compound to provide flexibility. Further, an anionic surfactant, for example, sodium alkylsulfate or sodium alkylsulfonate; an amphoteric surfactant, for example, alkylaminocarboxylate and alkylaminodicarboxylate; or a nonionic surfactant, for example, polyoxyethylene alkyl phenyl ether can be added in an amount corresponding to several % by weight of the polymer compound. The thickness of the protective layer is suitably from 0.5 to 5 µm, preferably from 1 to 3 µm.

The adhesion property of the protective layer to the image-recording layer and scratch resistance are also extremely important in view of handling of the lithographic printing plate precursor. Specifically, when a hydrophilic layer comprising a water-soluble polymer is laminated on the oleophilic image-recording layer, layer peeling due to an insufficient adhesion property is liable to occur, and the peeled portion causes such a defect as failure in curing of the image-recording layer due to polymerization inhibition by oxygen. Various proposals have been made for improving the adhesion property between the image-recording layer and the protective layer. For example, it is described in JP-B-54-12215 and BP-A-1, 303, 578 that a sufficient adhesion property can be obtained by mixing from 20 to 60% by weight of an acryl-based emulsion or a water-insoluble vinyl pyrrolidone/vinyl acetate copolymer with a hydrophilic polymer mainly comprising polyvinyl alcohol and laminating the resulting mixture on the image-recording layer. Any of these known techniques can be applied to the protective layer according to the invention. Coating methods of the protective layer are described in detail, for example, in U.S. Patent 3,458,311 and JP-B-55-49729.

The coverage of the protective layer is ordinarily from 0.1 to 10 g/m², preferably from 0.5 to 5 g/m², in terms of weight after drying.

### (Support)

The support for use in the lithographic printing plate precursor according to the invention is not particularly restricted as long as it is a dimensionally stable plate-like support. The support includes, for example, paper, paper laminated with plastic (for example, polyethylene, polypropylene or polystyrene), a metal plate (for example, aluminum, zinc or copper plate), a plastic film (for example, cellulose diacetate, cellulose triacetate, cellulose propionate, cellulose butyrate, cellulose acetatebutyrate, cellulose nitrate, polyethylene terephthalate, polyethylene, polystyrene, polypropylene, polycarbonate or polyvinyl acetal film) and paper or a plastic film laminated or deposited with the metal described above. Preferable examples of the support include a polyester film and an aluminum plate. Among them, the aluminum plate is preferred since it has good dimensional stability and is relatively inexpensive.

The aluminum plate includes a pure aluminum plate, an alloy plate comprising aluminum as a main component and containing a trace amount of hetero elements and a thin film of aluminum or aluminum alloy laminated with plastic. The hetero element contained in the aluminum alloy includes, for example, silicon, iron, manganese, copper, magnesium, chromium, zinc, bismuth, nickel and titanium. The content of the hetero element in the aluminum alloy is preferably 10% by weight or less. Although a pure aluminum plate is preferred in the invention, since completely pure aluminum is difficult to be produced in view of the refining technique, the aluminum plate may slightly contain the hetero element. The composition is not specified for the aluminum plate and those materials known and used conventionally can be appropriately utilized.

The thickness of the support is preferably from 0.1 to 0.6 mm, more preferably from 0.15 to 0.4 mm, still more preferably from 0.2 to 0.3 mm.

Prior to the use of aluminum plate, a surface treatment, for example, roughening treatment or anodizing treatment is preferably performed. The surface treatment facilitates improvement in the hydrophilic property and ensures adhesion between the image-recording layer and the support. In advance of the roughening treatment of the aluminum plate, a degreasing treatment, for example, with a surfactant, an organic solvent or an aqueous alkaline solution is conducted for removing rolling oil on the surface thereof, if desired.

The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively).

As the method of the mechanical roughening treatment, a known method, for example, a ball grinding method, a brush grinding method, a blast grinding method or a buff grinding method can be used.

The electrochemical roughening treatment method includes, for example, a method of conducting it by passing alternating current or direct current in an electrolyte containing an acid, for example, hydrochloric acid or nitric acid. Also, a method of using a mixed acid described in JP-A-54-63902 can be used.

The aluminum plate after the roughening treatment is then subjected, if desired, to an alkali etching treatment using an aqueous solution, for example, of potassium hydroxide or sodium hydroxide and further subjected to a neutralizing treatment, and then subjected to an anodizing treatment in order to enhance the abrasion resistance, if desired.

As the electrolyte used for the anodizing treatment of the aluminum plate, various electrolytes capable of forming porous oxide film can be used. Ordinarily, sulfuric acid, hydrochloric acid, oxalic acid, chromic acid or a mixed acid thereof is used. The concentration of the electrolyte can be appropriately determined depending on the kind of the electrolyte.

Since the conditions of the anodizing treatment are varied depending on the electrolyte used, they cannot be defined generally. However, it is ordinarily preferred that electrolyte concentration in the solution is from 1 to 80% by weight, liquid temperature is from 5 to 70°C, current density is from 5 to 60 A/dm², voltage is from 1 to 100 V, and electrolysis time is from 10 seconds to 5 minutes. The amount of the anodized film formed is preferably from 1.0 to 5.0 g/m², more preferably from 1.5 to 4.0 g/m². In the range described above, good printing durability and favorable scratch resistance in the non-image area of lithographic printing plate can be achieved.

After the anodizing treatment, the surface of the aluminum plate is subjected to a hydrophilizing treatment, if desired. The hydrophilizing treatment includes an alkali metal silicate method described in U.S. Patents 2,714,066, 3,181,461, 3,280,734 and 3, 902, 734. In the method, the support is subjected to an immersion treatment or an electrolytic treatment in an aqueous solution, for example, of sodium silicate. In addition, the hydrophilizing treatment includes, for example, a method of treating with potassium fluorozirconate described in JP-B-36-22063 and a method of treating with polyvinylphosphonic acid described in U.S. Patents 3,276,868, 4,153,461 and 4,689,272.

The support preferably has a center line average roughness of 0.10 to 1.2 µm. In the range described above, good adhesion property to the image-recording layer, good printing durability, and good resistance to stain can be achieved.

The color density of the support is preferably from 0.15 to 0.65 in terms of the reflection density value. In the range described above, good image-forming property by preventing halation at the image exposure and good aptitude for plate inspection after development can be achieved.

### [Intermediate layer]

In the lithographic printing plate precursor according to the invention, it is preferred to provide an intermediate layer between the support and the image-recording layer in order to increase the adhesion property between these layers. The intermediate layer according to the invention includes an embodiment containing (i) a metal oxide obtained by hydrolysis and polycondensation of an organic metal compound or inorganic metal compound and a preferable embodiment further containing (ii) a colloidal silica sol and (iii) an organic polymer compound in addition to the metal oxide. The intermediate layer may further contain a plasticizer.

The metal oxide for use in the intermediate layer includes silica (silicon oxide), titanium oxide, boron oxide, aluminum oxide, zirconium oxide and a composite thereof. The metal oxide in the intermediate layer for use in the invention is obtained by coating on the surface of a support a so-called sol-gel reaction solution prepared by conducting hydrolysis and polycondensation reaction of an organic metal compound or inorganic metal compound in water and an organic solvent in the presence of a catalyst, for example, an acid or alkali, followed by drying. The organic metal compound or inorganic metal compound used includes, for example, a metal alkoxide, a metal acetylacetonate, a metal acetate, a metal oxalate, a metal nitrate, a metal sulfate, a metal carbonate, a metal oxychloride, a metal chloride and condensates obtained by partial hydrolysis and oligomeration thereof.

The metal alkoxide is represented by the following formula:

M (OR) n

wherein M represents a metal element, R represents an alkyl group, and n represents an oxidation number of the metal element.

Examples of the metal alkoxide include Si (OCH₃) 4, Si(OC₂H₅)₄, Si(OC₃H₇)₄, Si(OC₄H₉)₄, Al(OCH₃)₃, Al(OC₂H₅)₃, Al(OC₃H₇)₃, Al(OC₄H₉)₃, B(OCH₃)₃, B(OC₂H₅)₃, B(OC₃H₇)₃, B(OC₄H₉)₃, Ti(OCH₃)₄, Ti(OC₂H₅)₄, Ti(OC₃H₇)₄, Ti(OC₄H₉)₄, Zr(OCH₃)₄, Zr(OC₂H₅)₄, Zr(OC₃H₇)₄ and Zr(OC₄H₉)₄. Also, an alkoxide of Ge, Li, Na, Fe, Ga, Mg, P, Sb, Sn, Ta, V is exemplified. Further, a mono-substituted silicon alkoxide, for example, CH₃Si (OCH₃)₃, C₂H₅Si(OCH₃)₃, CH₃Si(OC₂H₅)₃ or C₂H₅Si(OC₂H₅)₃ is also used. Examples of the metal acetylacetonate include Al(COCH₂COCH₃)₃ and Ti(COCH₂COCH₃)₄. Examples of the metal oxalate include K₂TiO(C₂O₄)₂. Examples of the metal nitrate include Al(NO₃)₃ and ZrO(NO₃)₂·2H₂O. Examples of the metal sulfate include Al₂(SO₄₃, (NH₄)Al(SO₄)₂, KAl(SO₄)₂ and NaAl (SO₄)₂. Examples of the metal oxychloride include Si₂OCl₆ and ZrOCl₂. Examples of the metal chloride include AlCl₃, SiCl₄, ZrCl₂ and TiCl₄.

The organic metal compounds or inorganic metal compounds may be used individually or in combination of two or more thereof.

According to the invention, it is preferred that the intermediate layer contains an organic silicone compound having a functional group capable of causing an addition polymerization upon a radical. By the introduction of the organic silicone compound, a balance of the adhesion property between the intermediate layer and image-recording layer with the occurrence of scum in the development processing is more improved.

When the functional group capable of causing an addition polymerization upon a radical is represented by R₁, the organic silicone compound includes an organic silicone compound represented by the following formula (XI):

R₁Si(OR₂)₃ (XI)

In formula (XI), -OR₂ represents an alkoxy group capable of being hydrolyzed or a -OCOCH₃ group.

R₁ in formula (XI) is not particularly restricted and includes, for example, CH₂=CHCOO-(CH₂)₃-, CH₂=C(CH₃)COO-(CH₂)₃-, CH₂=CH-C(=CH₂)-, CH₂=CH-SO₂NH-(CH₂)₃-, 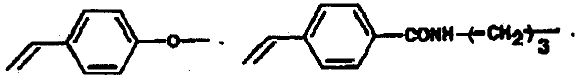 CH₂=CH-, HC≡C-, CH₃C≡C-, 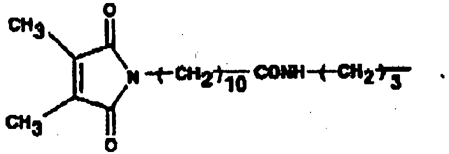 CH₂=CHCH₂O-, CH₂=CHCOO-(CH₂)₄-, CH₂=C(CH₃)COO-(CH₂)₄-, CH₂=C(CH₃)COO-(CH₂)₅-, CH₂=CHCH₂-, HO-CH₂-C≡C-, CH₃CH₂CO-C≡C-, CH₂=CHS-(CCH₂)₃-; CH₂-CHCH₂O-(CH₂)₂-SCH₂-, CH₂=CHCH₂S-(CH₂)₃-S-, (CH₃)₃-CCO-C≡C-, CH₂=CHCH₂NH-(CH₂)₃-, (CH₂=CH)₂-N-(CH₂)₂-SCH₂-,

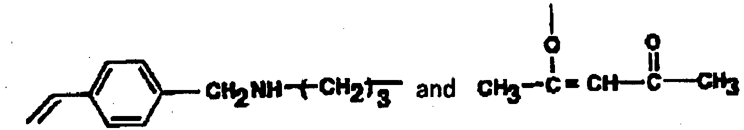

Specific examples of the organic silicone compound represented by formula (XI) for use in the invention are set forth below.

CH₂=CH-Si(OCOCH₃)₃, CH₂=CH-Si(OC₂H₅)₃, CH₂=CHSi(OCH₃)₃, CH₂=CHCH₂Si(OC₂H₅)₃, CH₂=CHCH₂NH(CH₂)₃Si(OCH₃)₃, CH₂=CHCOO-(CH₂)₃-Si(OCH₃)₃, CH₂=CHCOO-(CH₂)₃-Si(OC₂H₅)₃, CH₂=C(CH₃)COO-(CH₂)₃-Si((CH₃)₃, CH₂=C(CH₃)COO-(CH₂)₃-Si(OC₂H₅)₃, CH₂=C(CH₃) COO-(CH₂)₄-Si(OCH₃)₃, CH₂=C(CH₃)COO-(CH₂)₅-Si(OCH₃)₃, CH₂=CHCOO-(CH₂)₄-Si(OCH₃)₃, 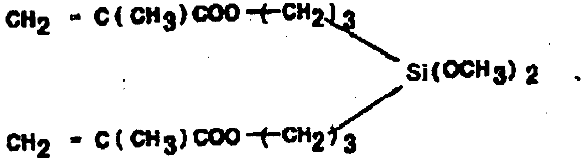 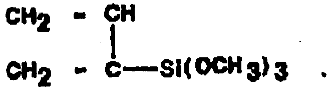 CH₂=CH-SO₂NH-(CH₂)₃-Si(OCH₃)₃, 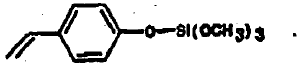 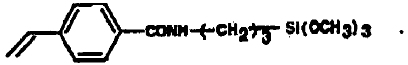 HC≡C-Si(OC₂H₅)₃, CH₃C≡Si(OC₂H₅)₃, 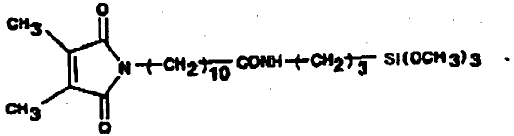 CH₂=CHCH₂O-Si(OCH₃)₃, (CH₂=CHCH₂O)₄Si, HO-CH₂-C≡C-Si(OC₂H₅)₃, CH₃CH₂CO-C≡C-Si(OC₂H₅)₃, CH₂=CHS-(CH₂)₃-Si(OCH₃)₃, CH₂=CHCH₂O-(CH₂)₂-SCH₂-Si(OCH₃)₃, CH₂-CHCH₂S-(CH₂)₃-S-Si(OCH₃)₃, (CH₃)₃CCO-C≡C-Si(OC₂H₅)₃, (CH₂=CH)₂-N-(CH₂)₂-SCH₂-Si(OCH₃)₃, 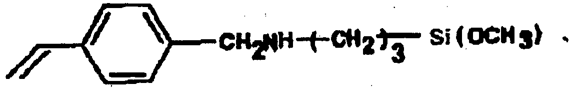 and CH₃COCH=C(CH₃)-O-Si(OCH₃)₃.

In the case of using the metal alkoxide, as for a ratio to the organic silicone compound, a molar ratio of the metal alkoxide to the organic silicone compound is suitably from 0.05 to 200, preferably from 0.2 to 100, more preferably from 1 to 40. In the ratio described above, the effect for reducing the generation of scum at the development processing is more increased. Further, the adhesion property to the image-recording layer is increased and printing durability and reproducibility of halftone dot are improved. As a means for achieving the ratio, for example, control of the sol-gel reaction (remaining organic property), adjustment of a mixing ration of the metal alkoxide and the organic silicone compound and adjustment due to an additive (for example, an organic polymer or a plasticizer) are exemplified.

On the other hand, as the catalyst, an organic or inorganic acid or alkali is used. Examples of the catalyst include an inorganic acid, for example, hydrochloric acid, sulfuric acid, sulfurous acid, nitric acid, nitrous acid, hydrofluoric acid, phosphoric acid or phosphorous acid, an organic acid, for example, formic acid, acetic acid, propionic acid, butyric acid, glycolic acid, chloroacetic acid, dichloroacetic acid, trichloroacetic acid, fluoroacetic acid, bromoacetic acid, methoxyacetic acid, oxaloacetic acid, citric acid, oxalic acid, succinic acid, malic acid, tartaric acid, fumaric acid, maleic acid, malonic acid, ascorbic acid, benzoic acid, a substituted benzoic acid, e.g., 3,4-dimethoxybenzoic acid, phenoxyacetic acid, phthalic acid, picric acid, nicotinic acid, picolinic acid, pyrazine, pyrazole, dipicolinic acid, azipic acid, p-toluilic acid, terephthalic acid, 1, 4-cyclohexene-2,2-dicarboxylic acid, erucic acid, lauric acid, n-undecanoic acid or ascorbic acid, and an alkali, for example, a hydroxide of alkali metal or alkaline earth metal, ammonia, ethanolamine, diethanolamine or triethanolamine. In addition, an organic acid, for example, a sulfonic acid, a sulfinic acid, an alkylsulfuric acid, a phosphonic acid, a phosphoric ester specifically, p-toluenesulfonic acid, dodecylbenzenesulfonic acid, p-toluenesulfinic acid, ethylic acid, phenylphophonic acid, phenylphophinic acid, phenyl phosphate or diphenyl phosphate can be used. The catalysts may be used individually or in combination of two or more thereof. The amount of the catalyst is preferably in a range of 0.001 to 10% by weight, more preferably in a range of 0.05 to 5% by weight, based on the metal compound as the raw material. When the amount of the catalyst is less than the above-described range, the initiation of the sol-gel reaction is delayed, whereas when it is more than the above-described range, the reaction rapidly proceeds to cause gelation soon in many cases, resulting in fear in that the coating operation can not be stably performed.

In order to initiate the sol-gel reaction, an appropriate amount of water is further necessary. The amount of water added is preferably from 0.05 to 50 molar times, more preferably from 0.5 to 30 molar times, based on the amount of water necessary for complete hydrolysis of the metal compound as the raw material. When the amount of water is less than the above-described range, the hydrolysis is difficult to proceed, whereas it is more than the above-described range, the hydrolysis is also difficult to proceed probably because of dilution of the raw material. To the sol-gel reaction solution is further added a solvent. As the solvent, any solvent which dissolves the metal compound as the raw material and dissolves or disperses sol-gel particles formed by the reaction can be used. For instance, a lower alcohol, for example, methanol, ethanol, propanol or butanol or a ketone, for example, acetone, methyl ethyl ketone or diethyl ketone is used. Further, for the purpose of improving the surface quality of the intermediate layer coated or the like, a monoalkyl or dialkyl ether or acetic ester of a glycol, for example, ethylene glycol, diethylene glycol, triethylene glycol, propylene glycol or dipropylene glycol may be used. Of the solvents, a lower alcohol which is miscible with water is preferable. Although the sol-gel reaction solution is prepared in concentration suitable for coating with the solvent, when the total amount of the solvent is added to the reaction solution from the beginning, the hydrolysis reaction is difficult to proceed probably because of dilution of the raw material.

Therefore, a method wherein a part of the solvent is added to the sol-gel reaction solution and the remainder of the solvent is added after the reaction proceeds is preferable.

The sol-gel reaction proceeds by mixing the raw material for the metal oxide, water, solvent and catalyst. The procedure of the reaction depends on the kinds and relative proportions of these components and the temperature and time of the reaction, and it effects on the film property of the layer formed. Since the effect of the reaction temperature is particularly large, it is preferred to control the temperature during the reaction. To the sol-gel reaction solution may be added a compound having a hydroxy group, an amino group or an active hydrogen in its molecule in addition to the above-described essential components in order to appropriately control the sol-gel reaction. Examples of the compound include polyethylene glycol, polypropylene glycol, a block copolymer thereof or a monoalkyl ether or monoalkylaryl ether thereof, various kinds of phenols, for example, phenol or cresol, polyvinyl alcohol or a copolymer thereof with other vinyl monomer, an acid having a hydroxy group, for example, malic acid or tartaric acid, an aliphatic or aromatic amine, formaldehyde and dimethylformaldehyde. Further, in order to increase compatibility of dried material of the coating solution with the organic solvent to solubilize, an organic polymer compound may be added.

The organic polymer compound (iii) includes, for example, polyvinyl chloride, polyvinyl alcohol, polyvinyl acetate, polyvinyl phenol, polyvinyl halogenated phenol, polyvinyl formal, polyvinyl acetal, polyvinyl butyral, polyamide, polyurethane, polyurea, polyimide, polycarbonate, an epoxy resin, phenol novolac, a condensation resin of resol phenol with aldehyde or ketone, polyvinylidene chloride, polystyrene, a silicone resin, an acrylic copolymer having an alkali-soluble group, for example, a phenolic hydroxy group, a sulfonamido group or a carboxyl group and a copolymer, terpolymer or higher order copolymer thereof. Particularly preferable compounds include a phenol novolac resin or resol resin, specifically, a novolac resin or resol resin of a phenol compound, for example, phenol, cresol (m-cresol, p-cresol, m/p mixed cresol), phenol/cresol (m-cresol, p-cresol, m/p mixed cresol), phenol-modified xylene, tert-butylphenol, octylphenol, resorcinol, pyrogallol, catechol, chlorophenol (m-Cl or p-Cl), bromophenol (m-Br or p-Br), salicylic acid or phloroglucinol with formaldehyde, and a condensation resin of the above phenol compound with acetone.

Other preferable examples of the polymer compound include copolymers ordinarily having a molecular weight of 10,000 to 200,000 and including as the constituting unit a monomer represented by any one of (1) to (12) shown below.
(1) acrylamides, methacrylamides, acrylates and methacrylates each having an aromatic hydroxy group and hydroxy styrenes, for example, N-(4-hydroxyphenyl)acrylamide, N-(4-hydroxyphenyl)methacrylamide, o-, m- or p-hydroxystyrene, or o-, m- or p-hydroxyphenylacrylate or methacrylate, (2) acrylates and methacrylates each having an aliphatic hydroxy group, for example, 2-hydroxyethyl acrylate or 2-hydroxyethyl methacrylate, (3) (substituted) acrylates, for example, methyl acrylate, ethyl acrylate, propyl acrylate, butyl acrylate, amyl acrylate, hexyl acrylate, cyclohexyl acrylate, octyl acrylate, phenyl acrylate, benzyl acrylate, 2-chloroethyl acrylate, 4-hydroxybutyl acrylate, glycidyl acrylate or N-dimethylaminoethyl acrylate, (3) (substituted) methacrylates, for example, methyl methacrylate, ethyl methacrylate, propyl methacrylate, butyl methacrylate, amyl methacrylate, hexyl methacrylate, cyclohexyl methacrylate, octyl methacrylate, phenyl methacrylate, benzyl methacrylate, 2-chloroethyl methacrylate, 4-hydroxybutyl methacrylate, glycidyl methacrylate or N-dimethylaminoethyl methacrylate, (5) acrylamides and methacrylamides, for example, acrylamide, methacrylamide, N-methylolacrylamide, N-methylolmethacrylamide, N-ethylacrylamide, N-ethylmethacrylamide, N-hexylacrylamide, N-hexylmethacrylamide, N-cyclohexylacrylamide, N-cyclohexylmethacrylamide, N-hydroxyethylacrylamide, N-hydroxyethylmethacrylamide, N-phenylacrylamide, N-phenylmethacrylamide, N-benzylacrylamide, N-benzylmethacrylamide, N-nitrophenylacrylamide, N-nitrophenylmethacrylamide, N-ethyl-N-phenylacrylamide or N-ethyl-N-phenylmethacrylamide, (6) vinyl ethers, for example, ethyl vinyl ether, 2-chloroethyl vinyl ether, hydroxyethyl vinyl ether, propyl vinyl ether, butyl vinyl ether, octyl vinyl ether or phenyl vinyl ether, (7) vinyl esters, for example, vinyl acetate, vinyl chloroacetate, vinyl buryrate or vinyl benzoate, (8) styrenes, for example, styrene, methylstyrene or chloromethylstyrene, (9) vinyl ketones, for example, methyl vinyl ketone, ethyl vinyl ketone, propyl vinyl ketone or phenyl vinyl ketone, (10) olefins, for example, ethylene, propylene, isobutylene, butadiene or isoprene, (11) N-vinylpyrrolidone, N-vinylcarbazole, 4-vinylpyridine, acrylonitrile or methacrylonitrile, (12) acrylamides, for example, N-(o-aminosulfonylphenyl)acrylamide, N-(m-aminosulfonylphenyl)acrylamide, N-(p-aminosulfonylphenyl)acrylamide, N-[1-(3-aminosulfonyl)naphthyl]acrylamide or N-(2-aminosulfonylethyl)acrylamide, methacrylamides, for example, N-(o-aminosulfonylphenyl)methacrylamide, N-(m-aminosulfonylphenyl)methacrylamide, N-(p-aminosulfonylphenyl)methacrylamide, N-[1-(3-aminosulfonyl)naphthyl]methacrylamide or N-(2-aminosulfonylethyl)methacrylamide, unsaturated sulfonamides of acrylates, for example, o-aminosulfonylphenyl acrylate, m-aminosulfonylphenyl acrylate, p-aminosulfonylphenyl acrylate or 1-(3-aminosulfonylphenylnaphthyl) acrylate, and unsaturated sulfonamides of methacrylates, for example, o-aminosulfonylphenyl methacrylate, m-aminosulfonylphenyl methacrylate, p-aminosulfonylphenyl methacrylate or 1-(3-aminosulfonylphenylnaphthyl) methacrylate.

The polymer compound preferably has a weight average molecular weight of 500 to 20, 000 and a number average molecular weight of 200 to 60,000. The amount of the polymer compound added is suitably from 1 to 200% by weight, preferably from 2 to 100% by weight, particularly preferably from 5 to 50% by weight, based on the metal compound as the raw material. When the amount added is larger than the above range, the intrinsic hydrophilicity of the sol-gel degrades and the stain resistance in the printing decreases.

Further, in order to prevent dust-adhering failure due to peeling of scale-like dried material of the coating solution during the coating in the production and to obtain stable surface quality of the coating, it is preferred to add a plasticizer together with the organic polymer compound. Effective examples of the plasticizer for use in the intermediate layer according to the invention include dimethyl phthalate, diethyl phthalate, dibutyl phthalate, diheptyl phthalate, dioctyl phthalate, butyl benzyl phthalate, diisodecyl phthalate, ethyl phthalylethyl glycolate, methyl phthalylethyl glycolate, butyl phthalylbutyl glycolate, diisobutyl phthalate, octyl capryl phthalate, dicyclohexyl phthalate, ditridecyl phthalate, diallyl phthalate, dimethylglycol phthalate, ethyl phthalylethyl glycolate, methyl phthalylethyl glycolate, butyl phthalylbutyl glycolate, triethylene glycol caprylic acid diester, trioctyl trimellitate, dioctyl adipate, dioctyl azelate, dibutyl sebacate, dioctyl sebacate, methyl acetyl cinolate, dimethyl maleate, diethyl maleate, dibutyl maleate, dioctyl maleate, dibutyl fumalate, dioctyl fumalate, adipic acid-propylene glycol ester, adipic acid-1,3-butylene glycol ester, glycerol triacetate, glycerol tributyrate, cellulose acetate phthalate, trimethyl phosphate, triethyl phosphate, tributyl phosphate, trioctyl phosphate, tributoxyethyl phosphate, trischloroethyl phosphate, trisdichloropropyl phosphate, mono-2,3-dichloropropyl-bis-2,3-dibromopropyl phosphate, triphenyl phosphate, tricresyl phosphate, trixylenyl phosphate, cresyl diphenyl phosphate. diphenyl monoorthoxenyl phosphate, octyl diphenyl phosphate, triphenyl phosphite, trilauryl trithiophosphite, trischloroethyl phosphite, trilauryl phosphite, trisnonylphenyl phosphite, trisdinonylphenyl phosphite, dibutyl hydrogen phosphite, isopropyl acid phosphate, butyl acid phosphate, dibutyl phosphate, octyl acid phosphate, dioctyl phosphate, isodecyl acid phosphate, monoisodecyl phosphate and tridecanol acid phosphate. Among them, those having a boiling point of 250°C or more at 760 mm Hg are particularly effective. Further, in order to avoid the degradation of stain resistance due to adhesion of an oleophilic substance at the time of plate-making, those as hydrophilic as possible are preferable. The plasticizer is added to the extent of preventing the intermediate layer from tackiness. The amount of the plasticizer added is suitably from 1 to 100% by weight, particularly preferably from 5 to 30% by weight, based on the metal compound as the raw material. When the amount added exceeds 100% by weight, the hydrophilicity of the non-image area after development degrades and the stain resistance in the printing decreases.

To the intermediate layer may be added (ii) a colloidal silica sol for the purpose of preventing the degradation of hydrophilicity. As the colloidal silica sol, a colloidal solution of ultrafine particles of silic acid using as a dispersion medium, for example, water, methanol, ethanol, isopropyl alcohol, butanol, xylene or dimethylformamide is exemplified. Methanol is particularly preferable as the dispersion medium. The particle size of the dispersoid is preferably from 1 to 100 µm, particularly preferably from 10 to 50 µm. When the particle size exceeds 100 µm, the uniformity of the layer coated degrades because of roughness of the surface.

The content of the silic acid is preferably from 5 to 80% by weight. The silic acid having hydrogen ion concentration outside a neutral region (pH of 6 to 8) is preferable in view of the stability. Particularly, the silic acid having the hydrogen ion concentration in an acidic region is preferable.

The silica sol is possible to use together with other fine particles, for example, alumina sol or lithium silicate. By using such other fine particles, the curing property of the sol-gel coating is further improved. The amount of the colloidal silica sol added is preferably from 30 to 300% by weight, more preferably from 30 to 200% by weight, most preferably from 50 to 100% by weight, based on the metal compound as the raw material. When the amount added is more than the above range, the film-forming property degrades and it is difficult to coat uniformly. When the amount added is less than the above range, the effect of preventing the degradation of hydrophilicity is not achieved.

Further, to the intermediate layer may be added a surfactant for the purpose of improving surface state of the coating.

Moreover, to the intermediate layer may be added as a lubricant, for example, a higher fatty acid or higher fatty acid amide, for example, behenic acid, behenic acid amide, stearic acid, stearic acid amide or alkenylsuccinic acid anhydride, wax, dimethylsiloxane or polyethylene powder.

The coating amount of the intermediate layer is preferably in a range of 2 to 1,000 mg/m², more preferably in a range of 5 to 200 mg/m², most preferably in a range of 10 to 50 mg/m². In order to coat the intermediate layer on the support, various methods can be utilized and a method of making a coating solution, coating the solution and drying is most preferable in view of ensuring the above-described coating amount.

### [Backcoat layer]

After applying the surface treatment to the support or forming the intermediate layer on the support, a backcoat layer can be provided on the back surface of the support, if desired.

The backcoat layer preferably includes, for example, a coating layer comprising an organic polymer compound described in JP-A-5-45885 and a coating layer comprising a metal oxide obtained by hydrolysis and polycondensation of an organic metal compound or an inorganic metal compound described in JP-A-6-35174. Among them, use of an alkoxy compound of silicon, for example, Si(OCH₃)₄, Si(OC₂H₅)₄, Si(OC₃H₇)₄ or Si (OC₄H₉)₄ is preferred since the starting material is inexpensive and easily available.

### [Plate-making method]

A plate-making method of the lithographic printing plate precursor according to the invention is described in detail below. The lithographic printing plate precursor is exposed imagewise and then developed with an aqueous alkali solution. A developer for use in the plate-making method according to the invention is described below.

### <Developer>

The developer for use in the plate-making method of the lithographic printing plate precursor according to the invention is not particularly limited and, for example, a solution containing an inorganic alkali salt and a surfactant and having ordinarily pH of 11.0 to 12.7, preferably pH of 11.5 to 12.5, is used.

The inorganic alkali salt is appropriately used. Examples thereof include an inorganic alkali agent, for example, sodium hydroxide, potassium hydroxide, ammonium hydroxide, lithium hydroxide, sodium silicate, potassium silicate, ammonium silicate, lithium silicate, sodium tertiary phosphate, potassium tertiary phosphate, ammonium tertiary phosphate, sodium carbonate, potassium carbonate, ammonium carbonate, sodium hydrogencarbonate, potassium hydrogencarbonate, ammonium hydrogencarbonate, sodium borate, potassium borate and ammonium borate. The inorganic alkali salts may be used independently or in combination of two or more thereof.

In the case of using a silicate, developing property can be easily adjusted by selecting a mixing ratio of silicon oxide (SiO₂) to alkali oxide (M₂O (wherein M represents an alkali metal or an ammonium group)), which are components of the silicate, and the concentration thereof. Of the alkali aqueous solutions, an alkali aqueous solution having the mixing ratio of silicon oxide (SiO₂) to alkali oxide (M₂O) (SiO₂/M₂O in molar ratio) of 0. 5 to 3.0 is preferred, and that of 1.0 to 2.0 is more preferred. The total amount of SiO₂/M₂O in the alkali aqueous solution is preferably from 1 to 10% by weight, more preferably from 3 to 8% by weight, most preferably from 4 to 7% by weight, based on the weight of the alkali aqueous solution. In the range of concentration described above, the developing property and processing ability do not decrease, the formation of precipitates and crystals is prevented and gelation at neutralization of waste liquor of the developer does not occur, thereby causing no troubles in treatment of the waste liquor.

Also, an organic alkali agent may be supplementarily used for the purpose of delicate adjustment of alkali concentration and assisting dissolution of the image-recording layer. The organic alkali agent includes monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine and tetramethylammonium hydroxide. The organic alkali agents may be used independently or in combination of two or more thereof.

The surfactant can be appropriately used. Examples thereof include a nonionic surfactant, for example, a nonionic surfactant having polyoxyalkylene ether group, a polyoxyethylene alkyl ester (e.g., polyoxyethylene stearate), a sorbitan alkyl ester (e.g., sorbitan monolaurate, sorbitan monostearate, sorbitan distearate, sorbitan monooleate, sorbitan sesquioleate or sorbitan trioleate) and a monoglyceride alkyl ester (e.g., glycerol monostearate or glyceron monooleate); an anionic surfactant, for example, an alkylbenzenesulfonate (e.g., sodium dodecylbenzenesulfonate), an alkylnaphthalenesulfonate (e.g., sodium butylnaphthalenesulfonate, sodium pentylnaphthalenesulfonate, sodium hexylnaphthalenesulfonate or sodium octylnaphthalenesulfonate), an alkylsulfate (e.g., sodium laurylsulfate), an alkylsulfonate (e.g., sodium dodecylsulfonate) and a sulfosuccinic acid ester salt (e.g., sodium dilaurylsulfosuccinate); and an amphoteric surfactant, for example, an alkylbetaine (e.g., laurylbetaine or stearylbetaine) and an amino acid. A nonionic surfactants having a polyoxyalkylene ether group is particularly preferred.

As the surfactant having a polyoxyalkylene ether group, a compound having the structure represented by formula (XII) shown below is preferably used.

R₄₀-O-(R₄₁-O)ₚH (XII)

In formula (XII), R₄₀ represents an alkyl group having from 3 to 15 carbon atoms, an aromatic hydrocarbon group having from 6 to 15 carbon atoms or a heteroaromatic cyclic group having from 4 to 15 carbon atoms, each of which may have a substituent. Examples of the substituent include an alkylene group having from 1 to 20 carbon atoms, a halogen atom, e.g., Br, Cl or I, an aromatic hydrocarbon group having from 6 to 15 carbon atoms, an aralkyl group containing 7 to 17 carbon atoms, an alkoxy group having from 1 to 20 carbon atoms, an alkoxycarbonyl group having from 2 to 20 carbon atoms and an acyl group having from 2 to 15 carbon atoms. R₄₁ represents an alkylene group having from 1 to 100 carbon atoms, which may have a substituent. Examples of the substituent include an alkyl group having from 1 to 20 carbon atoms and an aromatic hydrocarbon group having from 6 to 15 carbon atoms. p represents an integer of 1 to 100.

In the definition of the formula (XII), specific examples of "aromatic hydrocarbon group" include a phenyl group, a tolyl group, a naphthyl group, an anthryl group, a biphenyl group and a phenanthryl group, and specific examples of "heteroaromatic cyclic group" include a furyl group, a thionyl group, an oxazolyl group, an imidazolyl group, a pyranyl group, a pyridinyl group, an acridinyl group, a benzofuranyl group, a benzothionyl group, a benzopyranyl group, a benzoxazolyl group and a benzimidazolyl group.

Also, the moiety of (R₄₁-O)ₚ in the formula (XII) may be two or three kinds of groups within the above-described scope. Specifically, there may be illustrated a random or block chain of a combination of ethyleneoxy group and propyleneoxy group, a combination of ethyleneoxy group and isopropyleneoxy group, a combination of ethyleneoxy group and butyleneoxy group, and a combination of ethyleneoxy group and isobutyleneoxy group. In the invention, the surfactants having polyoxyalkylene ether group are used independently or in combination. The surfactant is effectively added in an amount from 1 to 30% by weight, preferably from 2 to 20% by weight, in the developer. When the amount of the surfactant is too small, deterioration of developing property may occur and whereas, it is too large, damage of the development increase and printing durability of a printing plate may degrade.

Examples of the nonionic surfactant having polyoxyalkylene ether group represented by formula (XII) include a polyoxyethylene alkyl ether, e.g., polyoxyethylene lauryl ether, polyoxyethylene cetyl ether and polyoxyethylene stearyl ether; a polyoxyethylene aryl ether, e.g., polyoxyethylene phenyl ether and polyoxyethylene naphthyl ether; and a polyoxyethylene alkylaryl ether, e.g., polyoxyethylene methylphenyl ether, polyoxyethylene octylphenyl ether and polyoxyethylene nonylphenyl ether.

The surfactants can be used independently or in combination thereof.

Further, the electric conductivity of the developer used in the invention is preferably from 3 to 30 mS/cm. When the electric conductivity of the developer is lower than 3 mS/cm, the dissolution of the component of the image-recording layer on the surface of support may become difficult to cause the occurrence of stain at printing and whereas, when it exceeds 30 mS/cm, since the salt concentration is high, the dissolution rate of the image-recording layer becomes extremely slow and the residual layer in the unexposed area may occur. The electric conductivity is particularly preferably in a range of 5 to 20 mS/cm. <Exposure and Development processing>

The lithographic printing plate precursor according to the invention is exposed imagewise with an active ray conventionally known, for example, a carbon arc lamp, a high-pressure mercury lamp, a xenon lamp, a metal halide lamp, a fluorescent lamp, a tungsten lamp, a halogen lamp, a helium cadmium laser, an argon ion laser, an FD-YAG laser, a helium neon laser, a semiconductor laser (wavelength of 250 to 600 nm) and subjected to development processing with a developer to form an image on the surface of aluminum support. As the exposure light source, a laser of 250 to 600 nm is preferable.

Between the image exposure and development, the lithographic printing plate precursor may be subjected to a heat process at temperature of 50 to 140°C for a period of time of one second to 5 minutes for the purpose of increasing the curing rate of the image-recording layer. In the range of heating temperature described above, the effect of increasing the curing rate is achieved without the occurrence of residual layer in the unexposed area due to dark polymerization.

In the case where the protective layer is provided on the image-recording layer of the lithographic printing plate precursor according to the invention, for example, a method of removing both the protective layer and the unexposed area of the image-recording layer at the same time using a developer or a method of first removing the protective layer with water or warm water and then removing the unexposed area of the image-recording layer by development is known. Into the water or warm water may be incorporated an antiseptic described in JP-A-10-10754, an organic solvent described in JP-A-8-278636.

The developer for use at the development processing of the lithographic printing plate precursor according to the invention is preferably contains an anionic surfactant having a polyoxyalkylene ether group.

The development of the lithographic printing plate precursor according to the invention with the developer is conducted in a conventional manner at temperature ordinarily from 0 to 60°C, preferably from 15 to 40°C, for example, by immersing the exposed lithographic printing plate precursor in the developer and rubbing with a brush.

Further, in the case of conducting the development processing using an automatic developing machine, the developer becomes fatigued in accordance with the processing amount, and hence the processing ability may be restored by using a replenishing solution or a fresh developer. The thus development-processed lithographic printing plate precursor is subjected to after-treatment with washing water, a rinsing solution containing a surfactant or an oil-desensitizing solution containing gum arabic or a starch derivative as described, for example, in JP-A-54-8002, JP-A-55-115045 and JP-A-59-58431. In the after-treatment of the lithographic printing plate precursor according to the invention, these treatments can be used in combination.

The lithographic printing plate thus-obtained by the above-described processing may be subjected to a post-exposure treatment by a method described in JP-A-2000-89478 or a heart treatment, for example, baking, to improve printing durability.

The lithographic printing plate obtained by the processing is mounted on an offset printing machine to perform printing of a large number of sheets.

### EXAMPLES

The present invention is described in more detail with reference to the following examples, but the invention should not be construed as being limited thereto.

### Comparative Example 1a

### [Preparation of aluminum support]

A 0.3 mm-thick aluminum plate was etched by dipping in a 10% by weight aqueous sodium hydroxide solution at 60°C for 25 seconds, washed with running water, neutralized and cleaned with a 20% by weight aqueous nitric acid solution and then washed with water. The aluminum plate was then subjected to an electrolytic surface roughening treatment in a 1 % by weight aqueous nitric acid solution using an alternating current with a sinusoidal waveform at an anode time electricity of 300 Coulomb/dm². Subsequently, the aluminum plate was dipped in a 1% by weight aqueous sodium hydroxide solution at 40°C for 5 seconds, dipped in a 30% by weight aqueous sulfuric acid solution at 60°C for 40 seconds to effect a desmut treatment, and then subjected to an anodizing treatment in a 20% by weight aqueous sulfuric acid solution for 2 minutes at a current density of 2 A/dm² to form an anodic oxide film having a thickness of 2.7 g/m². The surface roughness of the aluminum plate was measured and found to be 0.3 µm (Ra value according to JIS B 0601).

### [Formation of intermediate layer]

A solution for intermediate layer shown below was coated on the aluminum plate thus-treated using a bar coater and dried at 80°C for 20 seconds. The coating amount of the intermediate layer after drying was 10 mg/m².

### (Solution for intermediate layer)

| | |
|---|---|
| Sol solution shown below | 100 g |
| Methanol | 900 g |

### <Sol solution>

| | |
|---|---|
| Phosmer PE (produced by Uni-Chemical Co., Ltd.) | 52 g |
| Methanol | 44 g |
| Water | 14 g |
| Phosphoric acid (85% by weight) | 11 g |
| Tetraethoxysilane | 36 g |
| 3-Methacryloyloxypropyltrimethoxysilane | 12 g |

### [Formation of image-recording layer]

Photopolymerizable composition P-1 of high sensitivity having the composition shown below was coated on the intermediate layer so as to have a dry coating amount of 1.4 g/m² and dried at 100°C for one minute to form an image-recording layer.

### (Photopolymerizable composition P-1)

| | |
|---|---|
| Ethylenically unsaturated double bond-containing addition-polymerizable compound (Compound A) | 4.0 parts by weight |
| Alkaline water-soluble binder (Binder A) | 2.0 parts by weight |
| Sensitizing dye (C-1) | 0.32 parts by weight |
| Polymerization initiator (D-1) | 0.61 parts by weight |
| Chain transfer agent (E-1) | 0.57 parts by weight |
| N-Nitrosophenylhydroxylamine aluminum salt | 0.020 parts by weight |
| ε-Phthalocyanine dispersion | 0.71 parts by weight |
| Fluorine-based nonionic surfactant (Megafac F780, produced by Dainippon Ink & Chemicals, Inc.) | 0.016 parts by weight |
| Methyl ethyl ketone | 47 parts by weight |
| Propylene glycol monomethyl ether | 45 parts by weight |

Ethylenically unsaturated double bond-containing addition-polymerizable compound
Compound A Mp = -42.6°C 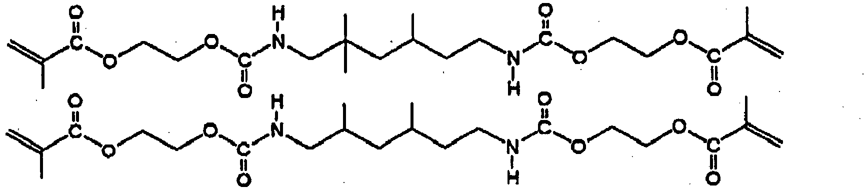 Compound B Mp = 50.0°C 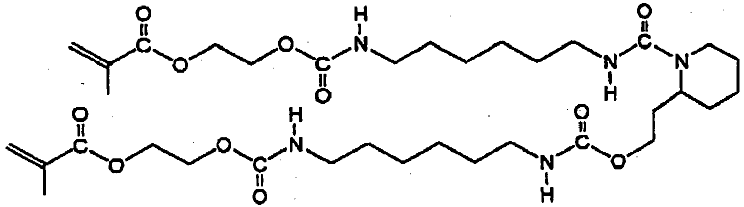 Compound C Mp = 76.4°C

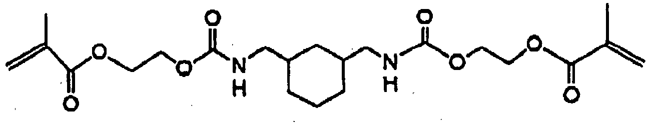

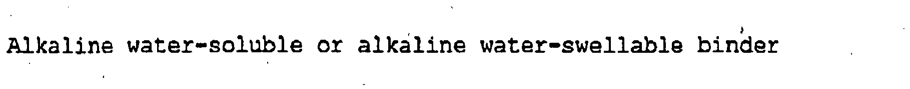

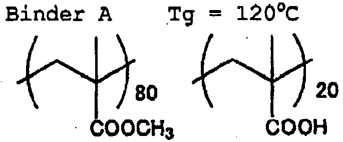

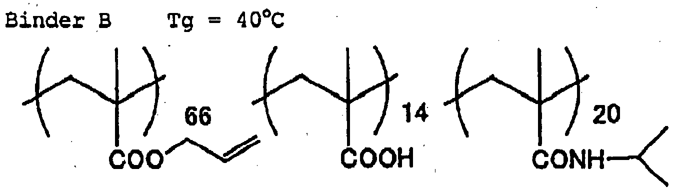

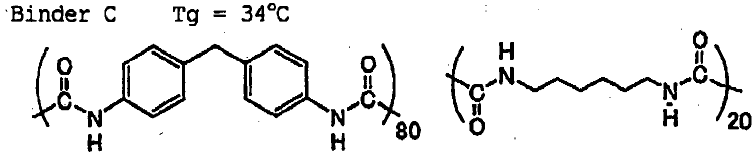

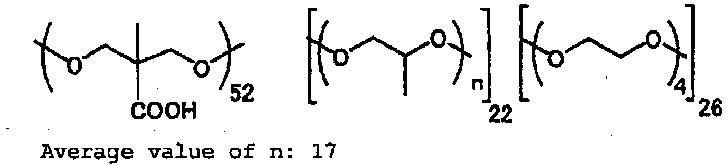

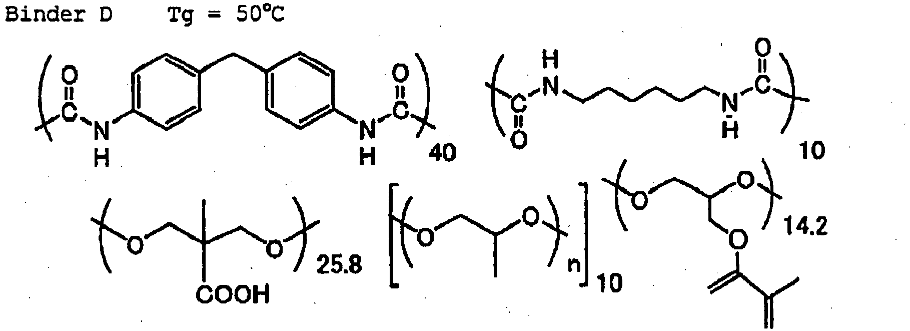

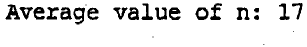

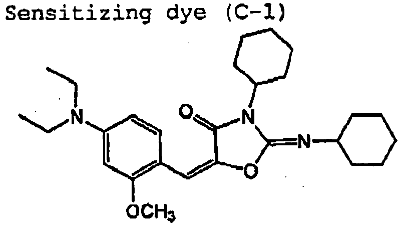

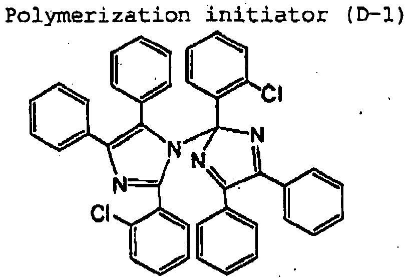

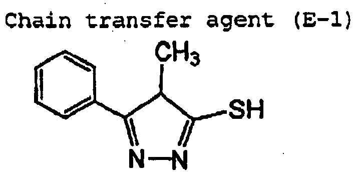

### [Formation of protective layer]

A mixed aqueous solution containing 76% by weight of polyvinyl alcohol (saponification degree: 98% by mole, polymerization degree: 550), 21% by weight of polyvinyl pyrrolidone (Luviscol K-30, produced by BASF), 1.0% by weight of a fluorine-based surfactant (Emalex 710, produced by Nihon-Emulsion Co., Ltd.) and 2% by weight of a surfactant (Pionin D230, produced by Takemoto Oil & Fat Co., Ltd.), based on the total solid content of the protective layer, was coated on the image-recording layer by a wire bar and dried in a warm air drying apparatus at 125°C for 75 seconds. The coating amount (coverage after drying) of the protective layer was 2.45 g/m².

### [Evaluation]

### (1) Sensitivity

The lithographic printing plate precursor thus-obtained was subjected to drawing of image having a halftone dot area rate of 50% using a plate setter (Vx9600CTP, produced by Fuji Film Co., Ltd., wavelength of light source: 405 nm) while adjusting the exposure amount on the surface of lithographic printing plate precursor to 0.05 mJ/cm². Within 30 seconds, the exposed lithographic printing plate precursor was pre-heated under the conditions of surface reaching temperature of 115°C and heat treatment time of 10 seconds and then developed using PS processor Inter Plater 850HD, produced by G & J fed with an alkali developer having the composition shown below at 25°C. The halftone dot area rate of the lithographic printing plate thus-obtained was measured by ccDOT, produced by Centurfax Ltd. to evaluate the sensitivity. The sensitivity was evaluated according to the following criteria: ○: The halftone dot area rate was 60.0% or more.
○Δ: The halftone dot area rate was 58.0% to 60.0%.
Δ: The halftone dot area rate was 56.0% to 58.0% (acceptable level).
×: The halftone dot area rate was 56.0% or less.

The results are shown in Table 1 below.

### (2) Printing durability

The lithographic printing plate precursor thus-obtained was subjected to imagewise drawing using a plate setter (Vx9600CTP, produced by Fuji Film Co., Ltd., wavelength of light source: 405 nm) while adjusting the exposure amount on the surface of lithographic printing plate precursor to 0.05 mJ/cm². Within 30 seconds, the exposed lithographic printing plate precursor was pre-heated under the conditions of surface reaching temperature of 115°C and heat treatment time of 10 seconds and then developed using PS processor Inter Plater 850HD, produced by G & J fed with an alkali developer having the composition shown below at 25°C. The lithographic printing plate thus-obtained was subjected to printing using a printing machine (Lithron, produced by Komori Corp.) and ink (DIC GEOS (N) black, produced by Dainippon Ink & Chemicals Inc.) and a number of sheets on which reduction of density in the solid image portion was visually recognized was determined to evaluate the printing durability. The printing durability was evaluated according to the following criteria:
0: The number of sheets on which the density in the solid image portion became 75% of the density at the start of printing is 50,000 or more.
Δ: The number of sheets on which the density in the solid image portion became 75% of the density at the start of printing is from 30,000 to 50,000 (acceptable level).
x: The number of sheets on which the density in the solid image portion became 75% of the density at the start of printing is 30, 000 or less.

The results are shown in Table 1 below.

### (Composition of alkali developer)

| | |
|---|---|
| Potassium hydroxide | 0.15 g |
| Polyoxyethylene naphthyl ether (n = 13) | 5.0 g |
| Chelest 400 (chelating agent) | 0.1 g |
| Water | 94.75 g |

### Comparative Example 2a

A lithographic printing plate precursor for Comparative Example 2a was prepared in the same manner as in Comparative Example 1a except for changing Ethylenically unsaturated double bond-containing addition-polymerizable compound: Compound A to Compound B and evaluated in the manner as in Comparative Example 1a. The results are shown in Table 1 below.

### Comparative Example 3a

A lithographic printing plate precursor for Comparative Example 3a was prepared in the same manner as in Comparative Example 1a except for changing Ethylenically unsaturated double bond-containing addition-polymerizable compound: Compound A to Compound C and evaluated in the manner as in Comparative Example 1a. The results are shown in Table 1 below.

### Comparative Example 8

A lithographic printing plate precursor for Comparative Example 8 was prepared in the same manner as in Comparative Example 2a except for changing Alkaline water-soluble or alkaline water-swellable binder: Binder A to Binder D and evaluated in the manner as in Comparative Example 1a. The results are shown in Table 1 below.

### Example 1

A lithographic printing plate precursor for Example 1 was prepared in the same manner as in Comparative Example 3a except for changing Alkaline water-soluble or alkaline water-swellable binder: Binder A to Binder D and evaluated in the manner as in Comparative Example 1a. The results are shown in Table 1 below.

### Comparative Example 1b

A lithographic printing plate precursor for Comparative Example 1 was prepared in the same manner as in Comparative Example 1a except for changing Alkaline water-soluble or alkaline water-swellable binder: Binder A to Binder B and evaluated in the manner as in Comparative Example 1a. The results are shown in Table 1 below.

### Comparative Example 2b

A lithographic printing plate precursor for Comparative Example 2b was prepared in the same manner as in Comparative Example 2a except for changing Alkaline water-soluble or alkaline water-swellable binder: Binder A to Binder B and evaluated in the manner as in Comparative Example 1. The results are shown in Table 1 below.

### Comparative Example 3b

A lithographic printing plate precursor for Comparative Example 3b was prepared in the same manner as in Comparative Example 3a except for changing Alkaline water-soluble or alkaline water-swellable binder: Binder A to Binder B and evaluated in the manner as in Comparative Example 1a. The results are shown in Table 1 below.

### Comparative Example 4

A lithographic printing plate precursor for Comparative Example 4 was prepared in the same manner as in Comparative Example 1a except for changing Alkaline water-soluble or alkaline water-swellable binder: Binder A to Binder C and evaluated in the manner as in Comparative Example 1a. The results are shown in Table 1 below.

### Comparative Example 5

A lithographic printing plate precursor for Comparative Example 5 was prepared in the same manner as in Comparative Example 2a except for changing Alkaline water-soluble or alkaline water-swellable binder: Binder A to Binder C and evaluated in the manner as in Comparative Example 1a. The results are shown in Table 1 below.

### Comparative Example 6

A lithographic printing plate precursor for Comparative Example 6 was prepared in the same manner as in Comparative Example 3a except for changing Alkaline water-soluble or alkaline water-swellable binder: Binder A to Binder C and evaluated in the manner as in Comparative Example 1a. The results are shown in Table 1 below.

### Comparative Example 7

A lithographic printing plate precursor for Comparative Example 7 was prepared in the same manner as in Comparative Example 1a except for changing Alkaline water-soluble or alkaline water-swellable binder: Binder A to Binder D and evaluated in the manner as in Comparative Example 1a. The results are shown in Table 1 below.

**Table 1: Example 1 and Comparative Examples 1 to 8**

| | Binder | | Monomer | | Sensitivity | Printing Durability |
|---|---|---|---|---|---|---|
| | Kind | Tg (°C) | Kind | Mp (°C) | | |
| Comparative Example 1a | Binder A (acrylic) Without crosslinkable group | 120 | Compound A | -42.6 | ○ | Δ |
| Comparative Example 2a | | | Compound B | 50 | ○ | Δ |
| Comparative Example 3a | | | Compound C | 76.4 | ○ | ○ |
| Comparative Example 1b | Binder B (acrylic) With crosslinkable group | 40 | Compound A | -42.6 | × | × |
| Comparative Example 2b | | | Compound B | 50 | ○ | × |
| Comparative Example 3b | | | Compound C | 76.4 | ○ | × |
| Comparative Example 4 | Binder C (urethane) Without crosslinkable group | 34 | Compound A | -42.6 | × | × |
| Comparative Example 5 | | | Compound B | 50 | ○ | × |
| Comparative Example 6 | | | Compound C | 76.4 | ○ | × |
| Comparative Example 7 | Binder D (urethane) With crosslinkable group | 50 | Compound A | -42.6 | × | ○ |
| Comparative Example 8 | | | Compound B | 50 | ○Δ | ○ |
| Example 1 | | | Compound C | 76.4 | ○ | ○ |

As is apparent from the results shown in Table 1, the present invention can provide the lithographic printing plate precursor having high sensitivity and excellent printing durability.

## Claims

1. A lithographic printing plate precursor comprising:
(i) a support; and
(ii) an image-recording layer comprising a photopolymerizable composition, which comprises
(a) an addition-polymerizable compound, which has at least one ethylenically unsaturated double bond in the molecule, and has a melting point of ≥ 60°C,
(b) an alkaline water-soluble or alkaline water-swellable binder, which is a polyurethane resin comprising a crosslinkable group and having a glass transition point of ≥ 45°C,
(c) a sensitizing dye, and
(d) a photo-initiator.

2. The lithographic printing plate precursor of claim 1,
wherein the melting point of compound (a) is ≥ 75°C.

3. The lithographic printing plate precursor of claim 1 or 2, wherein the compound (a) is a compound of formula (I)
L₁-OOCNH-R₁-X-R₂-NHCOO-L₂ (I)
wherein
X is an optionally substituted 5- or 6-membered ring,
R₁ and R₂ each independently are a straight-chain or branched C₁₋₅-alkylene group, and
L₁ and L₂ each are an organic group, and at least one of
L₁ and L₂ comprises an ethylenically unsaturated double bond.

4. The lithographic printing plate precursor of claim 3, wherein L₁ and L₂ in formula (I) further comprise a urethane bond.

5. The lithographic printing plate precursor of any of claims 1-4, wherein the absorption maximum wavelength of the sensitizing dye (c) is in the range of 250-450 nm.

## Patentansprüche

1. Lithografischer Druckplattenvorläufer, umfassend:
(i) einen Träger; und
(ii) eine Bildaufzeichnungsschicht, die eine photopolymerisierbare Zusammensetzung umfasst, die folgendes umfasst:
(a) eine additionspolymerisierbare Verbindung, die mindestens eine ethylenisch ungesättigte Doppelbindung im Molekül hat, und einen Schmelzpunkt von ≥ 60 °C hat,
(b) ein in alkalischem Wasser lösliches oder in alkalischem Wasser quellbares Bindemittel, das ein Polyurethanharz mit einer vernetzbaren Gruppe ist um eine Glasübergangstemperatur von ≥ 45 °C hat,
(c) einen Sensibilisierungsfarbstoff, und
(d) einen Photoinitiator.

2. Lithographischer Druckplattenvorläufer nach Anspruch 1, in dem der Schmelzpunkt der Verbindung (a) ≥ 75 °C ist.

3. Lithographischer Druckplattenvorläufer nach Anspruch 1 oder 2, in dem die Verbindung (a) eine Verbindung der Formel (I) ist:
L₁-OOCNH-R₁-X-R₂-NHCOO-L₂ (I)
wobei
X ein optional substituierter 5- oder 6-gliedriger Ring ist,
R₁ und R₂ jeweils unabhängig voneinander eine geradkettige oder verzweigte C₁₋₅-Alkylengruppe sind, und
L₁ und L₂ jeweils eine organische Gruppe sind, und mindestens eines von L₁ und L₂ eine ethylenisch ungesättigte Doppelbindung umfasst.

4. Lithographischer Druckplattenvorläufer nach Anspruch 3, in dem L₁ und L₂ in der Formel (I) ferner eine Urethanbindung umfassen.

5. Lithographischer Druckplattenvorläufer nach mindestens einem der Ansprüche 1 bis 4, in dem die maximale Absorptionswellenlänge des Sensibilisierungsfarbstoffs (c) im Bereich von 250-450 nm ist.

## Revendications

1. Précurseur de plaque d'impression lithographique comprenant :
(i) un support ; et
(ii) une couche d'enregistrement d'image comprenant une composition photopolymérisable, qui comprend
(a) un composé polymérisable par addition, qui a au moins une double liaison à insaturation éthylénique dans la molécule, et a un point de fusion ≥ 60°C,
(b) un liant alcalin hydrosoluble ou un liant alcalin capable de gonfler dans l'eau, qui est une résine de polyuréthane comprenant un groupe réticulable et ayant un point de transition vitreuse ≥ 45°C,
(c) un colorant de sensibilisation, et
(d) un photo-initiateur.

2. Précurseur de plaque d'impression lithographique de la revendication 1, dans lequel le point de fusion du composé (a) est ≥ 75°C.

3. Précurseur de plaque d'impression lithographique de la revendication 1 ou 2, dans lequel le composé (a) est un composé de formule (I)
L₁-OOCNH-R₁-X-R₂-NHCOO-L₂ (I)
où
X représente un cycle à 5 ou 6 chaînons facultativement substitué,
R₁ et R₂ représentent chacun indépendamment un groupe alkylène en C₁ à C₅ à chaîne droite ou ramifié, et
L₁ et L₂ représentent chacun un groupe organique, et au moins l'un parmi L₁ et L₂ comprend une double liaison à insaturation éthylénique.

4. Précurseur de plaque d'impression lithographique de la revendication 3, dans lequel L₁ et L₂ dans la formule (I) comprennent en outre une liaison uréthane.

5. Précurseur de plaque d'impression lithographique de l'une des revendications 1 à 4, dans lequel la longueur d'onde maximale d'absorption du colorant de sensibilisation (c) se trouve dans la plage allant de 250 à 450 nm.
